# EUROPEAN PATENT APPLICATION

(11) **EP 4 513 270 A1**
(43) Date of publication of application: **26.02.2025**
(21) Application number: 24193109.6
(22) Date of filing: 06.08.2024
(51) Int. Cl.: G03F 7/039, G03F 7/004

(54) **CHEMICALLY AMPLIFIED POSITIVE RESIST COMPOSITION AND RESIST PATTERN FORMING PROCESS**

(30) Priority: 09.08.2023 JP 2023130319; 16.07.2024 JP 2024113485
(71) Applicant: SHIN-ETSU CHEMICAL CO., LTD., Tokyo 1000005 (JP)
(72) Inventor: Masunaga, Keiichi, NIIGATA-KEN (JP); Watanabe, Satoshi, NIIGATA-KEN (JP); Fukushima, Masahiro, NIIGATA-KEN (JP); Kotake, Masaaki, NIIGATA-KEN (JP); Matsuzawa, Yuta, NIIGATA-KEN (JP); Sueyoshi, Tatsumi, NIIGATA-KEN (JP)
(74) Representative: Ter Meer Steinmeister & Partner

(57) **Abstract**

A resist composition comprising a base polymer, a photoacid generator, and a quencher is provided. The base polymer contains a polymer comprising phenolic hydroxy-containing units, aromatic ring-containing units, and units containing a phenolic hydroxy group protected with an acid labile group. A resist film is processed into a pattern of satisfactory profile exhibiting a high resolution, reduced LER, and rectangularity while the influence of residue defects is restrained.

## Description

### TECHNICAL FIELD

This invention relates to a chemically amplified positive resist composition and resist pattern forming process.

### BACKGROUND ART

To meet the recent demand for higher integration in integrated circuits, pattern formation to a smaller feature size is required. Acid-catalyzed chemically amplified resist compositions are most often used in forming resist patterns with a feature size of 0.2 µm or less. High-energy radiation such as UV, deep-UV, EUV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB having a minute area. The operation of successively scanning all finely divided regions on the work surface takes a long time as compared with one-shot exposure through a photomask. To avoid any throughput decline, a resist film having a high sensitivity is required. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate. A small line edge roughness (LER) is another important performance factor. In recent years, the multibeam mask writing (MBMW) process is used in the processing of mask blanks to achieve further miniaturization. The resist used in the MBMW process is a low-sensitivity resist composition (or high-dose region) which is advantageous in roughness while a spotlight is brought to the optimization of the resist composition in the high-dose region.

Various improvements in the control of resist sensitivity and pattern profile have been made by a proper selection and combination of resist material components and processing conditions. One improvement pertains to the diffusion of acid that largely affects the resolution of a resist film. In the processing of photomasks, it is required that the profile of a resist pattern formed do not change with the lapse of time from the end of exposure to bake. The major cause of such a change of resist pattern profile with time is diffusion of an acid generated upon exposure. The problem of acid diffusion has been widely studied not only in terms of photomask processing, but also in terms of general resist compositions because the acid diffusion has a significant impact on sensitivity and resolution.

Patent Documents 1 and 2 describe acid generators capable of generating bulky acids for controlling acid diffusion and reducing LER. Since these acid generators are still insufficient to control acid diffusion, it is desired to have an acid generator with shorter acid diffusion.

Patent Document 3 discloses a resist composition comprising a base polymer having introduced therein repeat units having a sulfonium structure capable of generating a sulfonic acid upon light exposure. This approach of controlling acid diffusion by introducing repeat units capable of generating acid upon exposure into a base polymer is effective in forming a pattern with small LER. However, the base polymer having introduced therein repeat units capable of generating acid upon exposure sometimes encounters a problem with respect to its solubility in organic solvent, depending on the structure and proportion of the repeat units.

Polymers comprising a major proportion of aromatic structure having an acidic side chain, for example, polyhydroxystyrene are useful as a base polymer in resist materials for the KrF excimer laser lithography. These polymers are not used in resist materials for the ArF excimer laser lithography because they exhibit strong absorption to radiation of wavelength around 200 nm. These polymers, however, are expected to form useful resist materials for the EB and EUV lithography for forming patterns of smaller size than the processing limit of ArF excimer laser because they offer high etching resistance.

Often used as the base polymer in positive resist compositions for EB and EUV lithography is a polymer having an acidic functional group on phenol side chain masked with an acid labile group. Upon exposure to high-energy radiation, a photoacid generator generates an acid and the acid labile group is deprotected by the catalysis of the generated acid whereby the polymer turns soluble in alkaline developer. Typical of the acid labile group are tertiary alkyl and tert-butoxycarbonyl. Acetal groups are also used as an acid labile group requiring a relatively low level of activation energy. See Patent Documents 4 to 8.

The acetal group has the advantage that a resist film having a high sensitivity is obtainable. In the MBMW image writing process by the EB lithography for the fabrication of advanced photomasks of 10 nm node or less, images are written in thin-film regions where a resist film has a thickness of 100 nm or less and in high-dose regions having a high level of irradiation energy. If acetal has a high reactivity, deprotection reaction can occur even in the unexposed region of the resist film. There arise such problems as degradations of resolution and roughness, which are regarded important for positive resist compositions.

The development step in the process for the fabrication of photomasks tends to use a more amount of developer than the KrF, ArF or EUV lithography using wafers, for the purpose of minimizing mask defects. This suggests stronger development conditions. The resist design adapted for such a strong development process is needed. It is desired to improve a resist composition so as to achieve a high resolution, reduced roughness and minimal development residue defects in the lithography of advanced generation.

### Citation List

Patent Document 1: JP-A 2009-053518
Patent Document 2: JP-A 2010-100604
Patent Document 3: JP-A 2011-022564
Patent Document 4: JP 3981830
Patent Document 5: JP 5385017
Patent Document 6: WO 2019/167419
Patent Document 7: JP 6987873
Patent Document 8: WO 2019/044259

### SUMMARY OF INVENTION

An object of the invention is to provide a chemically amplified positive resist composition which is lithographically processed into a resist pattern with a very high resolution, reduced LER, improved rectangularity, and minimal influence of residue defects on developer; and a resist pattern forming process using the composition.

The inventors have found that a resist composition comprising a base polymer having acid labile groups of acetal form having a structure in which an aromatic ring is bonded to the carbon atom to which two oxygen atoms are bonded, a photoacid generator, and a quencher, wherein the ratio of photoacid generator to quencher is controlled, forms a resist film which can be processed into a pattern of satisfactory profile exhibiting a high resolution, reduced roughness, and minimal influence of residue defects even in high dose regions.

In one aspect, the invention provides a chemically amplified positive resist composition comprising (A) a base polymer, (B) a photoacid generator, and (C) a quencher. The base polymer (A) contains a polymer comprising phenolic hydroxy-containing units represented by the formula (A1), aromatic ring-containing units represented by any one of the formulae (A2) to (A4), and units containing a phenolic hydroxy group protected with an acid labile group, represented by the formula (A5), all repeat units in the base polymer (A) are aromatic ring-containing repeat units, and the number of halogen atoms in the repeat units in the base polymer (A) is up to 3.

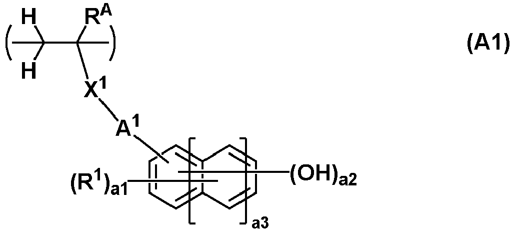

Herein a1 is an integer satisfying 0 ≤ a1 ≤ 5+2(a3)-a2, a2 is an integer of 1 to 3, a3 is an integer of 0 to 2,
R^{A} is hydrogen, fluorine, methyl or trifluoromethyl,
X¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which some -CH₂-may be replaced by -O-,
R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group.

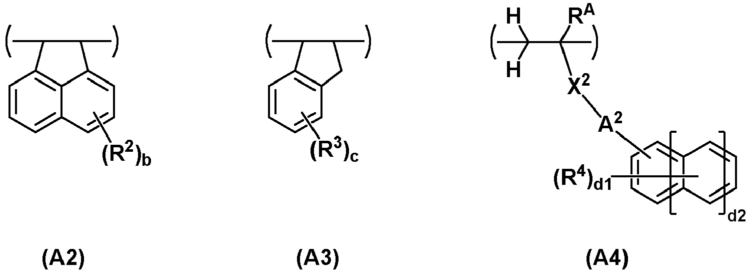

Herein b and c are each independently an integer of 0 to 4, d1 is an integer of 0 to 5, d2 is an integer of 0 to 2,
R^{A} is hydrogen, fluorine, methyl or trifluoromethyl,
X² is a single bond, *-C(=O)-O- or *-C(=O)-NH-, * designates a point of attachment to the carbon atom in the backbone,
A² is a single bond or a C₁-C₁₀ saturated hydrocarbylene group in which some -CH₂-may be replaced by -O-,
R² and R³ are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R⁴ may also be hydroxy when d2 is 1 or 2.

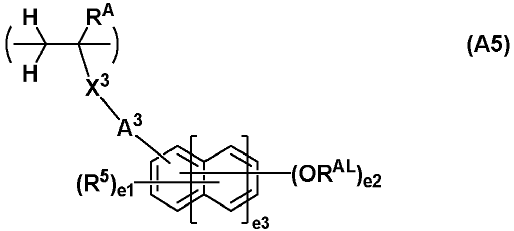

Herein e1 is an integer satisfying 0 ≤ e1 ≤ 5+2(e3)-e2, e2 is an integer of 1 to 3, e3 is an integer of 0 to 2,
R^{A} is hydrogen, fluorine, methyl or trifluoromethyl,
X³ is a single bond, *-C(=O)-O- or *-C(=O)-NH-, * designates a point of attachment to the carbon atom in the backbone,
A³ is a single bond or a C₁-C₁₀ saturated hydrocarbylene group in which some -CH₂-may be replaced by -O-,
R⁵ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R^{AL} is an acid labile group of acetal form having the formula (AL-1) when e2=1, R^{AL} is hydrogen or an acid labile group of acetal form having the formula (AL-1), at least one R^{AL} being an acid labile group of acetal form having the formula (AL-1), when e2=2 or 3.

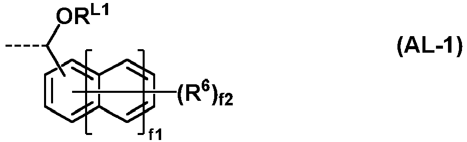

Herein f1 is an integer of 0 to 2, and f2 is an integer satisfying 0 ≤ f2 ≤ 5+2(f1).
R⁶ is acetyl, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro or cyano group,
R^{L1} is a C₁-C₃₀ hydrocarbyl group, and
the broken line designates a point of attachment.

In a preferred embodiment, the phenolic hydroxy-containing units have the formula (A1-1): 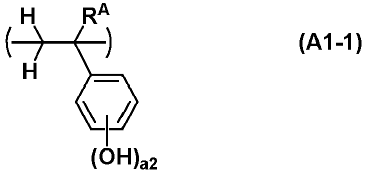 wherein R^{A} and a2 are as defined above.

In a preferred embodiment, the units containing a phenolic hydroxy group protected with an acid labile group have the formula (A5-1): 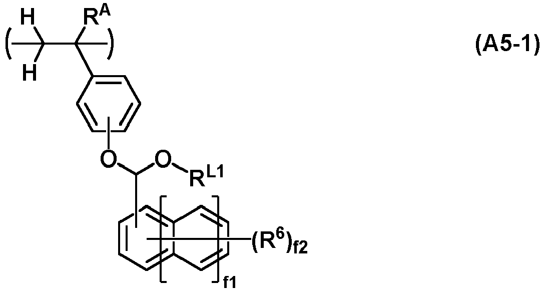 wherein R^{A}, R⁶, f1, f2 and R^{L1} are as defined above.

In a preferred embodiment, the photoacid generator (B) generates an acid having an acid strength (pKa) of -3.0 or larger.

In a preferred embodiment, the photoacid generator (B) and the quencher (C) are present in a weight ratio (B/C) of less than 3/1.

In a preferred embodiment, the photoacid generator (B) is an onium salt compound containing an anion having the formula (B-1) or (B-2).

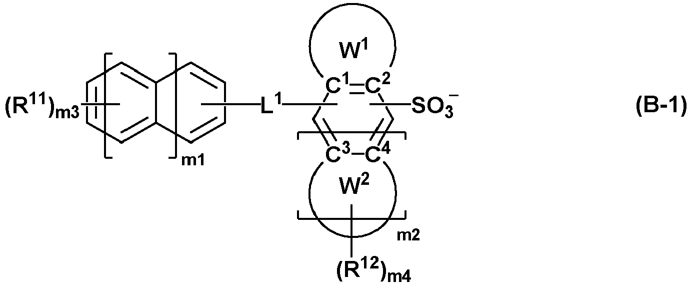

Herein m1 and m2 are each independently an integer of 0 to 2, m3 is an integer of 1 to 5 in case of m1=0, an integer of 1 to 7 in case of m 1 = 1, and an integer of 1 to 9 in case of m1=2, m4 is an integer of 0 to 5 in case of m2=0, an integer of 0 to 7 in case of m2=1, and an integer of 0 to 9 in case of m2=2,
L¹ is a single bond, ether bond, ester bond, sulfonate ester bond, amide bond, carbonate bond or carbamate bond,
R¹¹ is each independently iodine or a C₃-C₂₀ branched or cyclic hydrocarbyl group which may contain a heteroatom, at least one R¹¹ is attached to a carbon atom adjoining the carbon atom to which L¹ is attached, a plurality of R¹¹ may bond together to form a ring with the carbon atoms to which they are attached when m3 is 2 or more,
R¹² is each independently a C₁-C₂₀ hydrocarbyl group which may contain a heteroatom, a plurality of R¹² may bond together to form a ring with the carbon atoms to which they are attached when m4 is 2 or more,
W¹ forms a C₃-C₁₅ ring with the carbon atoms C¹ and C² on the adjoining aromatic ring, some carbon on the ring may be replaced by a heteroatom-containing group,
W² forms a C₃-C₁₅ ring with the carbon atoms C³ and C⁴ on the adjoining aromatic ring, some carbon on the ring may be replaced by a heteroatom-containing group.

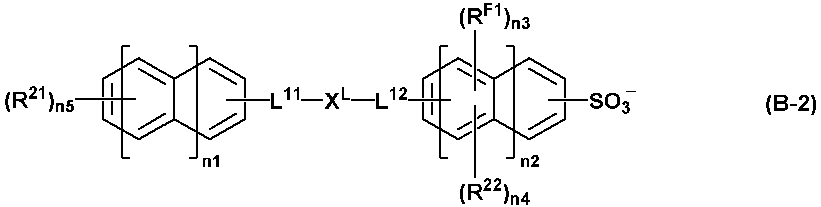

Herein n1 and n2 are each independently an integer of 0 to 2, n3 is an integer of 1 to 4 in case of n2=0, an integer of 1 to 6 in case of n2=1, and an integer of 1 to 8 in case of n2=2, n4 is an integer of 0 to 3 in case of n2=0, an integer of 0 to 5 in case of n2=1, and an integer of 0 to 7 in case of n2=2, n3+n4 is from 1 to 4 in case of n2=0, from 1 to 6 in case of n2=1, and from 1 to 8 in case of n2=2, n5 is an integer of 1 to 5 in case of n1=0, an integer of 1 to 7 in case of n1=1, and an integer of 1 to 9 in case of n1=2,
R²¹ is each independently iodine or a C₃-C₂₀ branched or cyclic hydrocarbyl group which may contain a heteroatom, at least one R²¹ is attached to a carbon atom adjoining the carbon atom to which L¹¹ is attached, a plurality of R²¹ may bond together to form a ring with the carbon atoms to which they are attached when n5 is 2 or more,
R²² is each independently a C₁-C₂₀ hydrocarbyl group which may contain a heteroatom, a plurality of R²² may bond together to form a ring with the carbon atoms to which they are attached when n4 is 2 or more,
R^{F1} is each independently fluorine, a C₁-C₆ fluorinated alkyl group, C₁-C₆ fluorinated alkoxy group, or C₁-C₆ fluorinated thioalkoxy group,
L¹¹ and L¹² are each independently a single bond, ether bond, ester bond, amide bond, sulfonate ester bond, carbonate bond or carbamate bond, and
X^{L} is a single bond or a C₁-C₄₀ hydrocarbylene group which may contain a heteroatom.

In a preferred embodiment, the photoacid generator (B) is an onium salt compound having a fluorine-free anion.

The resist composition may further comprise (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6).

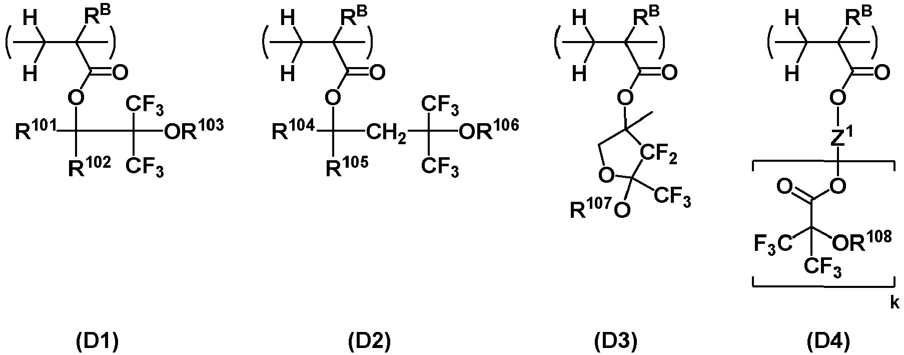

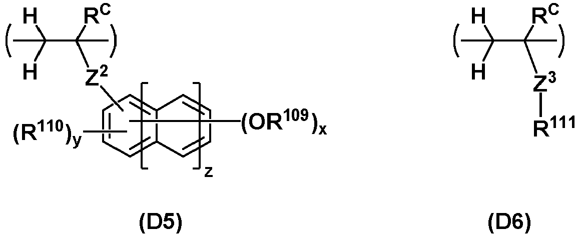

Herein x is 1, 2 or 3, y is an integer satisfying 0 ≤ y ≤ 5+2z-x, z is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group,
when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some -CH₂- may be replaced by an ester bond or ether bond,
Z¹ is a C₁-C₂₀ (k+1)-valent hydrocarbon group or C₁-C₂₀ (k+1)-valent fluorinated hydrocarbon group,
Z² is a single bond, *-C(=O)-O- or *-C(=O)-NH-,
Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

The resist composition may further comprise (E) an organic solvent.

In a preferred embodiment, the base polymer has a dissolution rate in alkaline developer of up to 5 nm/min.

In a preferred embodiment, the resist composition forms a resist film, the resist film in an unexposed region having a dissolution rate in alkaline developer of up to 10 nm/min.

The resist composition is typically adapted for the EB lithography.

In another aspect, the invention provides a resist pattern forming process comprising the steps of applying the chemically amplified positive resist composition defined herein onto a substrate to form a resist film thereon, exposing the resist film to a pattern of EUV or EB, and developing the exposed resist film in an alkaline developer.

Often, the substrate has the outermost surface of a material containing at least one element selected from chromium, silicon, tantalum, molybdenum, cobalt, nickel, tungsten, and tin.

Most often, the substrate is a mask blank of transmission or reflection type.

Also contemplated herein is a mask blank of transmission or reflection type which is coated with the chemically amplified positive resist composition defined herein.

### ADVANTAGEOUS EFFECTS OF INVENTION

A resist film of the chemically amplified positive resist composition is lithographically processed into a resist pattern of satisfactory profile having a high resolution, reduced LER, improved rectangularity, and minimal influence of residue defects on developer. The resist film is sensitive to EB which is used in the processing of semiconductor substrates and photomask blanks. The pattern forming process using the resist composition is effective for forming a resist pattern of satisfactory profile having a high resolution, etch resistance, reduced LER, and minimal influence of residue defects on developer. The resist composition is thus best suited in the micropatterning technology, typically EUV or EB lithography.

### DESCRIPTION OF EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group.

In chemical formulae, the broken line (---) or asterisk (*) designates a valence bond or point of attachment. As used herein, the term "fluorinated" refers to a fluorine-substituted or fluorine-containing compound or group. The terms "group" and "moiety" are interchangeable.

The abbreviations and acronyms have the following meaning.
- EB:: electron beam
- EUV:: extreme ultraviolet
- Mw:: weight average molecular weight
- Mn:: number average molecular weight
- Mw/Mn:: molecular weight distribution or dispersity
- GPC:: gel permeation chromatography
- PEB:: post-exposure bake
- PAG:: photoacid generator
- LER:: line edge roughness
- CDU:: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Chemically amplified positive resist composition

One embodiment of the invention is a chemically amplified positive resist composition comprising (A) a base polymer, (B) a photoacid generator, and (C) a quencher.

### [(A) Base polymer]

The base polymer (A) contains a polymer comprising phenolic hydroxy-containing units represented by the formula (A1), referred to as repeat units A1, hereinafter.

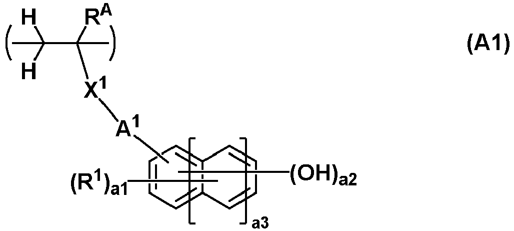

In formula (A1), a1 is an integer satisfying 0 ≤ a1 ≤ 5+2(a3)-a2, a2 is an integer of 1 to 3, a3 is an integer of 0 to 2.

In formula (A1), R^{A} is hydrogen, fluorine, methyl or trifluoromethyl.

In formula (A1), X¹ is a single bond, *-C(=O)-O- or *-C(=O)-NH-. The asterisk (*) designates a point of attachment to the carbon atom in the backbone.

In formula (A1), A¹ is a single bond or a C₁-C₁₀ saturated hydrocarbylene group in which some constituent -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof.

In formula (A1), R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic. Examples thereof include C₁-C₆ alkyl groups such as methyl, ethyl, n-propyl, isopropyl, butyl, pentyl, and hexyl; C₃-C₆ cycloalkyl groups such as cyclopropyl, cyclobutyl, cyclopentyl, and cyclohexyl, and combinations thereof. A carbon count below the upper limit ensures a satisfactory solubility in alkaline developer. When a1 is 2 or more, a plurality of R¹ may be the same or different.

Preferred examples of repeat unit A1 wherein both X¹ and A¹ are a single bond include units derived from 3-hydroxystyrene, 4-hydroxystyrene, 5-hydroxy-2-vinylnaphthalene, and 6-hydroxy-2-vinylnaphthalene. Repeat units having the formula (A1-1) are more preferred. 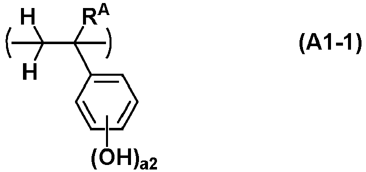 Herein R^{A} and a2 are as defined above.

Preferred examples of repeat unit A1 wherein X¹ is other than a single bond are shown below, but not limited thereto. Herein R^{A} is as defined above.

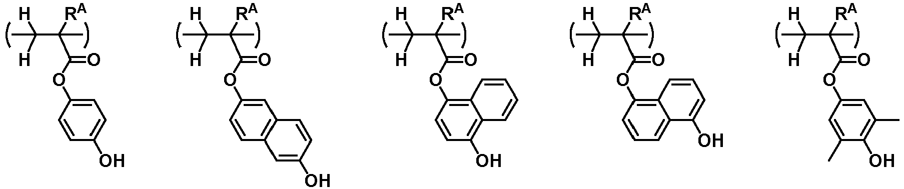

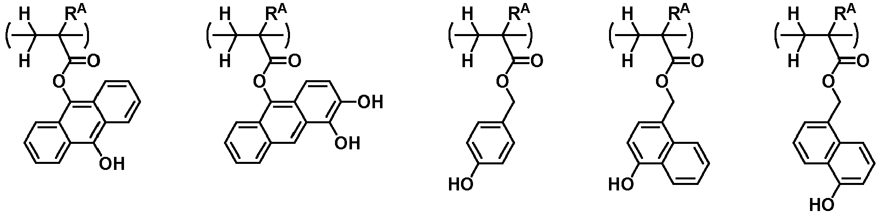

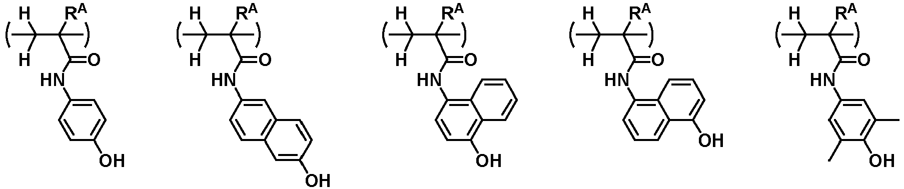

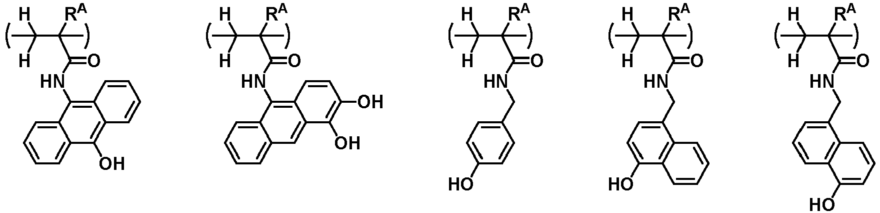

Repeat units A1 are preferably incorporated in an amount of 30 to 90 mol%, more preferably 60 to 85 mol% based on the overall repeat units of the polymer in the base polymer. In an embodiment wherein the polymer contains repeat units of at least one type selected from repeat units having formula (A2) and repeat units having formula (A3) for providing the polymer with higher etch resistance and the relevant units have a phenolic hydroxy group as the substituent, the amount of repeat units A1 plus the relevant units should preferably fall in the range. The repeat units A1 may be of one type or in admixture of two or more.

The polymer further contains repeat units of at least one type selected from aromatic ring-containing units having the formula (A2), aromatic ring-containing units having the formula (A3), and aromatic ring-containing units having the formula (A4), which are referred to as repeat units A2, A3, and A4, hereinafter.

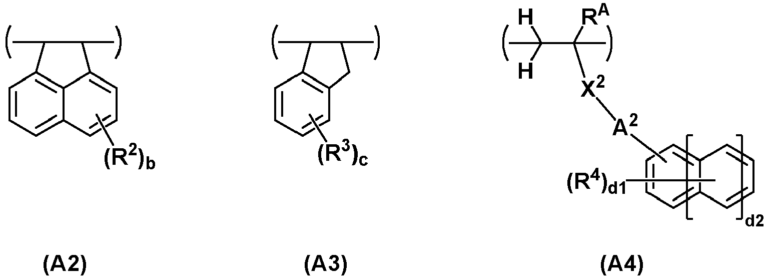

In formulae (A2) and (A3), b and c are each independently an integer of 0 to 4.

In formulae (A2) and (A3), R² and R³ are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl group, saturated hydrocarbyloxy group, and saturated hydrocarbylcarbonyloxy group may be straight, branched or cyclic. A plurality of R² may be identical or different when b is 2 or more. A plurality of R³ may be identical or different when c is 2 or more.

In formula (A4), R^{A} is hydrogen, fluorine, methyl or trifluoromethyl. The subscript d1 is an integer of 0 to 5, and d2 is an integer of 0 to 2.

In formula (A4), R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group. R⁴ may also be hydroxy when d2 is 1 or 2. The saturated hydrocarbyl group, saturated hydrocarbyloxy group, saturated hydrocarbylcarbonyloxy group, saturated hydrocarbyloxyhydrocarbyl group, and saturated hydrocarbylthiohydrocarbyl group may be straight, branched or cyclic. A plurality of R⁴ may be identical or different when d1 is 2 or more.

In formula (A4), X² is a single bond, *-C(=O)-O- or *-C(=O)-NH-, wherein * designates a point of attachment to the carbon atom in the backbone.

In formula (A4), A² is a single bond or a C₁-C₁₀ saturated hydrocarbylene group in which some -CH₂- may be replaced by -O-. The saturated hydrocarbylene group may be straight, branched or cyclic and examples thereof are as exemplified above for A¹ in formula (A1).

When repeat units A2 to A4 are incorporated, better performance is obtained because not only the aromatic ring possesses etch resistance, but the cyclic structure incorporated into the main chain also exerts the effect of improving resistance to etching and EB irradiation during pattern inspection step.

The repeat units A2 to A4 are preferably incorporated in a range of at least 5 mol% based on the overall repeat units of the polymer in the base polymer for obtaining the effect of improving etch resistance. Also, the repeat units A2 to A4 are preferably incorporated in a range of up to 25 mol%, more preferably up to 20 mol% based on the overall repeat units of the polymer in the base polymer. When the relevant units are free of functional groups or have a functional group other than hydroxy, their content of up to 25 mol% is preferred because the risk of forming development defects is eliminated. Each of the repeat units A2 to A4 may be of one type or a combination of plural types.

The total content of repeat units A1 and repeat units of at least one type selected from repeat units A2 to A4 is preferably at least 60 mol%, more preferably at least 70 mol% based on the overall repeat units of the polymer in the base polymer.

The polymer further comprises units containing a phenolic hydroxy group protected with an acid labile group, represented by the formula (A5), referred to as repeat units A5, hereinafter.

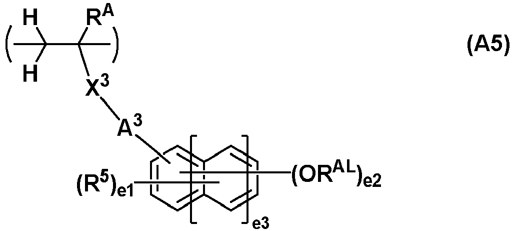

In formula (A5), R^{A} is hydrogen, fluorine, methyl or trifluoromethyl. The subscript e1 is an integer satisfying 0 ≤ e1 ≤ 5+2(e3)-e2, e2 is an integer of 1 to 3, and e3 is an integer of 0 to 2.

In formula (A5), X³ is a single bond, *-C(=O)-O- or *-C(=O)-NH-, wherein * designates a point of attachment to the carbon atom in the backbone.

In formula (A5), A³ is a single bond or a C₁-C₁₀ saturated hydrocarbylene group in which some -CH₂- may be replaced by -O-. The saturated hydrocarbylene group may be straight, branched or cyclic and examples thereof are as exemplified above for A¹ in formula (A1).

In formula (A5), R⁵ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group. The saturated hydrocarbyl group and saturated hydrocarbyl moiety in the saturated hydrocarbyloxy group and saturated hydrocarbylcarbonyloxy group may be straight, branched or cyclic and examples thereof are as exemplified above for R¹ in formula (A1). A carbon count within the upper limit ensures a high solubility in alkaline developer. A plurality of R⁵ may be identical or different when e1 is 2 or more.

In formula (A5), R^{AL} is an acid labile group of acetal form having the formula (AL-1) when e2 is 1. R^{AL} is hydrogen or an acid labile group of acetal form having the formula (AL-1), at least one R^{AL} being an acid labile group of acetal form having the formula (AL-1), when e2 is 2 or 3.

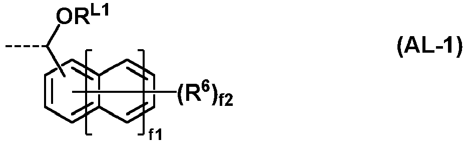

In formula (AL-1), f1 is an integer of 0 to 2, and f2 is an integer satisfying 0 ≤ f2 ≤ 5+2(f1).

In formula (AL-1), R⁶ is acetyl, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro or cyano group.

R⁶ is properly selected depending on how to design the sensitivity of the labile group to acid. To optimize the acetal elimination reaction, R⁶ may be selected from a variety of substituent groups including hydrogen, electron donative groups and electron attractive groups. The selection of an electron attractive group is preferred for ease of control of elimination reaction. When halogen is selected, the number of halogen atoms is preferably 3 or less from the aspects of reactivity control, compatibility with alkaline developer, and minimal development defects. When iodine is selected, the number of iodine atoms is more preferably up to 2 from the aspect of solubility in the resist solvent.

The acetal form acid labile group R^{AL} is structurally characterized in that an aromatic ring is bonded to the carbon atom to which two oxygen atoms are bonded. The acid labile group R^{AL} facilitates the optimum design of acid elimination reaction as compared with alkyl groups and cycloalkyl groups and provides higher etch resistance.

In formula (AL-1), R^{L1} is a C₁-C₃₀ hydrocarbyl group. The hydrocarbyl group may be saturated or unsaturated and straight, branched or cyclic. In the hydrocarbyl group, some carbon may be replaced by a heteroatom such as oxygen or sulfur to form an ether bond or sulfide bond. Examples thereof include C₁-C₃₀ saturated hydrocarbyl groups and C₆-C₃₀ aryl groups. R^{L1} is preferably a C₁-C₆ hydrocarbyl group in order to establish a higher resolution in forming small size patterns. When R^{L1} is a C₁-C₆ hydrocarbyl group, the alcohol formed after the progress of acid-catalyzed deprotection reaction is water soluble. When positive patterns are formed using an alkaline developer, the alcohol dissolves in the developer. Then residue defects in the exposed region can be reduced.

Examples of the group R^{L1} are shown below, but not limited thereto. Herein, * designates a point of attachment to the adjacent -O-.

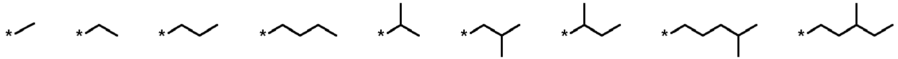

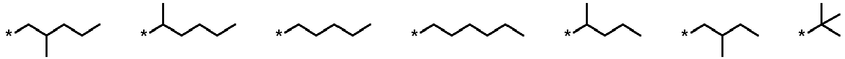

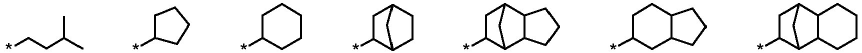

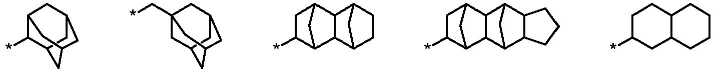

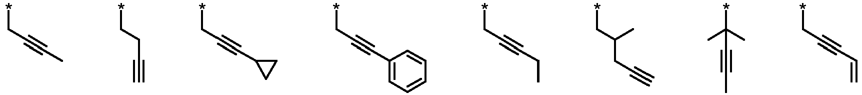

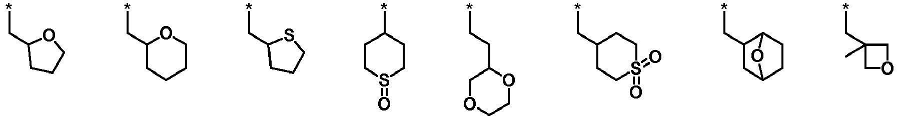

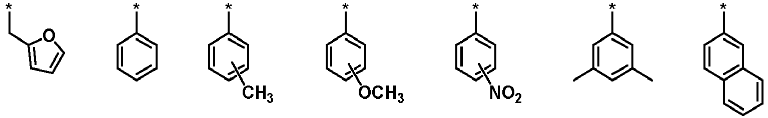

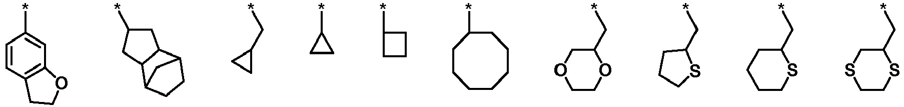

Examples of the acetal form acid labile group having formula (AL-1) are shown below, but not limited thereto. Herein, R^{L1} is as defined above.

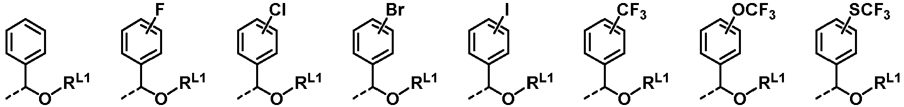

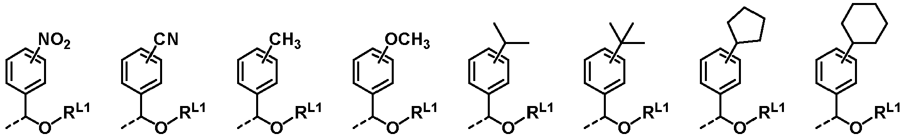

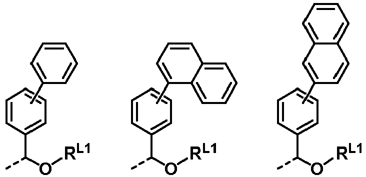

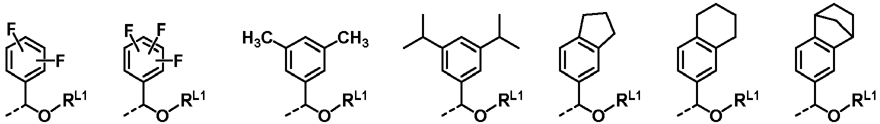

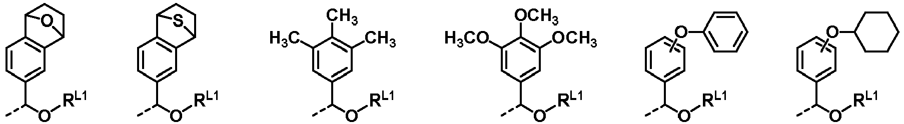

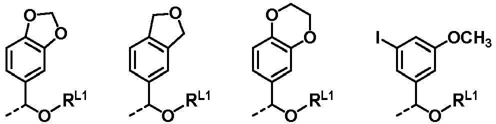

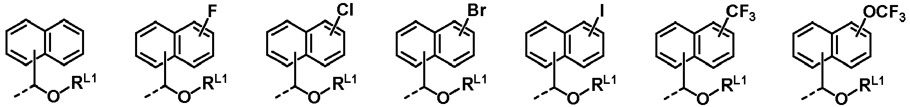

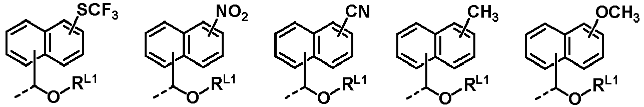

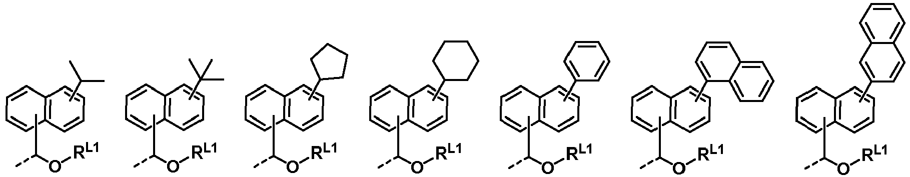

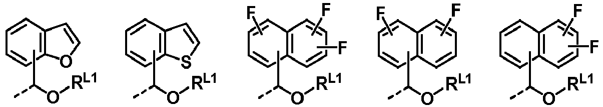

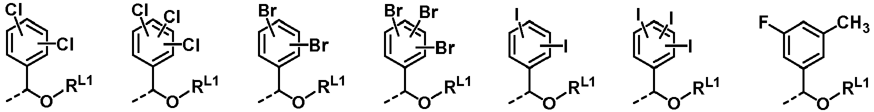

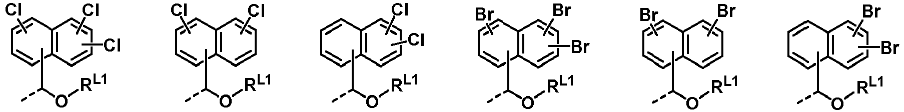

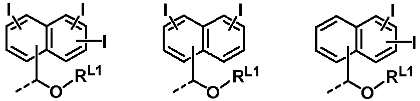

Of the units containing a phenolic hydroxy group protected with an acid labile group, units having the formula (A5-1) are preferred. 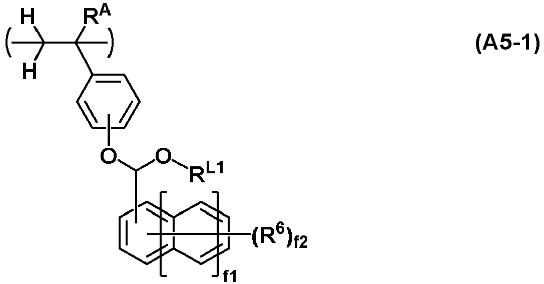 Herein R^{A}, R⁶, f1, f2 and R^{L1} are as defined above.

Known methods of protecting a polymer as polymerized with an acid labile group of acetal form include a method of using a vinyl ether in the presence of an acid catalyst and a method of using an acetalizing agent having a haloalkoxy group along with a base. The latter method is preferred herein.

In the method of using an acetalizing agent having a haloalkoxy group along with a base, the acetalizing agent having a haloalkoxy group is added dropwise in the presence of a basic compound such as triethylamine. The reaction temperature is -20°C to 50°C and the reaction time is 0.2 to 10 hours, preferably 0.5 to 6 hours.

The repeat units protected with an acid labile group of acetal form are preferably incorporated in an amount of 10 to 40 mol%, more preferably 10 to 30 mol%, even more preferably 20 to 30 mol% based on the overall repeat units of the polymer in the base polymer.

In addition to the polymer having an acid labile group of acetal form, the base polymer may contain a polymer having a well-known acid labile group other than the acid labile group of acetal form having formula (AL-1), such as tertiary alkyl groups or tert-butoxycarbonyl groups. In this embodiment, the polymer having an acid labile group other than the acid labile group of acetal form having formula (AL-1) preferably contains repeat units having an acid labile group other than the acid labile group of acetal form having formula (AL-1) and repeat units A1, and optionally, repeat units A2 to A4. In order to obtain the benefits of the invention, the polymer having the acid labile group of acetal form preferably accounts for at least 50% by weight of the base polymer in the positive resist composition.

The number of halogen atoms in the repeat units of the base polymer is preferably up to 3. If 4 or more halogen atoms are contained, the solubility of the base polymer in an alkaline developer is so reduced that development residues may be left behind.

Since the acetal form acid labile group is also effective for suppressing the influence of back scattering during EB image writing, the resist composition prevents the pattern profile from being inversely tapered in a sensitivity region of at least 50 µC/cm², preferably at least 80 µC/cm², more preferably at least 100 µC/cm² and displays excellent rectangular performance.

The base polymer should preferably have a Mw of 1,000 to 20,000, and more preferably 4,000 to 7,000. A Mw of at least 1,000 eliminates the risk that pattern features are rounded at their top to invite degradations of resolution and LER. A Mw of up to 20,000 eliminates the risk that LER is degraded when a pattern with a line width of up to 100 nm is formed. As used herein, Mw is measured by GPC versus polystyrene standards using tetrahydrofuran (THF) or dimethylformamide (DMF) solvent.

The base polymer preferably has a narrow molecular weight distribution or dispersity (Mw/Mn) of 1.0 to 2.0, more preferably 1.0 to 1.8, even more preferably 1.0 to 1.6. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

### [(B) Photoacid generator]

The positive resist composition further comprises a photoacid generator (PAG). The PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

Suitable PAGs include nonafluorobutane sulfonate, partially fluorinated sulfonates described in JP-A 2012-189977, paragraphs [0247]-[0251], partially fluorinated sulfonates described in JP-A 2013-101271, paragraphs [0261]-[0265], and those described in JP-A 2008-111103, paragraphs [0122]-[0142] and JP-A 2010-215608, paragraphs [0080]-[0081]. Among others, arylsulfonate and alkanesulfonate type PAGs are preferred because they generate acids having an appropriate strength to deprotect the acid labile group in the repeat units having formula (A5).

The preferred PAGs are onium salt compounds having anions of the structure shown below.

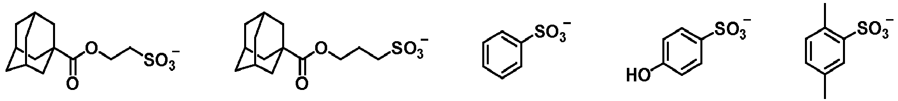

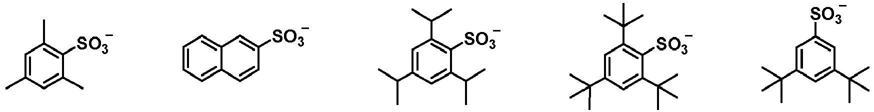

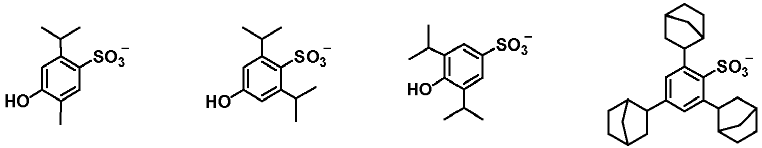

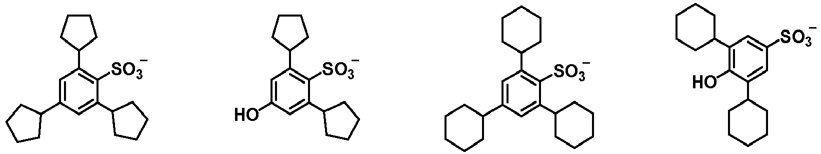

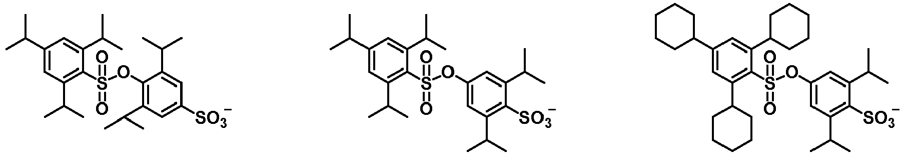

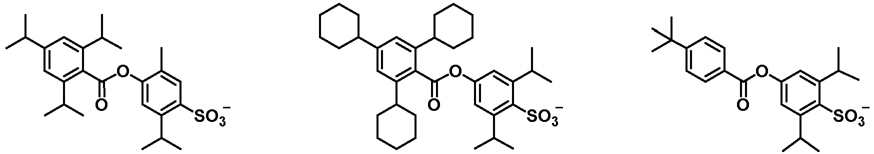

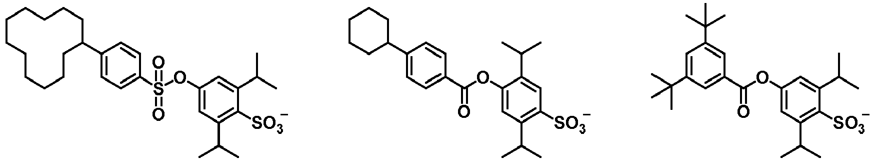

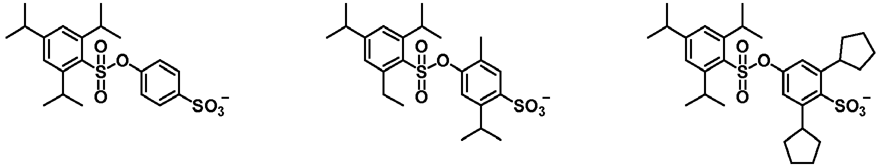

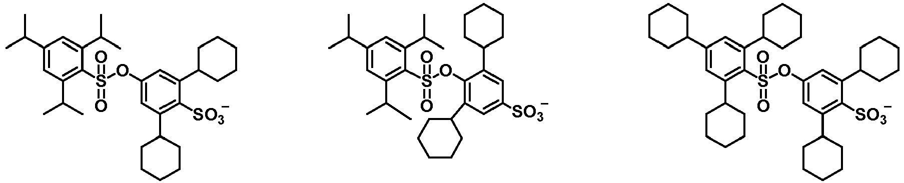

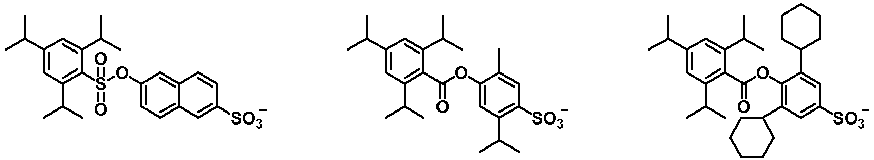

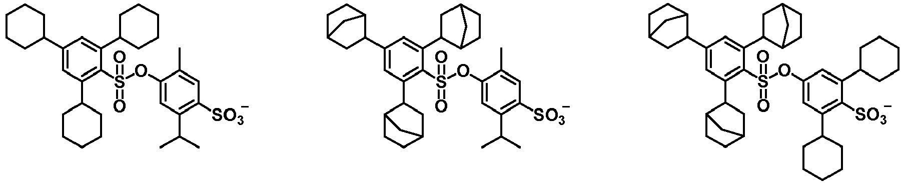

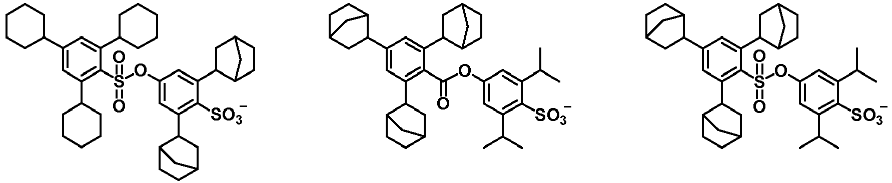

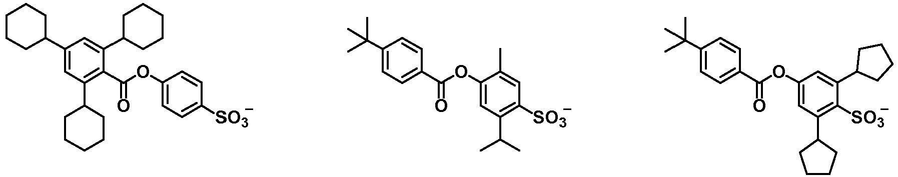

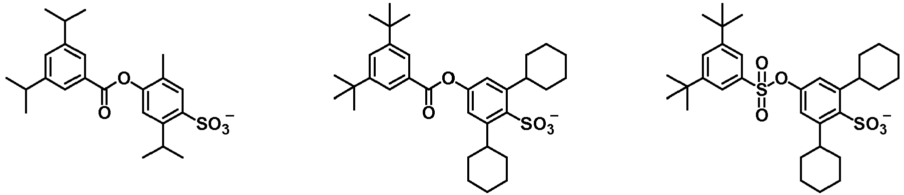

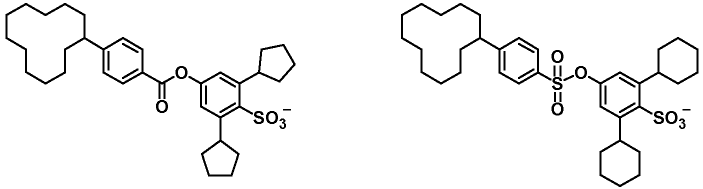

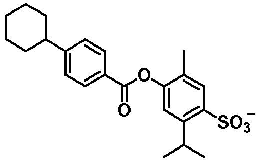

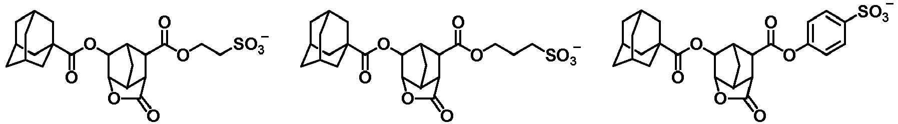

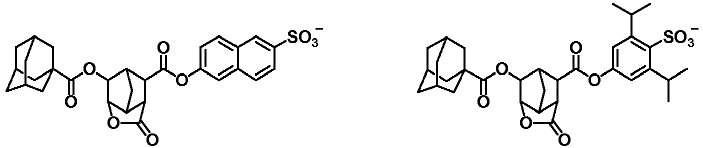

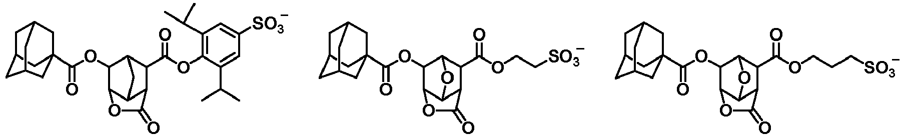

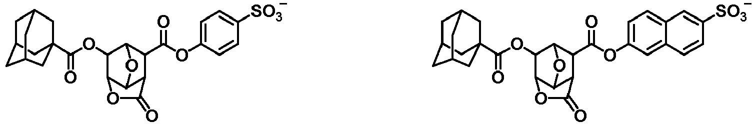

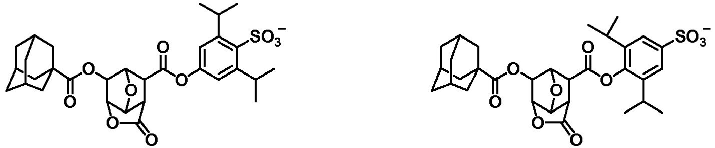

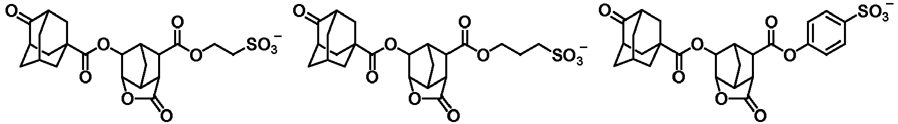

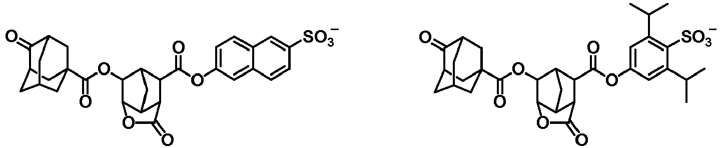

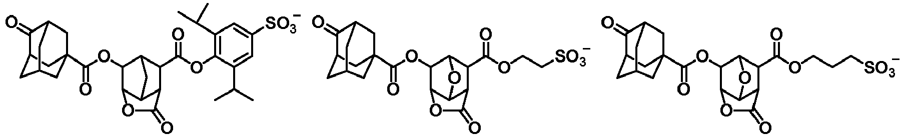

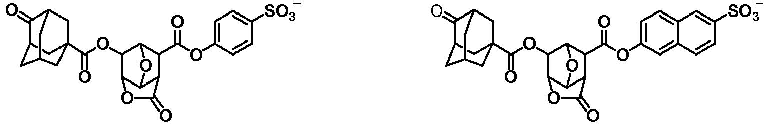

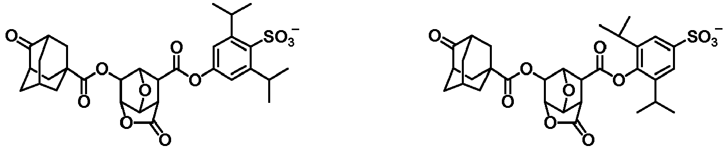

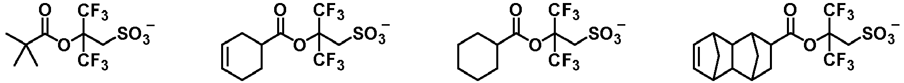

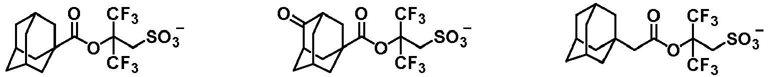

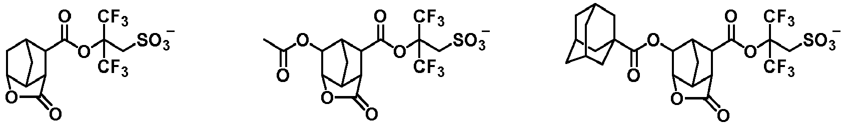

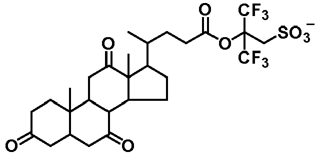

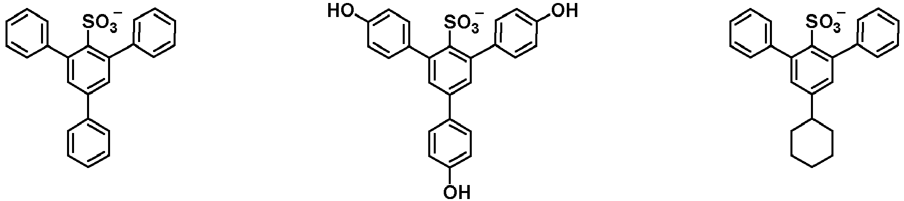

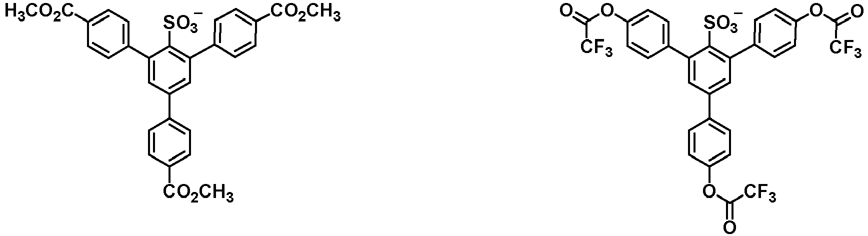

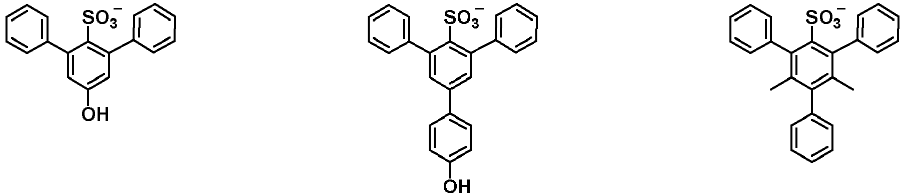

Onium salt compounds having an anion of the formula (B-1) are also preferred as the PAG (B).

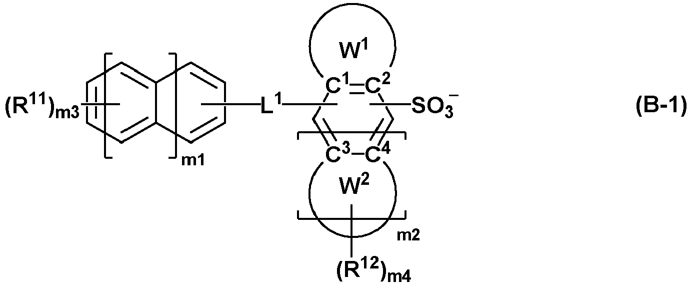

In formula (B-1), m1 and m2 are each independently an integer of 0 to 2. The relevant structure represents a benzene ring when m1=0, a naphthalene ring when m1=1, and an anthracene ring when m1=2. From the aspect of solvent solubility, a benzene ring corresponding to m1=0 is preferred. From the aspect of solvent solubility, m2=0 is preferred.

In formula (B-1), m3 is an integer of 1 to 5 in case of m1=0, an integer of 1 to 7 in case of m1=1, and an integer of 1 to 9 in case of m1=2. The subscript m4 is an integer of 0 to 5 in case of m2=0, an integer of 0 to 7 in case of m2=1, and an integer of 0 to 9 in case of m2=2.

In formula (B-1), L¹ is a single bond, ether bond, ester bond, sulfonate ester bond, amide bond, carbonate bond or carbamate bond. Inter alia, an ether bond, ester bond, and sulfonate ester bond are preferred, with sulfonate ester bond being more preferred.

In formula (B-1), R¹¹ is each independently iodine or a C₃-C₂₀ branched or cyclic hydrocarbyl group which may contain a heteroatom, at least one R¹¹ is attached to a carbon atom adjoining the carbon atom to which L¹ is attached. Examples of the hydrocarbyl group include, but are not limited to, C₃-C₂₀ aliphatic cyclic hydrocarbon groups such as isopropyl, sec-butyl, tert-butyl, tert-pentyl, cyclopentyl, cyclohexyl, 2-ethylhexyl, cyclopentylmethyl, cyclopentylethyl, cyclopentylbutyl, cyclohexylmethyl, cyclohexylethyl, cyclohexylbutyl, norbornyl, oxanorbornyl, tricyclo[5.2.1.0^{2,6}]decyl, and adamantyl; aryl groups such as phenyl, naphthyl and anthracenyl; and combinations thereof. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, halogen, carbonyl moiety, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine and iodine, with fluorine and iodine being preferred. When m3 is 2 or more, a plurality of R¹¹ may be identical or different.

When m3 is 2 or more, a plurality of R¹¹ may bond together to form a ring with the carbon atoms to which they are attached. Preferred is a 5 to 8-membered ring.

In formula (B-1), R¹² is each independently a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl, and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; and C₆-C₂₀ aryl groups such as phenyl, naphthyl and anthracenyl. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, halogen, carbonyl moiety, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine, and iodine, with fluorine and iodine being preferred. When m4 is 2 or more, a plurality of R¹² may be identical or different.

When m4 is 2 or more, a plurality of R¹² may bond together to form a ring with the carbon atoms to which they are attached. Preferred is a 5 to 8-membered ring.

In formula (B-1), W¹ forms a C₃-C₁₅ ring with the carbon atoms C¹ and C² on the adjoining aromatic ring, some carbon on the ring may be replaced by a heteroatom-containing group. The ring may be mono or polycyclic. W² forms a C₃-C₁₅ ring with the carbon atoms C³ and C⁴ on the adjoining aromatic ring, some carbon on the ring may be replaced by a heteroatom-containing group. The ring may be mono or polycyclic.

Exemplary structures of the ring that W¹ or W² in formula (B-1) forms by fusing to the adjoining aromatic ring are shown below, but not limited thereto. Herein, the broken line designates a point of attachment to L¹.

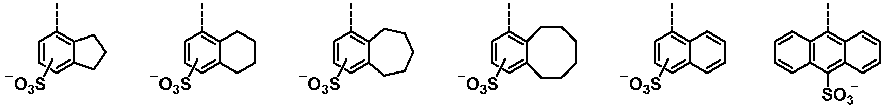

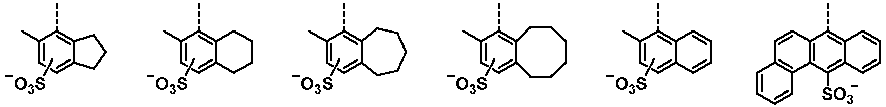

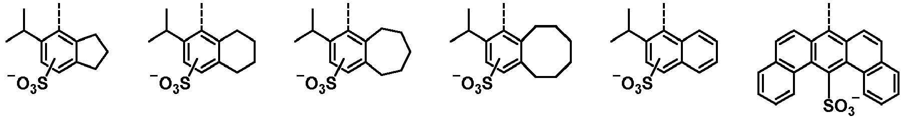

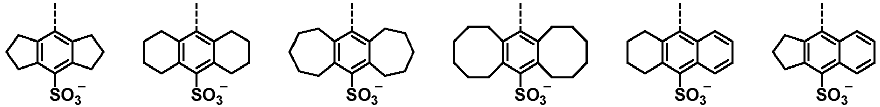

Examples of the structure that R¹¹ forms with the aromatic ring in formula (B-1) are shown below, but not limited thereto. Herein, the broken line designates a point of attachment to L¹.

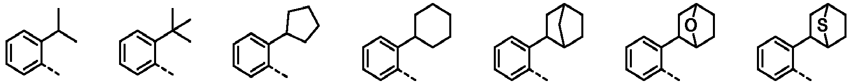

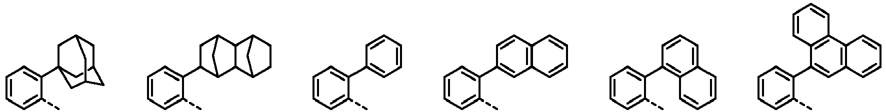

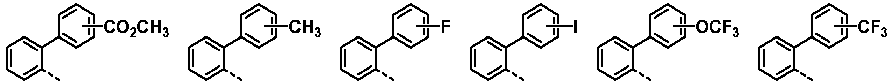

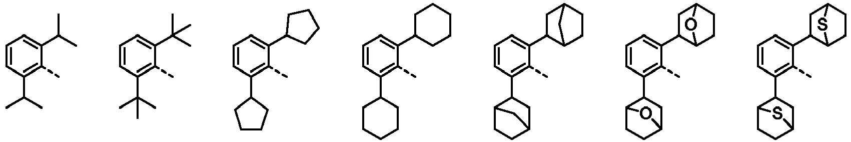

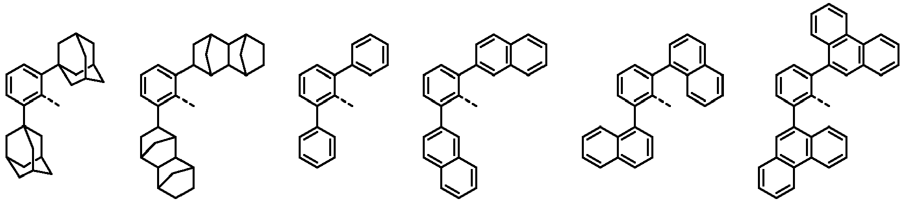

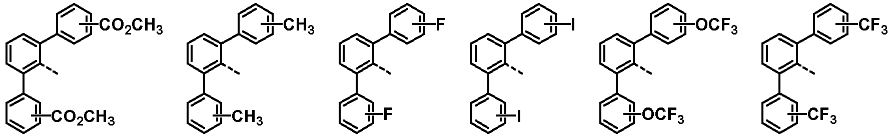

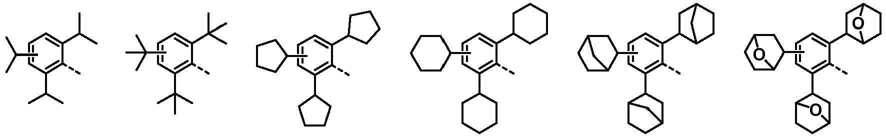

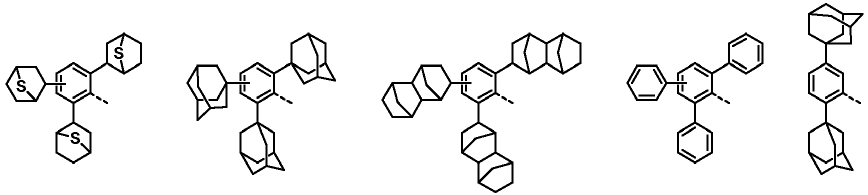

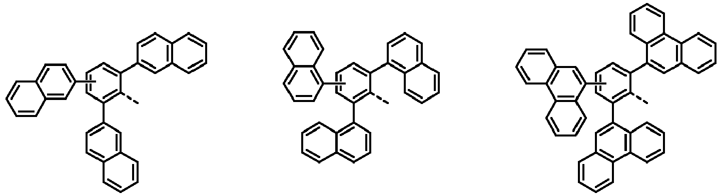

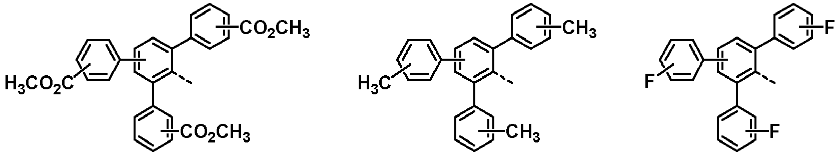

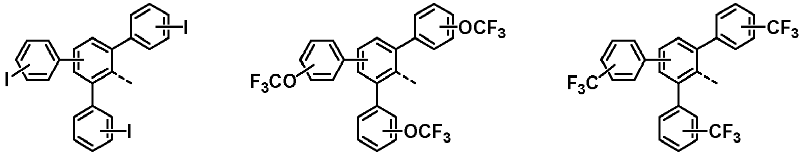

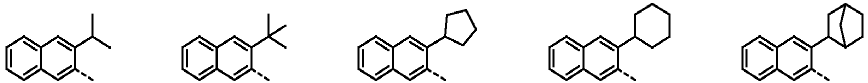

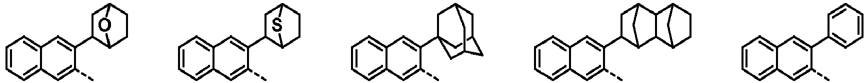

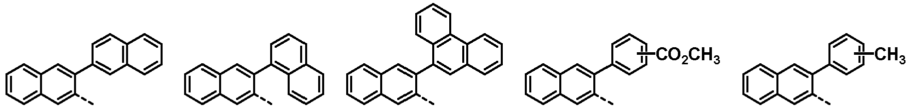

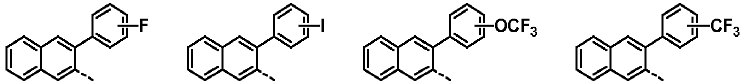

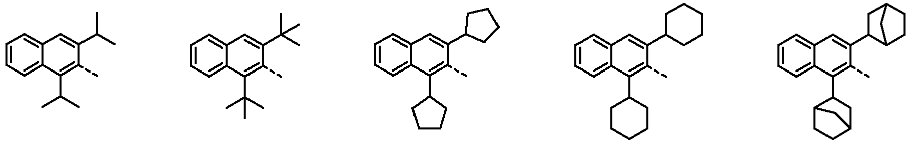

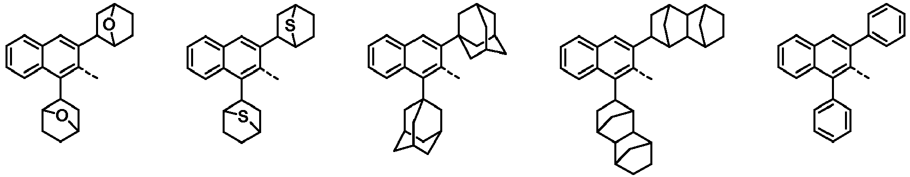

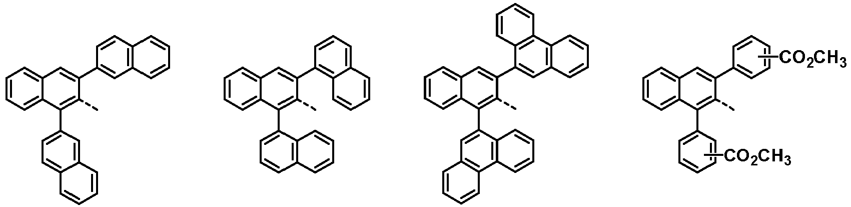

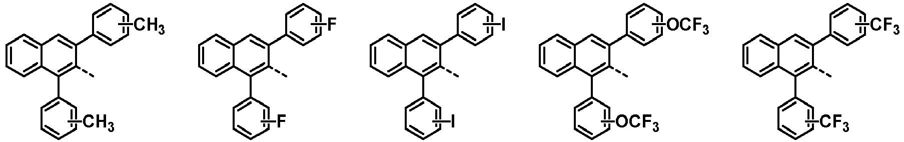

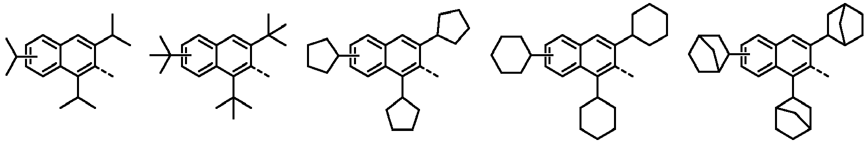

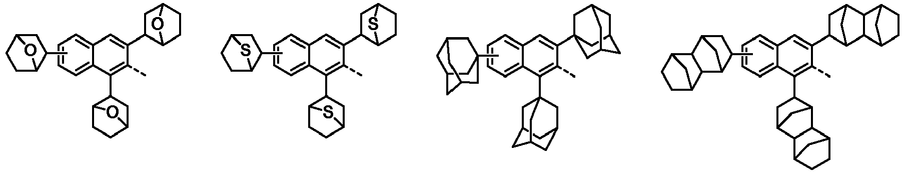

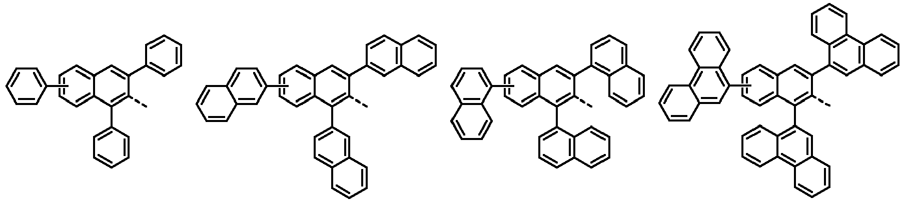

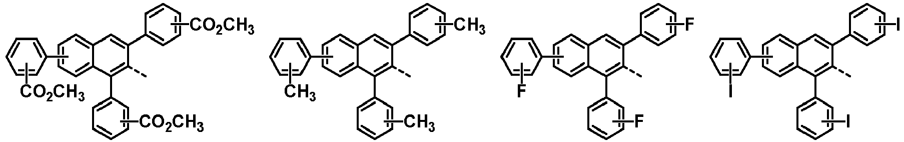

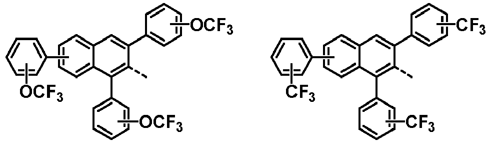

Of the anions having formula (B-1), anions having the formula (B-1-1) are preferred. 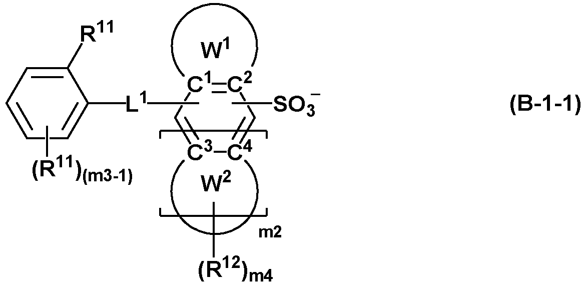 Herein m2, m3, m4, L¹, R¹¹, R¹², W¹, and W² are as defined above.

Of the anions having formula (B-1-1), anions having the formula (B-1-2) are more preferred. 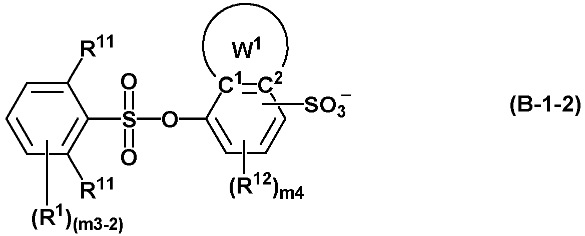 Herein m3, m4, R¹¹, R¹², and W¹ are as defined above.

Preferred examples of the anion having formula (B-1) are shown below, but not limited thereto.

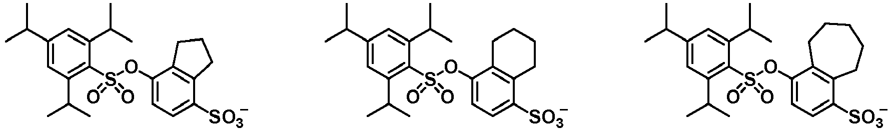

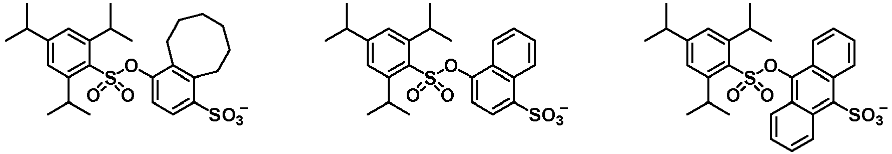

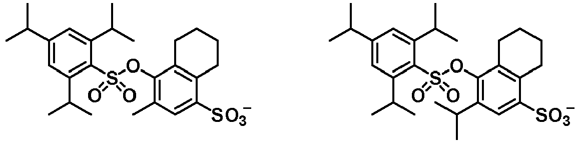

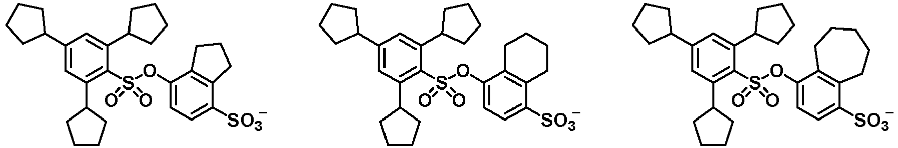

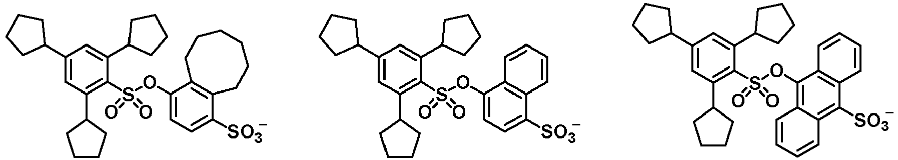

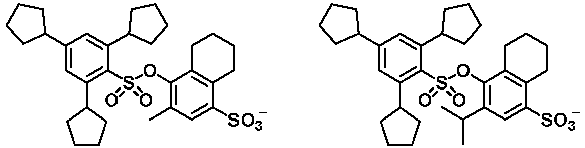

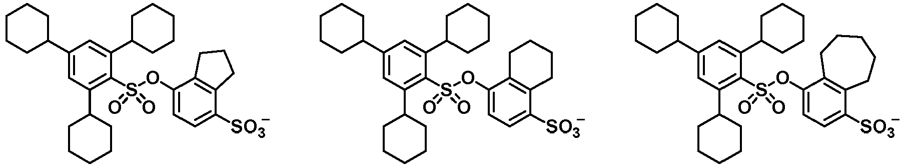

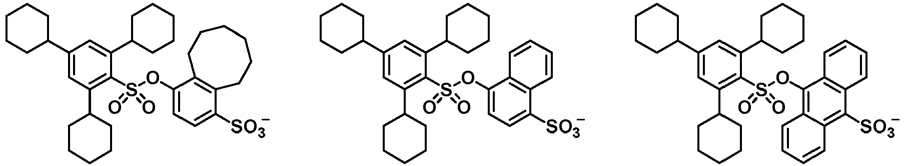

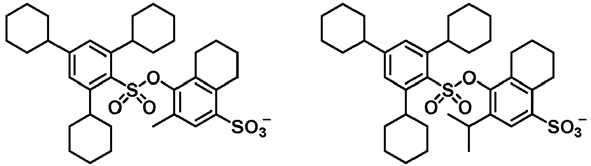

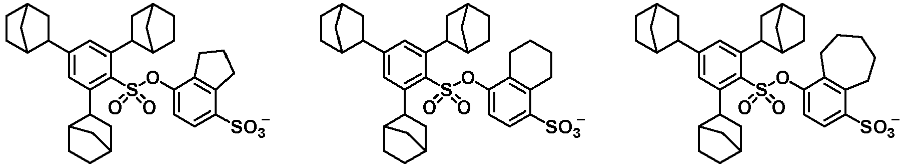

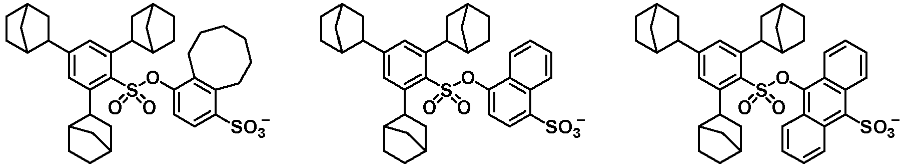

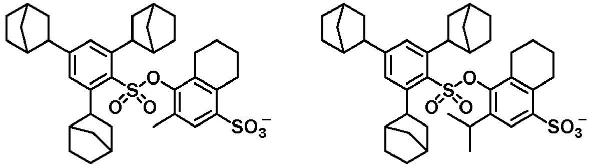

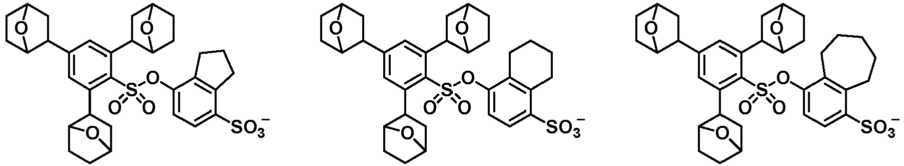

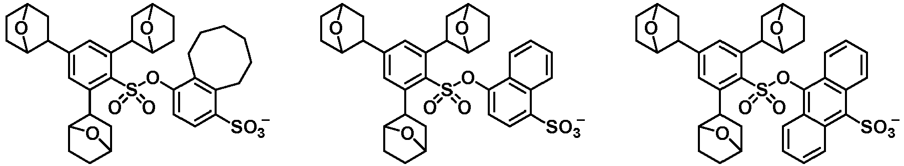

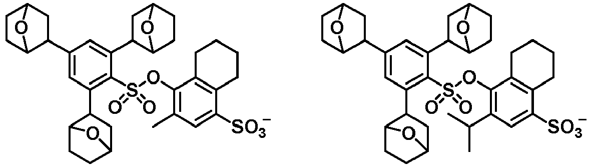

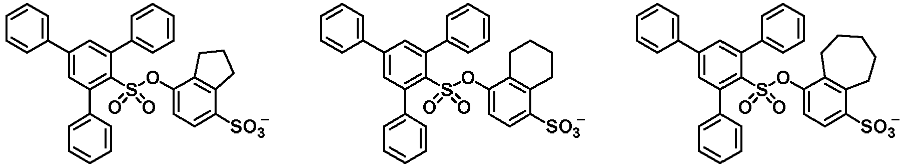

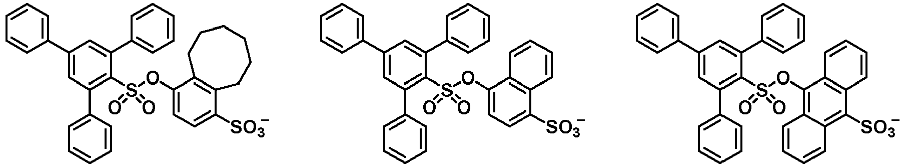

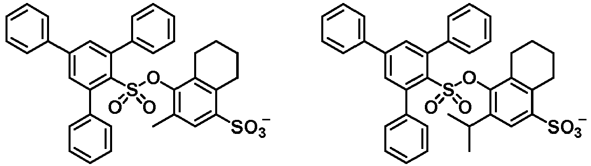

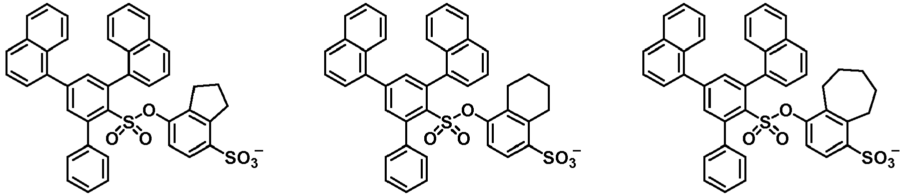

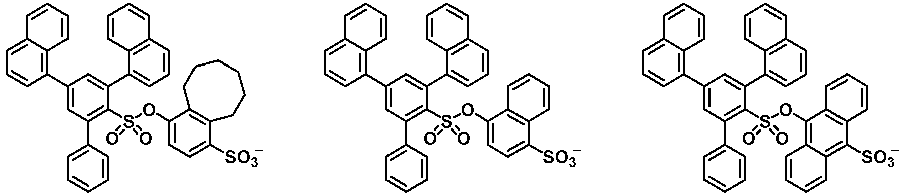

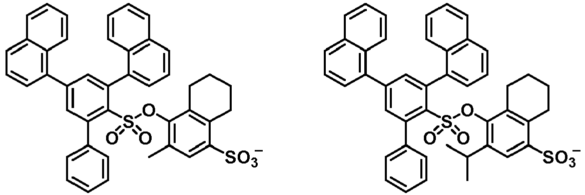

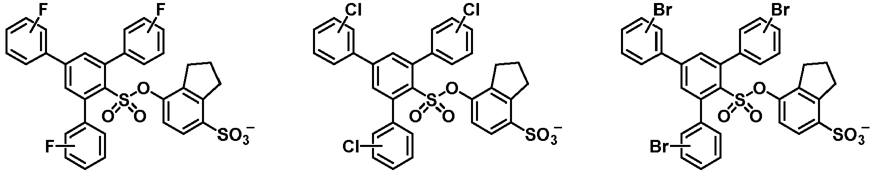

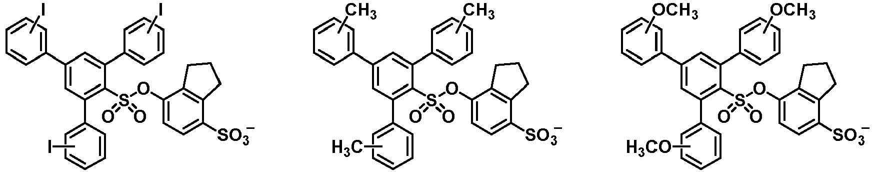

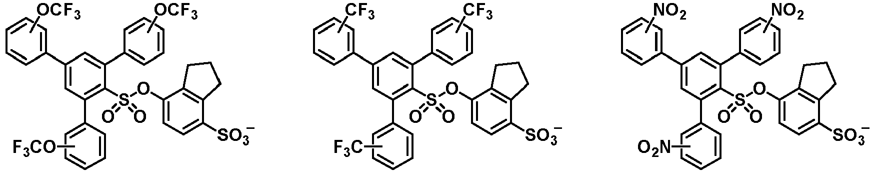

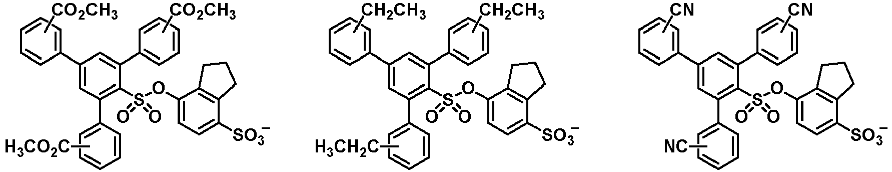

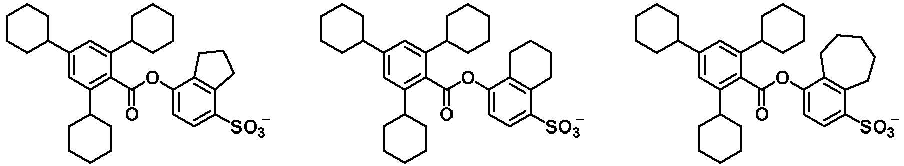

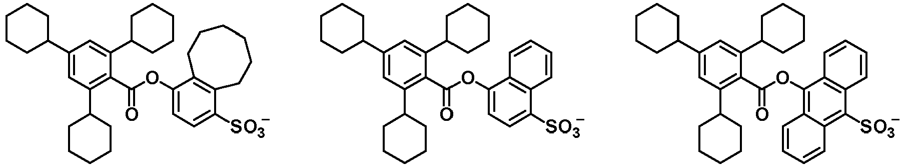

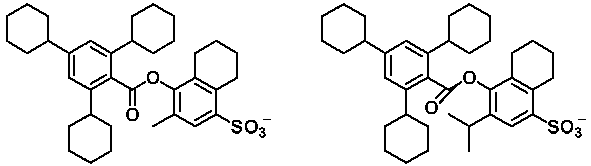

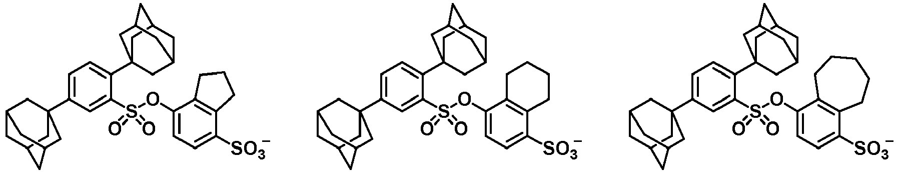

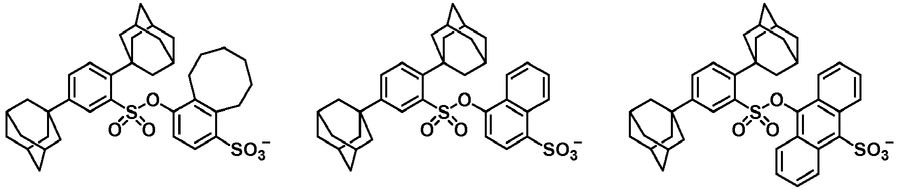

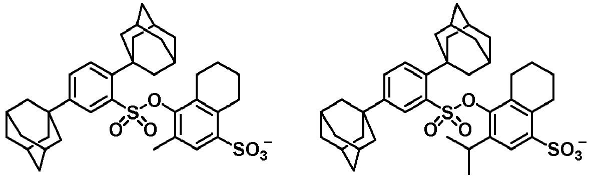

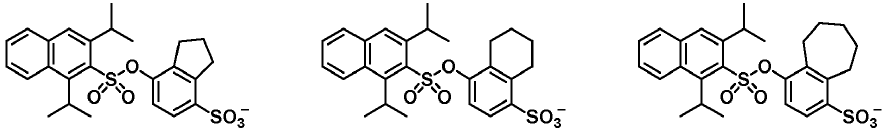

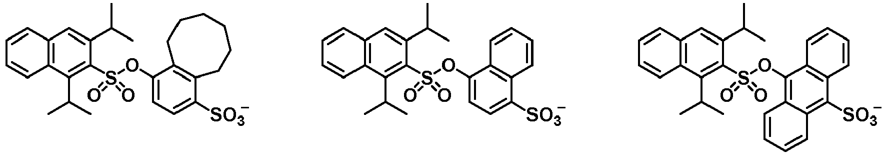

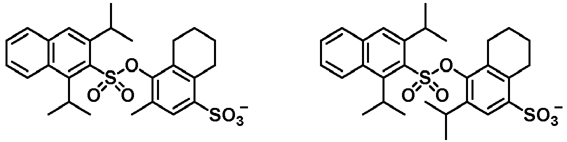

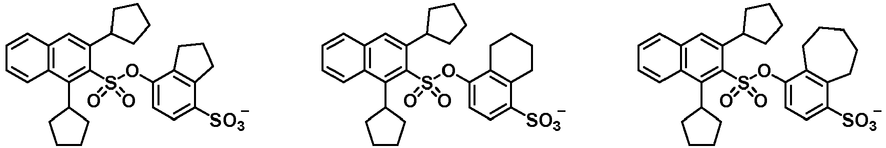

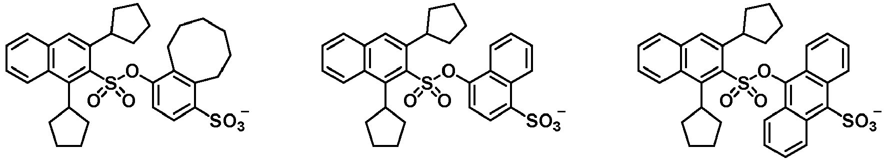

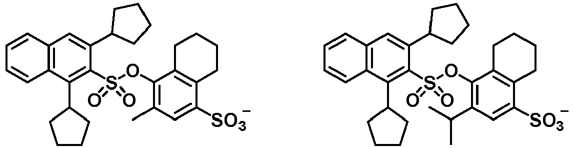

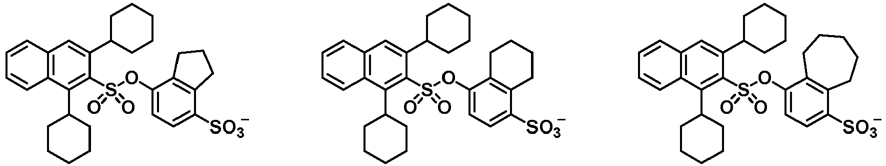

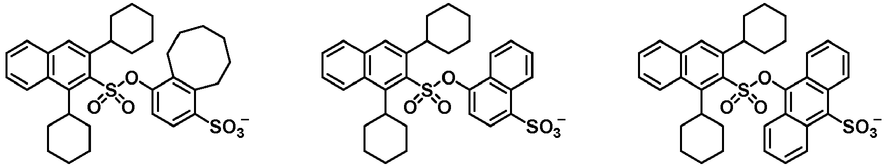

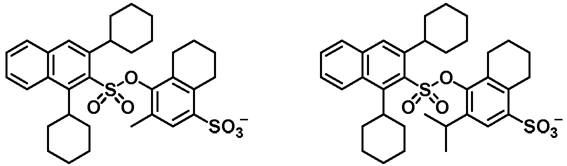

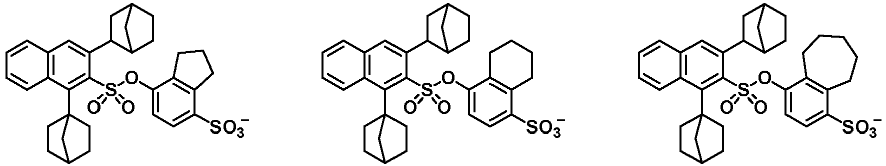

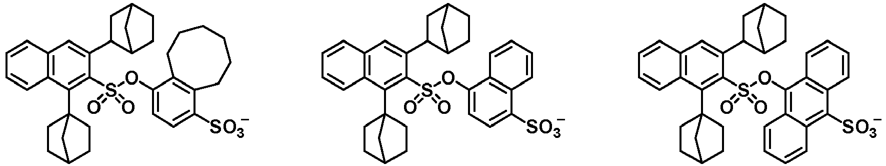

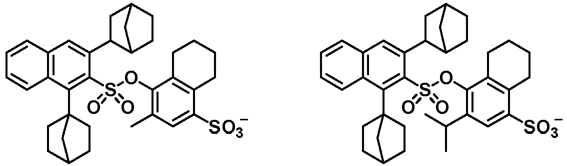

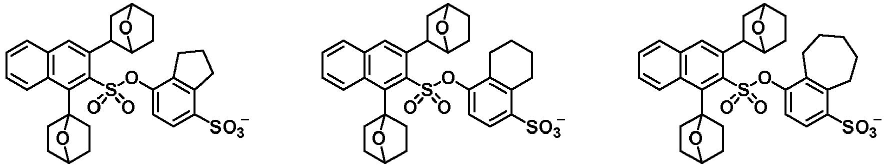

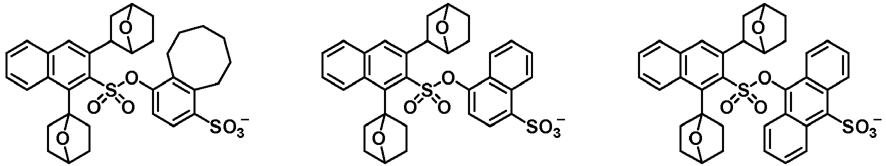

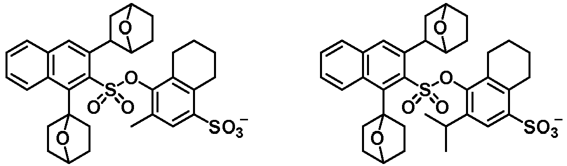

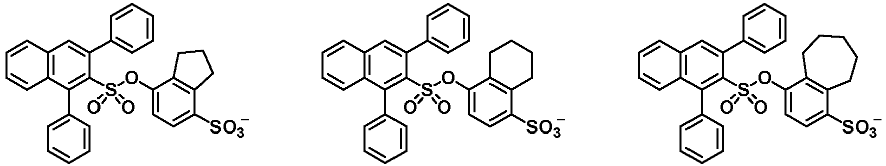

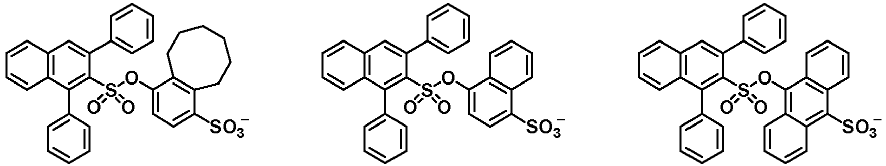

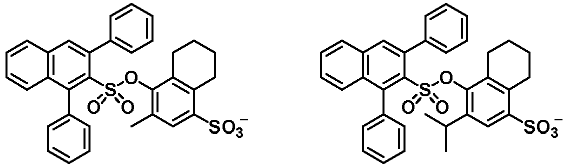

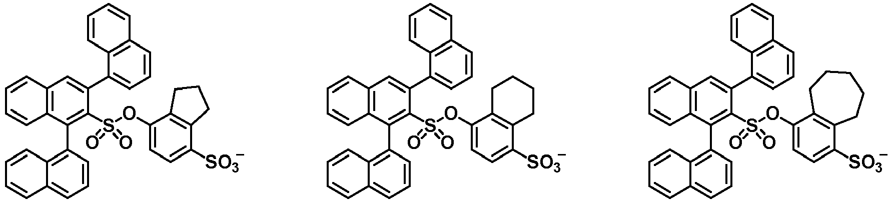

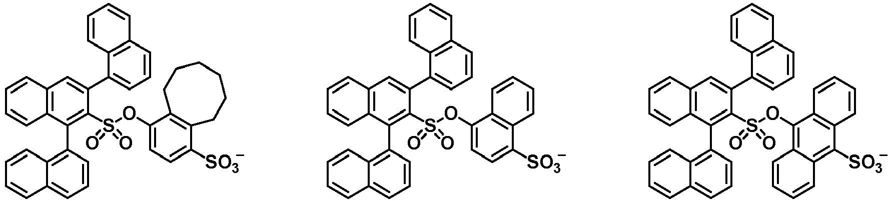

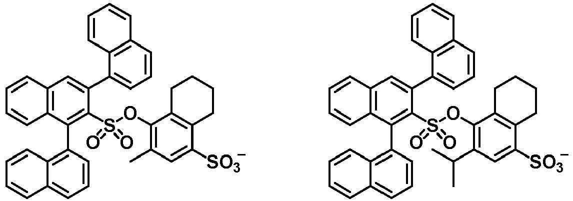

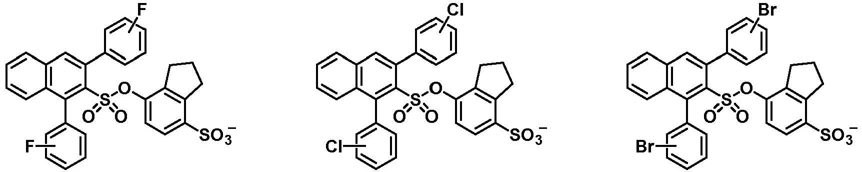

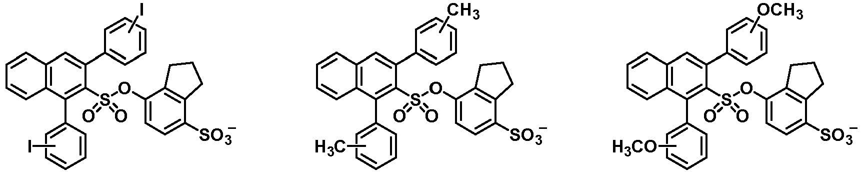

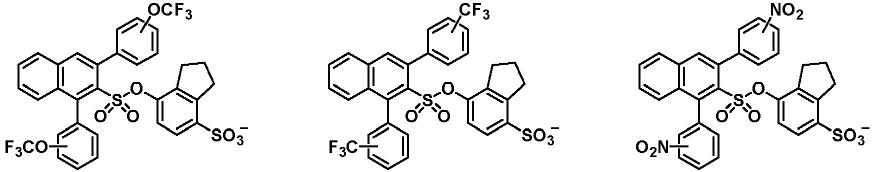

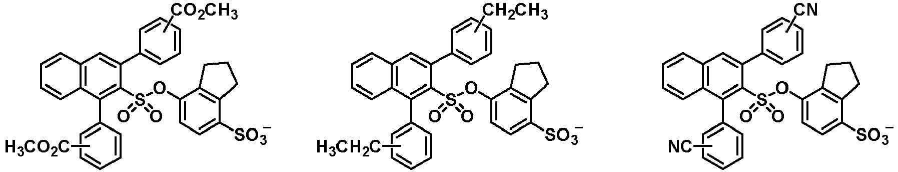

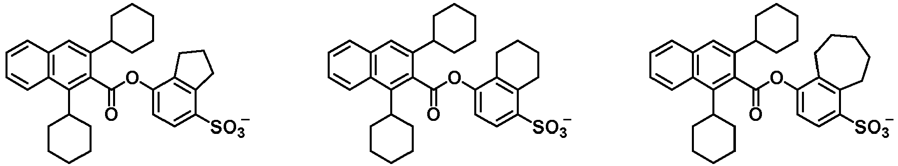

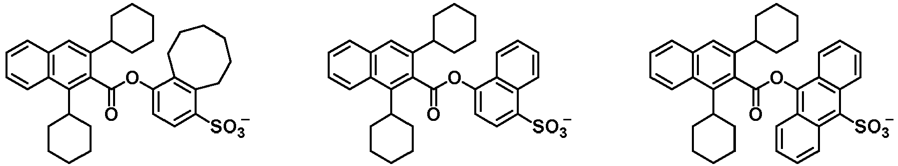

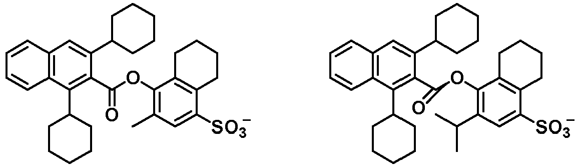

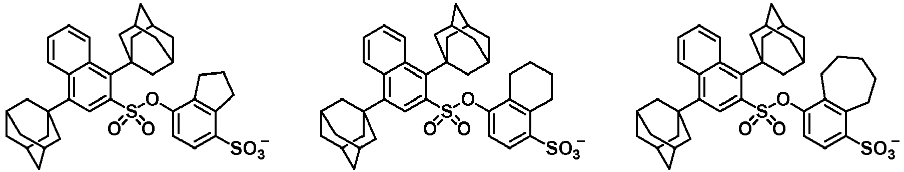

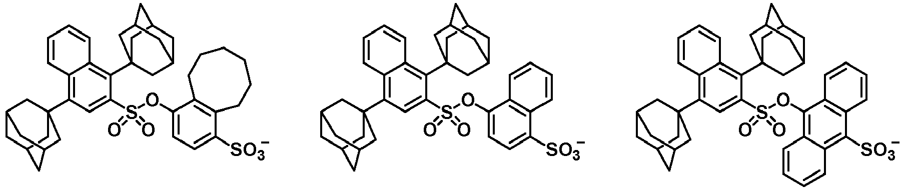

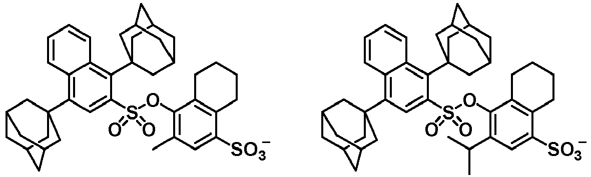

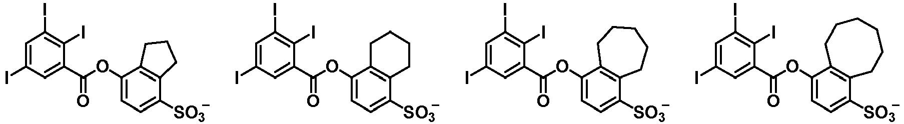

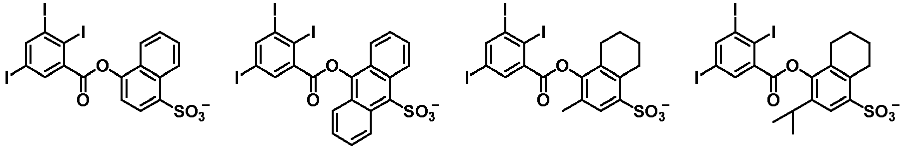

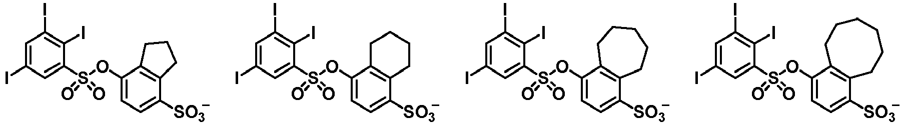

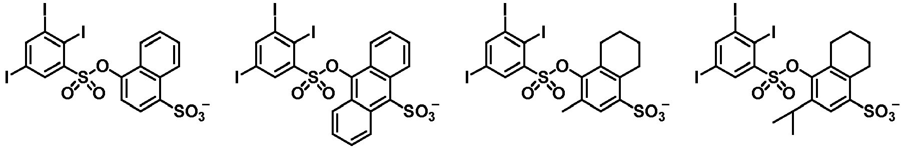

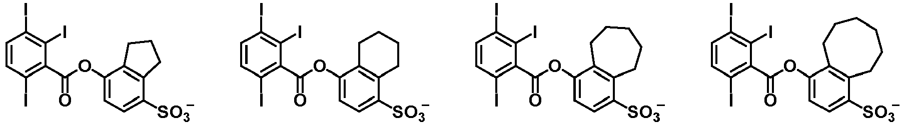

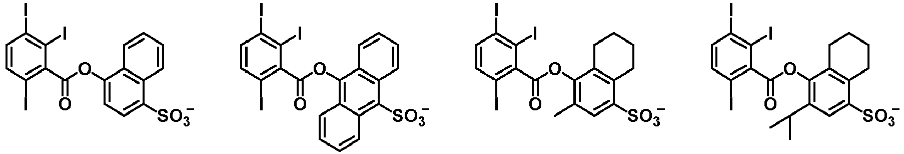

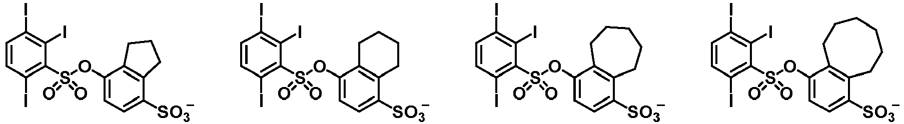

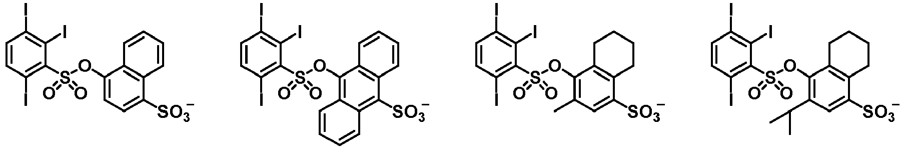

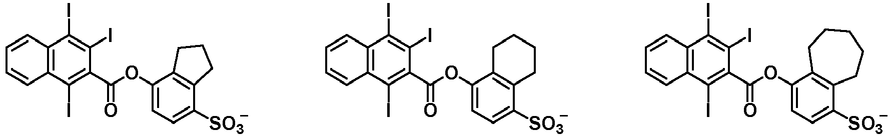

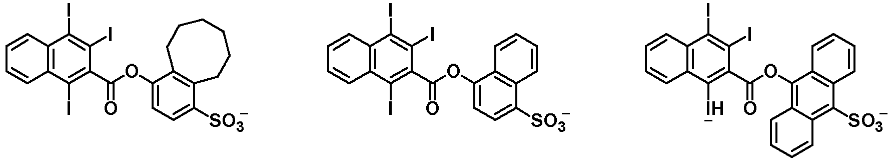

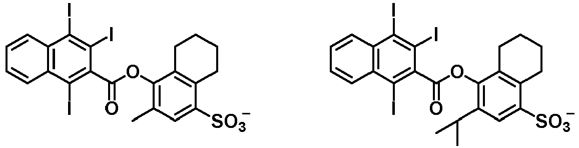

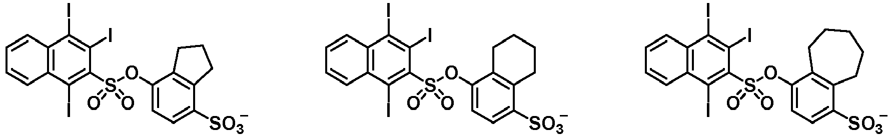

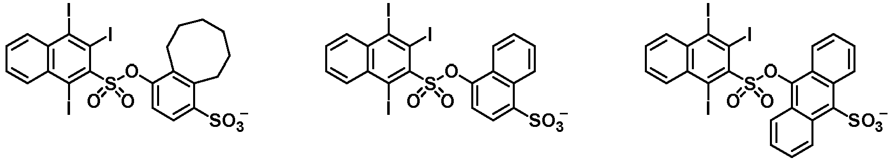

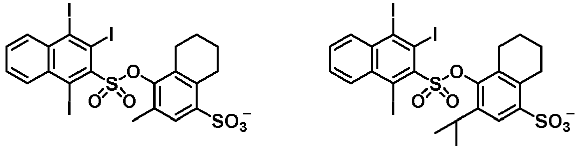

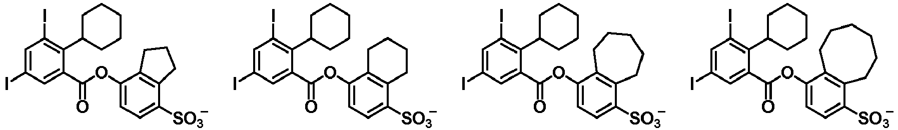

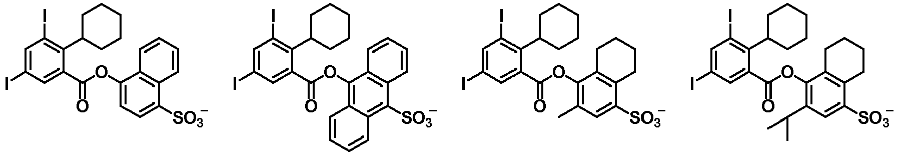

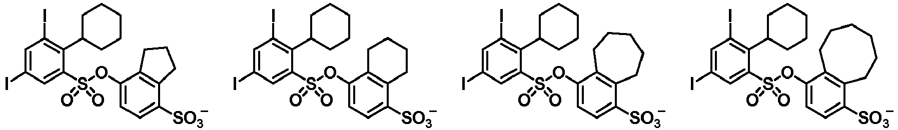

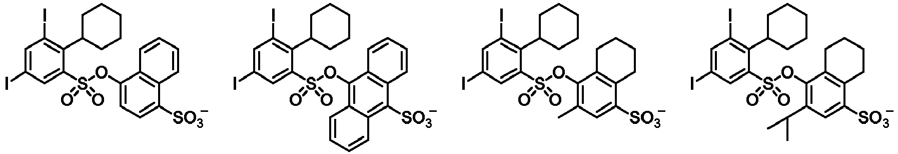

Since the onium salt containing an anion of formula (B-1) is an onium salt of a non-fluorinated sulfonic acid, it generates an acid having an adequate strength upon exposure to high-energy radiation. The onium salt is structurally characterized by having one ring structure fused to an aromatic ring attached to a sulfo group of an anion and another aromatic ring structure containing a bulky substituent. The steric hindrance of these two aromatic rings restrains the degree of freedom of rotation of the bond linking the aromatic rings, for thereby limiting excessive diffusion of the generated acid. In addition, since the onium salt is fully lipophilic, its preparation and handling are easy. Due to these effects, the acid featuring an adequate acid strength and controlled diffusion is generated in the resist film. Then a small-size pattern is formed with satisfactory resolution and reduced LER. When the positive resist composition is developed in an alkaline developer, a pattern of satisfactory rectangularity is obtainable by virtue of properly inhibited dissolution.

An onium salt compound containing an anion having the formula (B-2) is also preferred as the PAG (B).

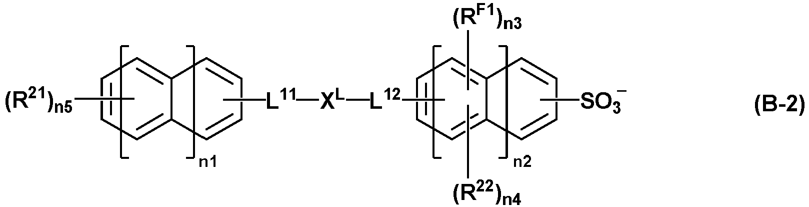

In formula (B-2), n1 and n2 are each independently an integer of 0 to 2, n3 is an integer of 1 to 4 in case of n2=0, an integer of 1 to 6 in case of n2=1, and an integer of 1 to 8 in case of n2=2.

In formula (B-2), n4 is an integer of 0 to 3 in case of n2=0, an integer of 0 to 5 in case of n2=1, and an integer of 0 to 7 in case of n2=2, n3+n4 is from 1 to 4 in case of n2=0, from 1 to 6 in case of n2=1, and from 1 to 8 in case of n2=2.

In formula (B-2), n5 is an integer of 1 to 5 in case of n1=0, an integer of 1 to 7 in case of n1=1, and an integer of 1 to 9 in case of n1=2.

In formula (B-2), R²¹ is each independently iodine or a C₃-C₂₀ branched or cyclic hydrocarbyl group which may contain a heteroatom, at least one R²¹ is attached to a carbon atom adjoining the carbon atom to which L¹¹ is attached. Examples of the hydrocarbyl group include, but are not limited to, branched alkyl groups such as isopropyl, sec-butyl, tert-butyl, tert-pentyl, and 2-ethylhexyl; C₃-C₂₀ cyclic saturated hydrocarbon groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, oxanorbornyl, tricyclo[5.2.1.0^{2,6}]decyl, and adamantyl; aryl groups such as phenyl, naphthyl and anthracenyl; and combinations thereof. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, halogen, carbonyl moiety, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine and iodine, with fluorine and iodine being preferred. A plurality of R²¹ may be identical or different when n5 is 2 or more.

A plurality of R²¹ may bond together to form a ring with the carbon atoms to which they are attached when n5 is 2 or more. Preferred is a 5 to 8-membered ring.

Examples of the structure formed by bonding R²¹ to the aromatic ring in formula (B-2) are shown below, but not limited thereto. The broken line designates a point of attachment to L¹¹.

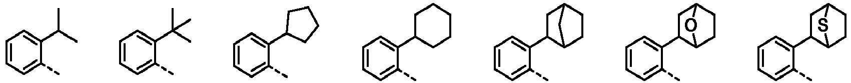

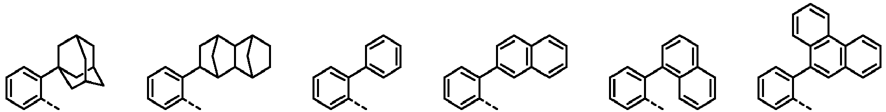

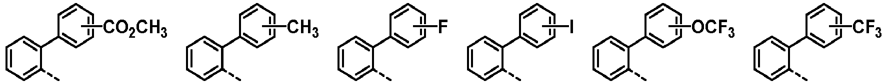

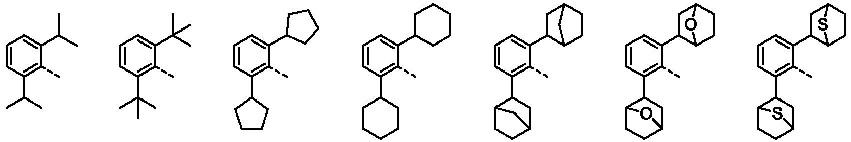

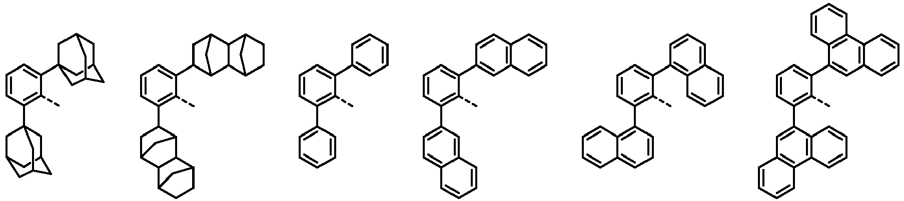

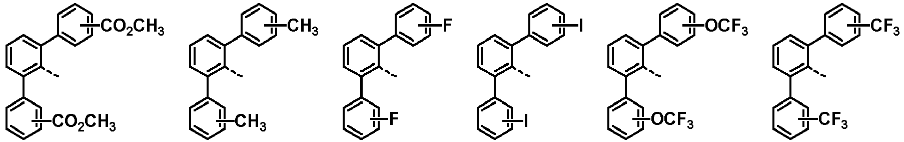

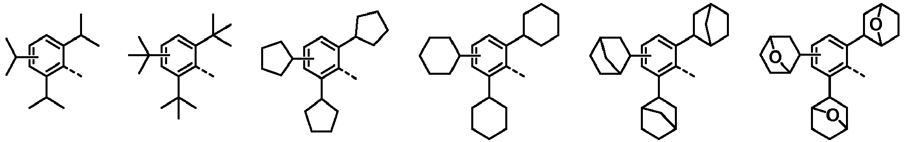

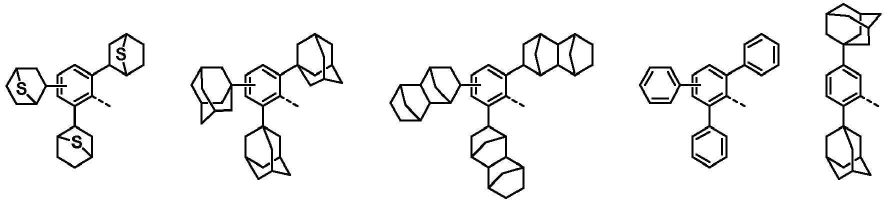

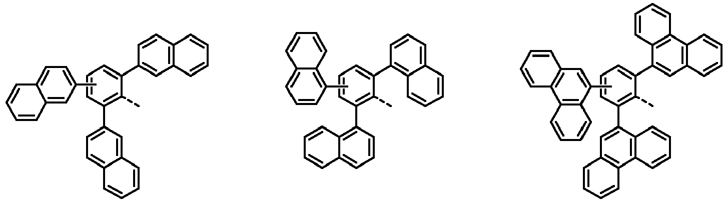

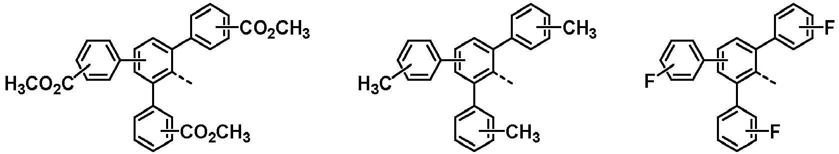

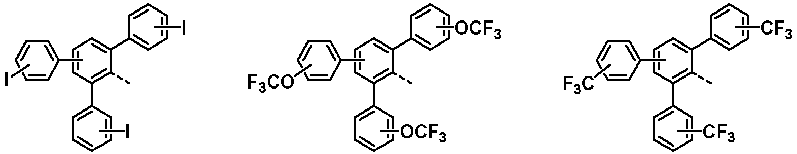

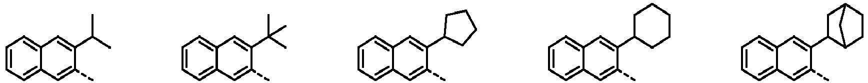

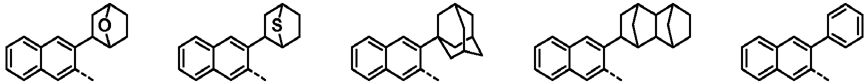

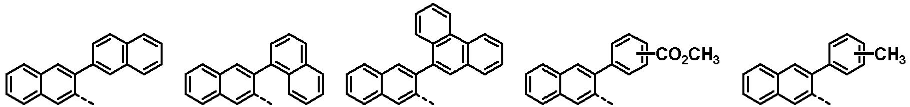

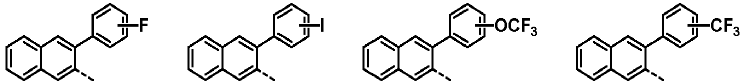

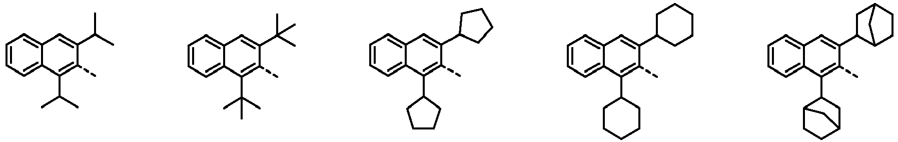

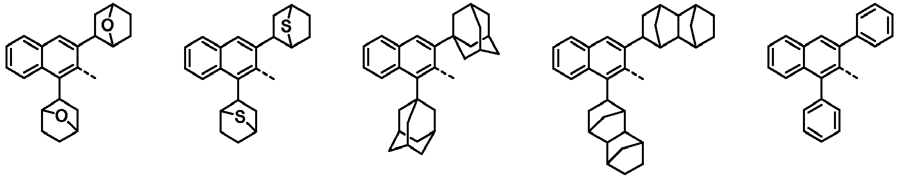

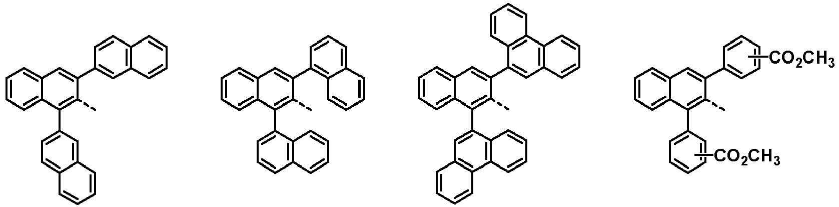

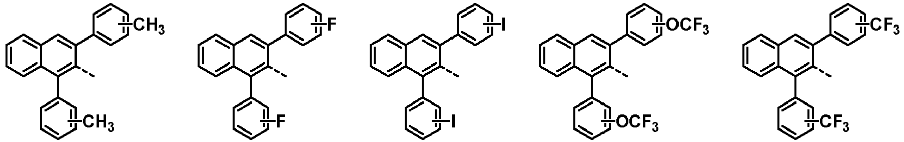

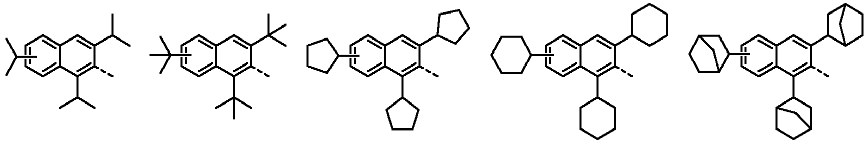

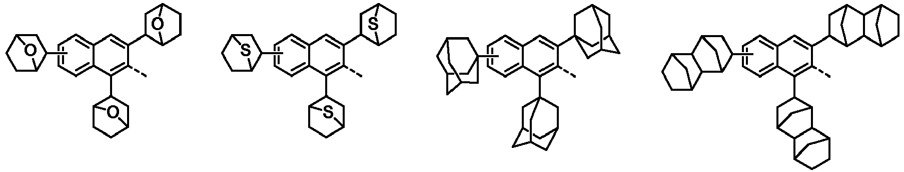

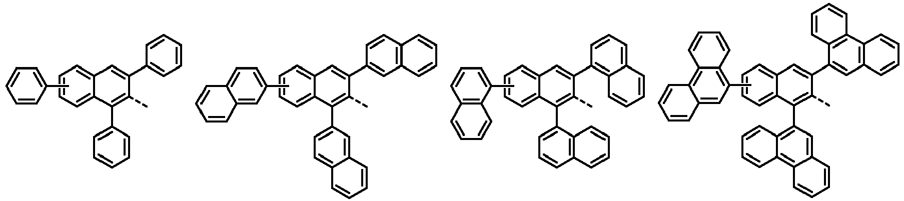

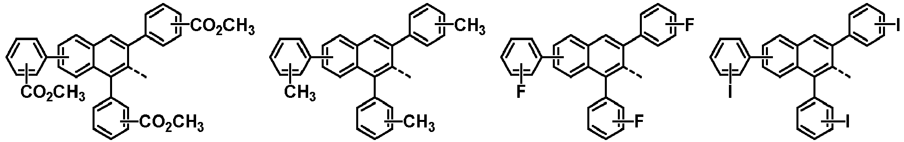

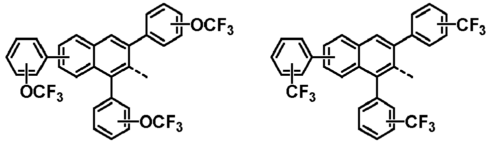

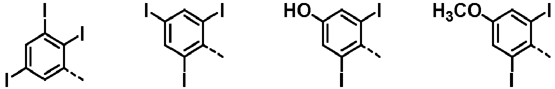

In formula (B-2), R²² is each independently a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl, and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; and C₆-C₂₀ aryl groups such as phenyl, naphthyl and anthracenyl. In the hydrocarbyl group, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the group may contain a hydroxy moiety, cyano moiety, halogen, carbonyl moiety, ether bond, ester bond, sulfonate ester bond, carbonate bond, lactone ring, sultone ring, carboxylic anhydride (-C(=O)-O-C(=O)-) or haloalkyl moiety. Suitable halogen atoms include fluorine, chlorine, bromine, and iodine, with fluorine and iodine being preferred. A plurality of R²² may be identical or different when n4 is 2 or more.

A plurality of R²² may bond together to form a ring with the carbon atoms to which they are attached when n4 is 2 or more. Preferred is a 5 to 8-membered ring.

In formula (B-2), R^{F1} is each independently fluorine, a C₁-C₆ fluorinated alkyl group, C₁-C₆ fluorinated alkoxy group, or C₁-C₆ fluorinated thioalkoxy group. R^{F1} is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. Because of fluorine included, the generated acid has a sufficiently high acid strength for deprotection reaction to take place smoothly. A plurality of R^{F1} may be identical or different when n3 is 2 or more.

In formula (B-2), L¹¹ and L¹² are each independently a single bond, ether bond, ester bond, amide bond, sulfonate ester bond, carbonate bond or carbamate bond. Inter alia, ether bond, ester bond or sulfonate ester bond is preferred, with ether bond or sulfonate ester bond being more preferred.

In formula (B-2), X^{L} is a single bond or a C₁-C₄₀ hydrocarbylene group which may contain a heteroatom. The hydrocarbylene group may be straight, branched or cyclic and examples thereof include alkanediyl and cyclic saturated hydrocarbylene groups. Suitable heteroatoms include oxygen, nitrogen and sulfur atoms.

Examples of the optionally heteroatom-containing C₁-C₄₀ hydrocarbylene group X^{L} are shown below, but not limited thereto. Herein, * designates a point of attachment to L¹¹ or L¹².

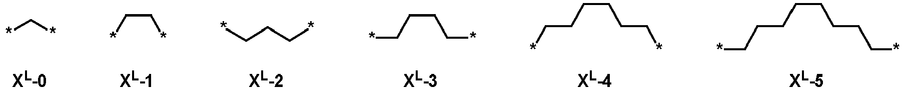

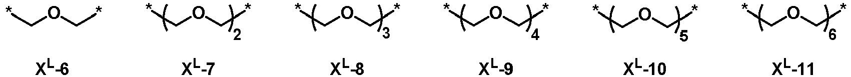

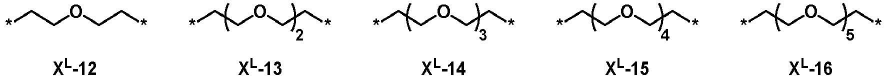

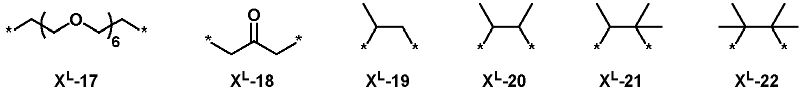

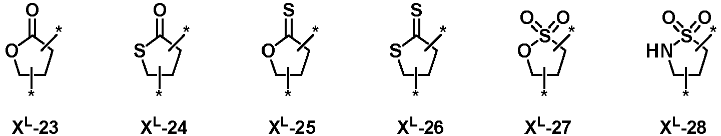

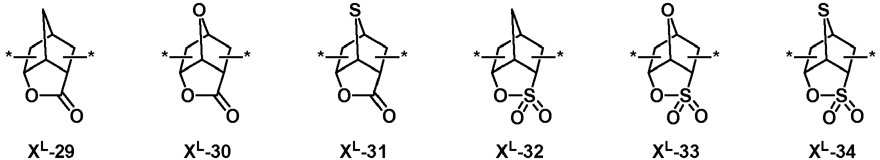

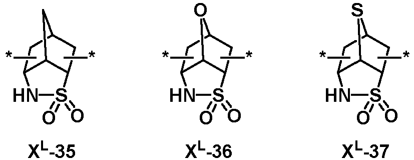

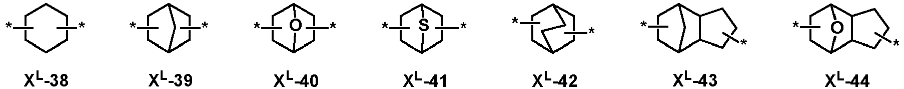

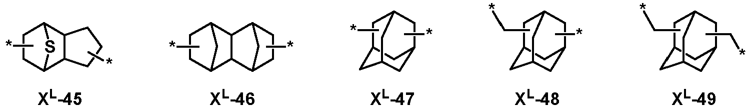

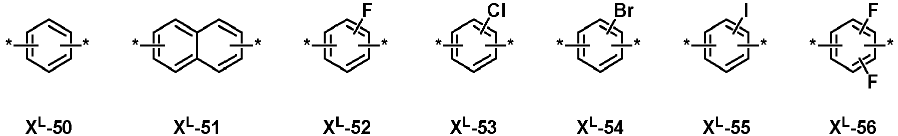

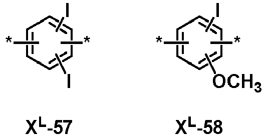

Of these, X^{L}-0 to X^{L}-22 and X^{L}-47 to X^{L}-58 are preferred.

Of the acid generators having formula (B-2), compounds having the formula (B-2-1) are preferred. 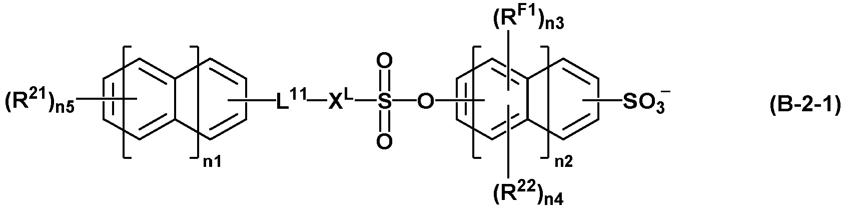 Herein n1 to n5, R²¹, R²², R^{F1}, L¹¹, and X^{L} are as defined above.

Examples of the anion having formula (B-2) are shown below, but not limited thereto.

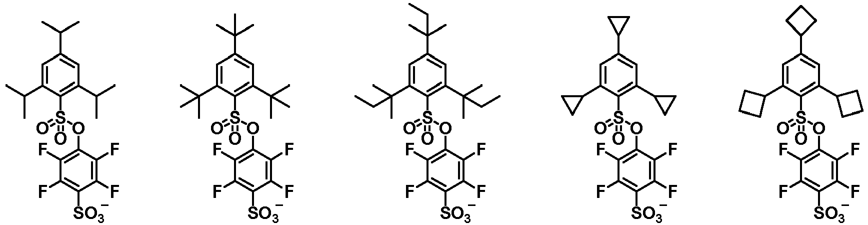

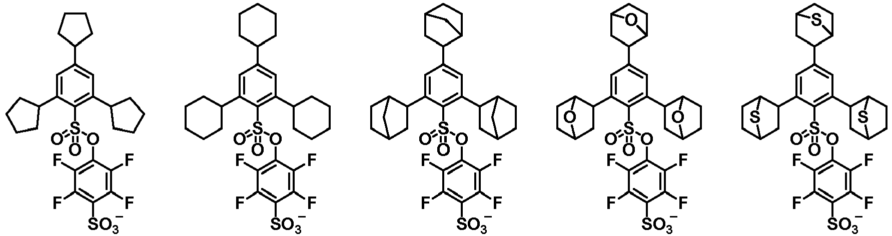

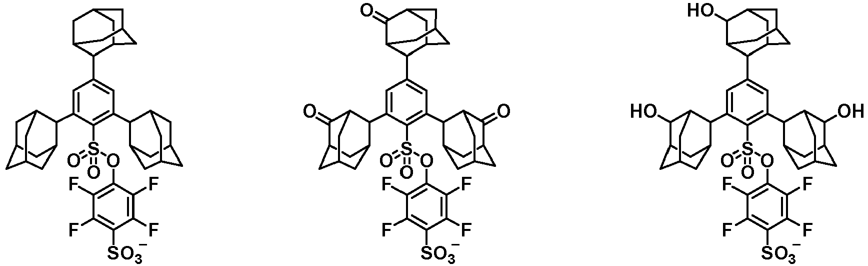

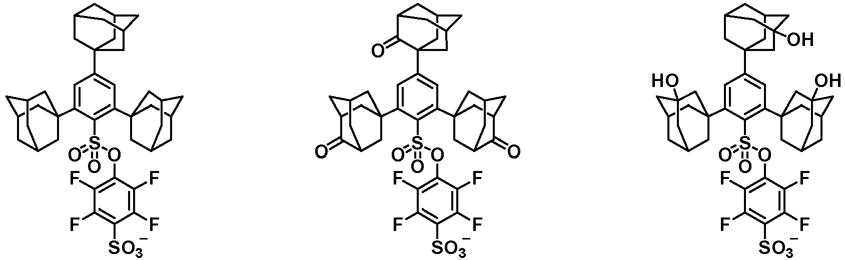

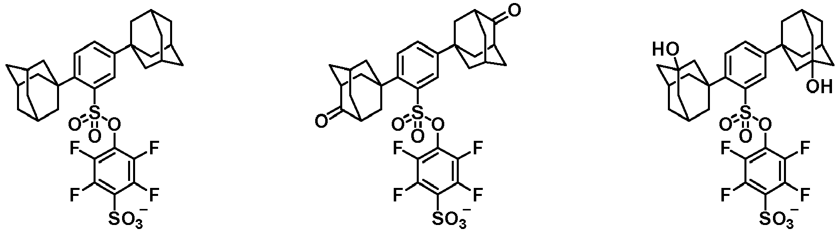

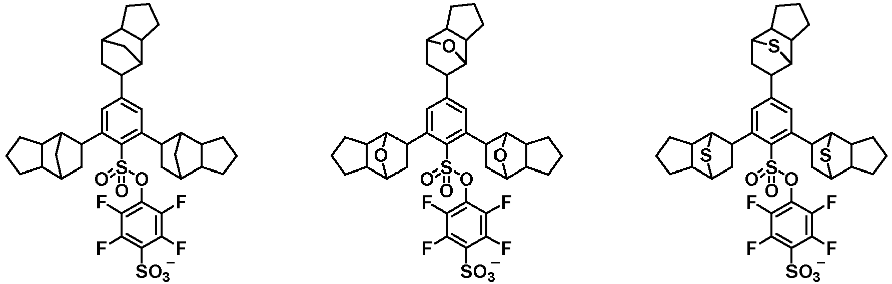

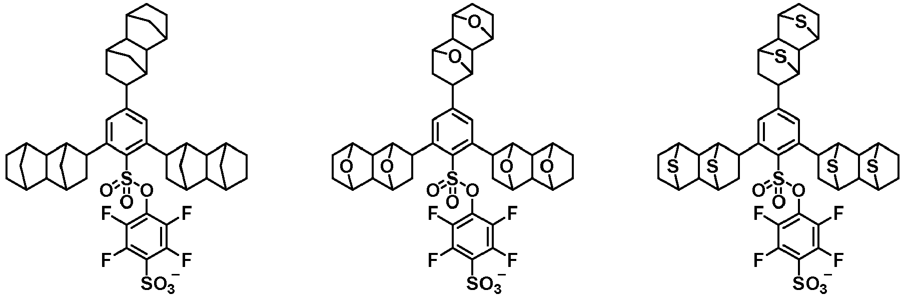

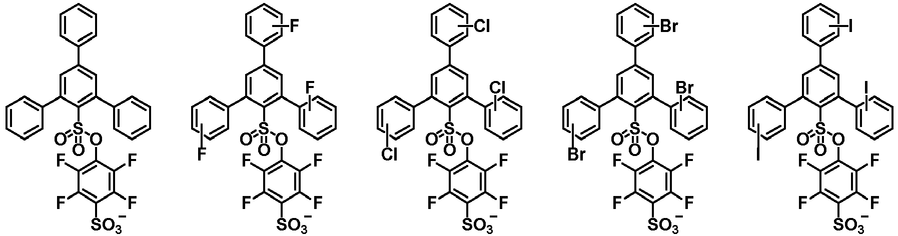

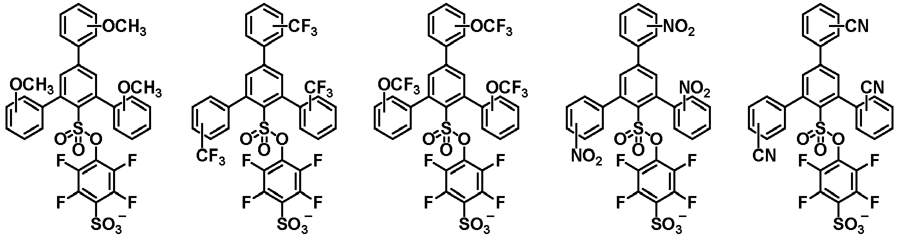

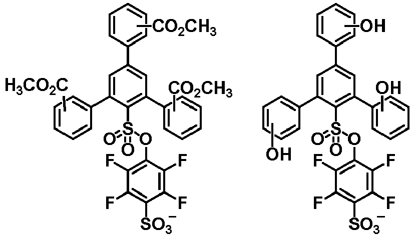

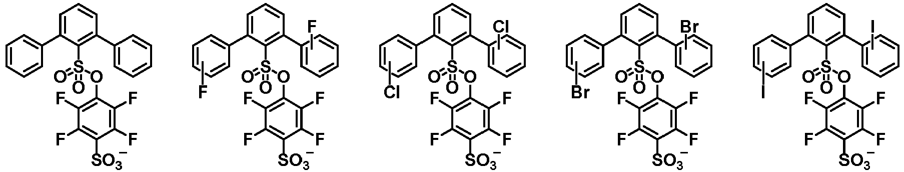

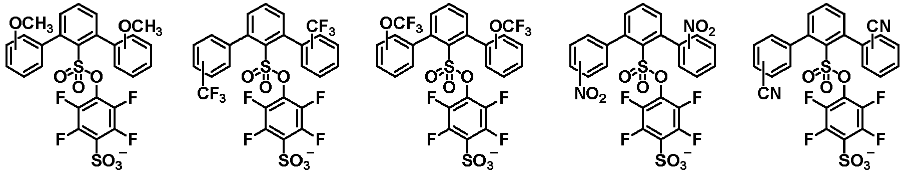

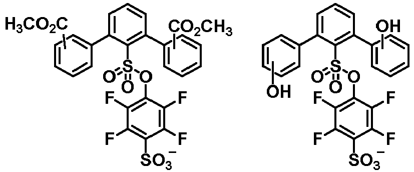

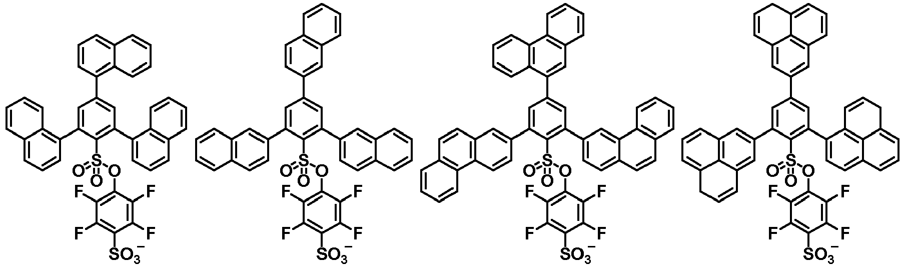

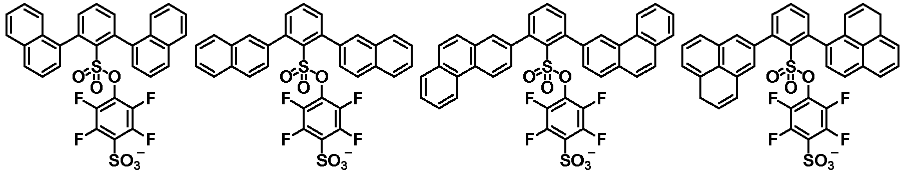

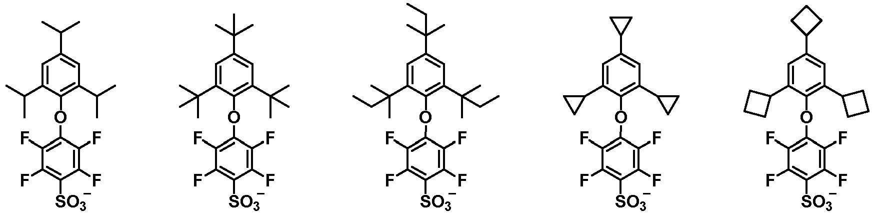

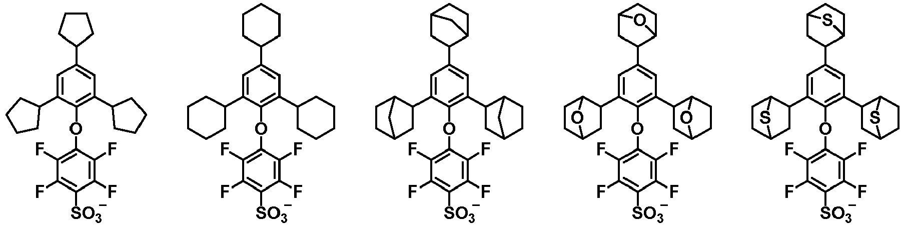

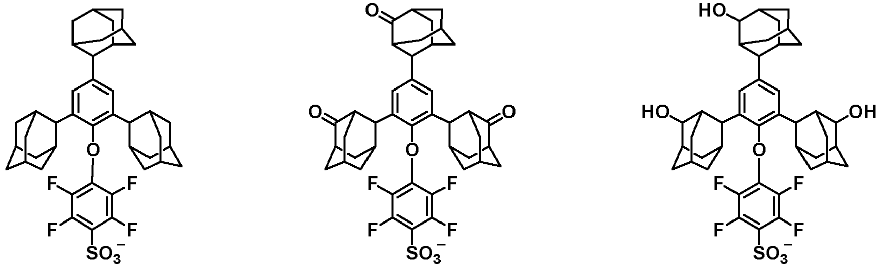

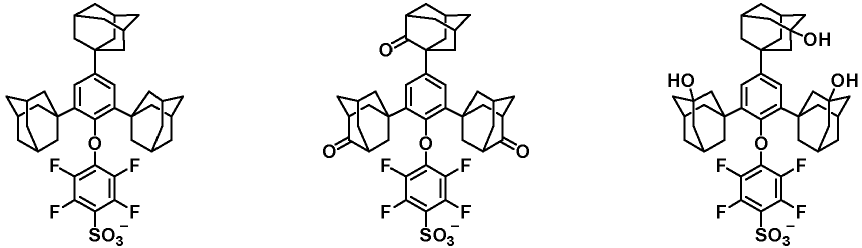

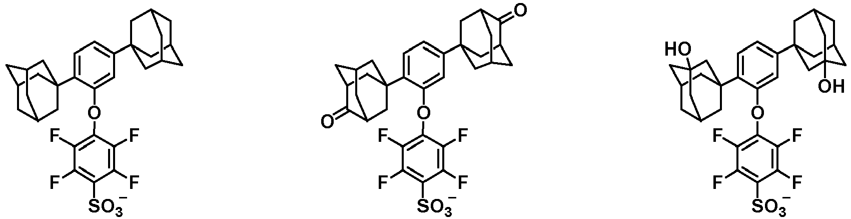

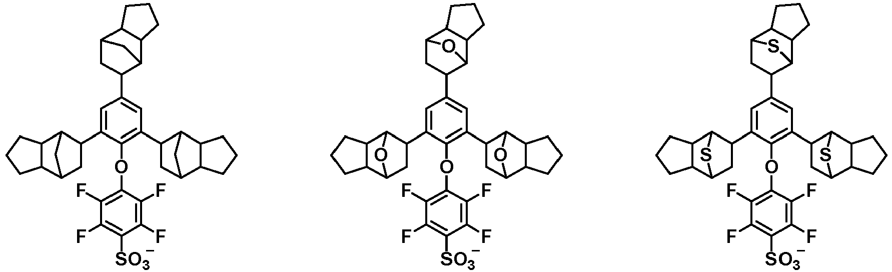

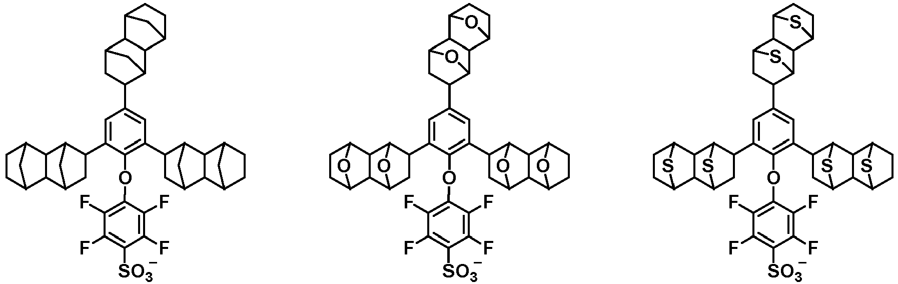

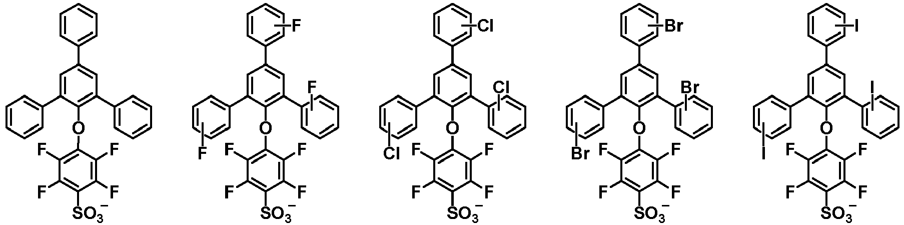

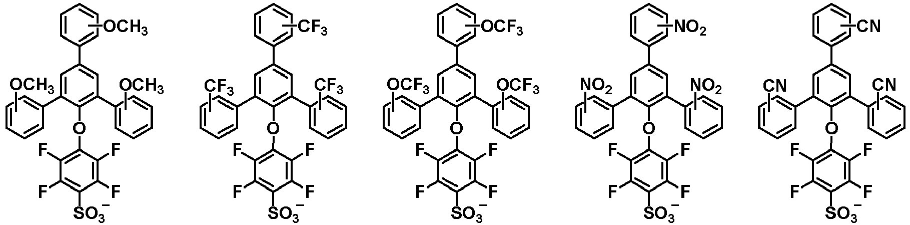

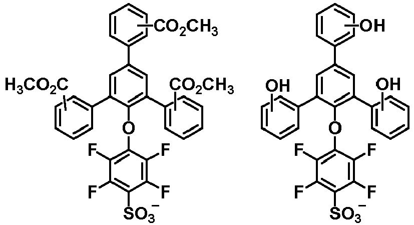

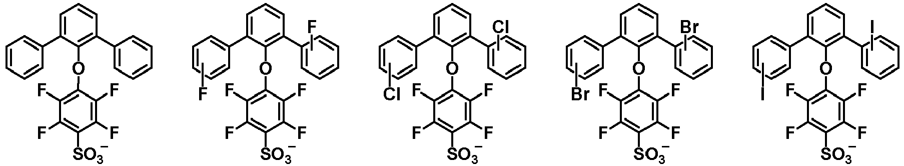

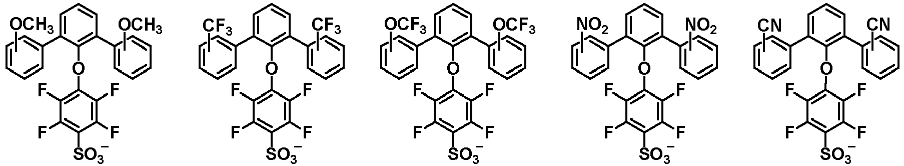

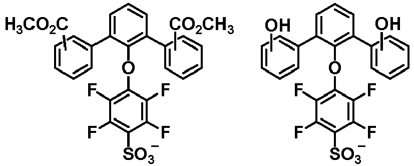

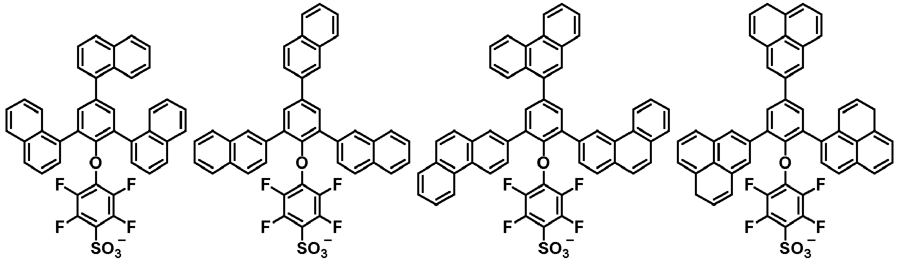

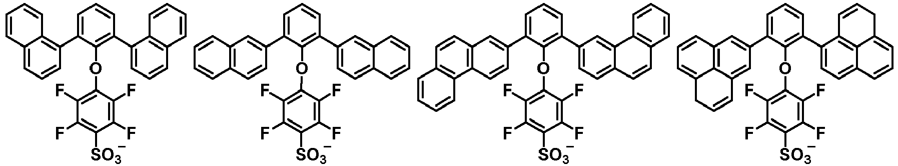

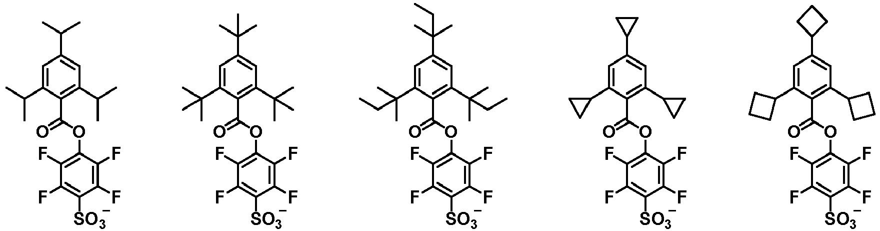

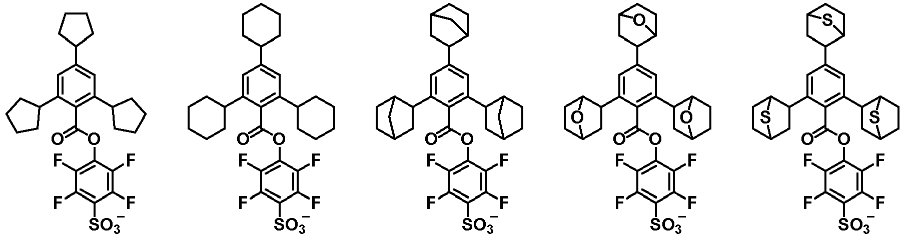

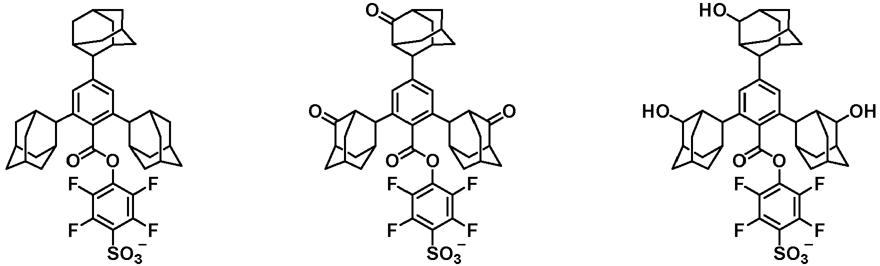

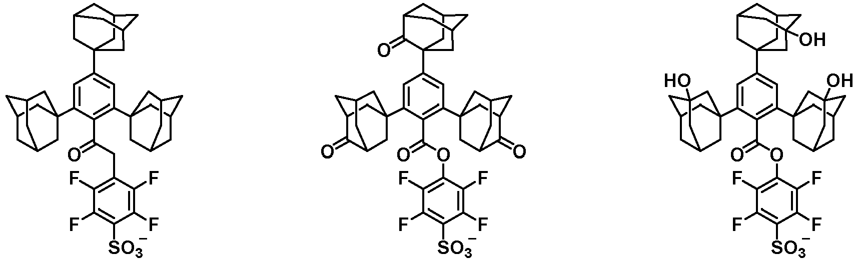

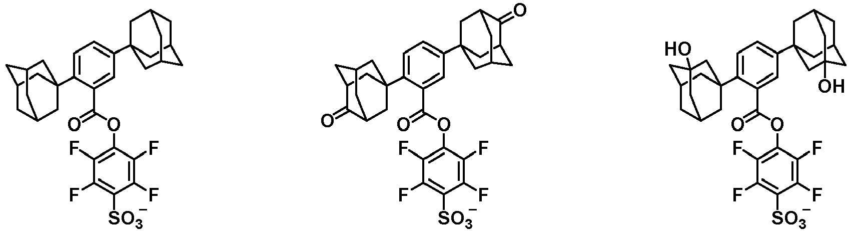

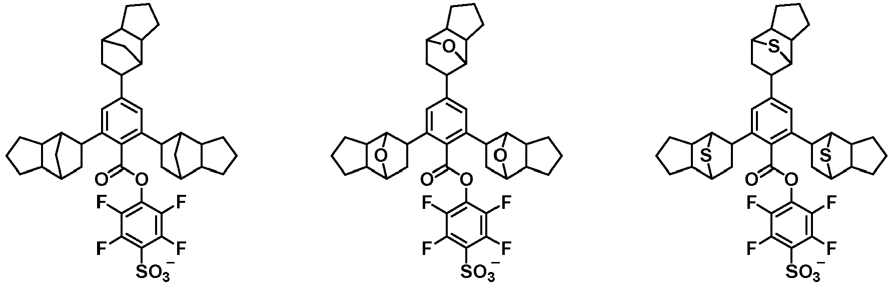

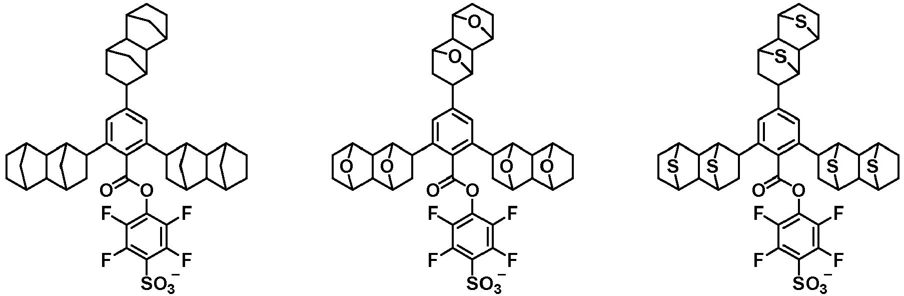

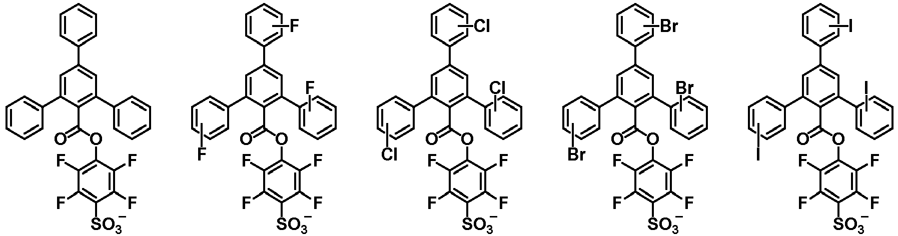

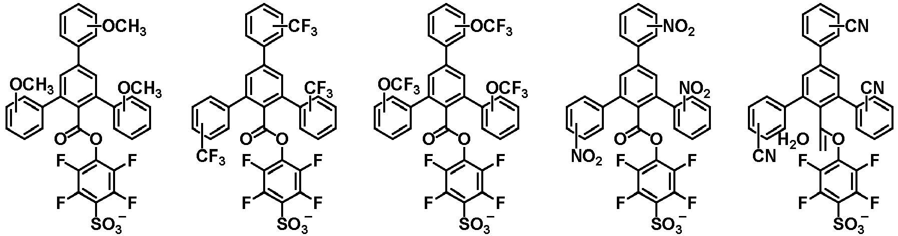

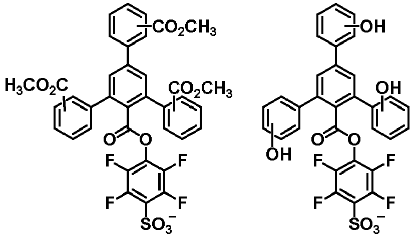

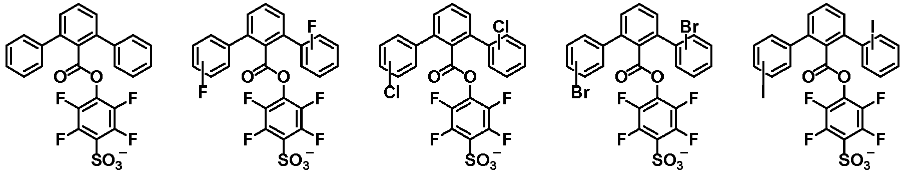

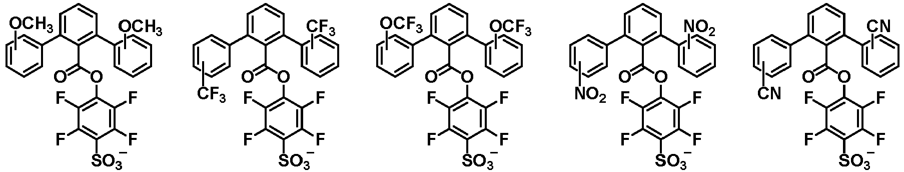

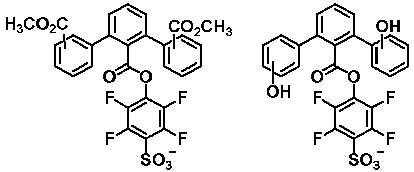

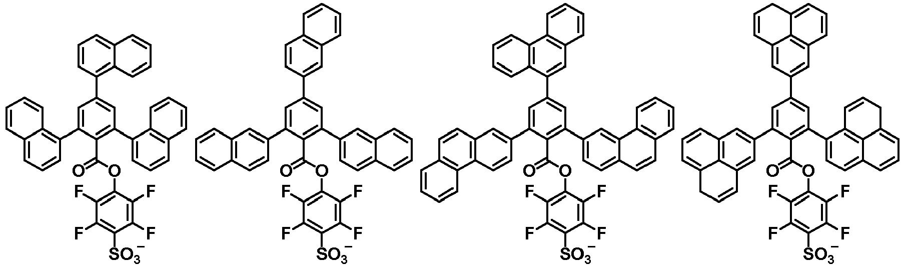

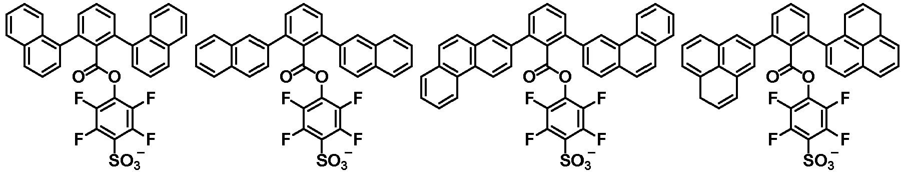

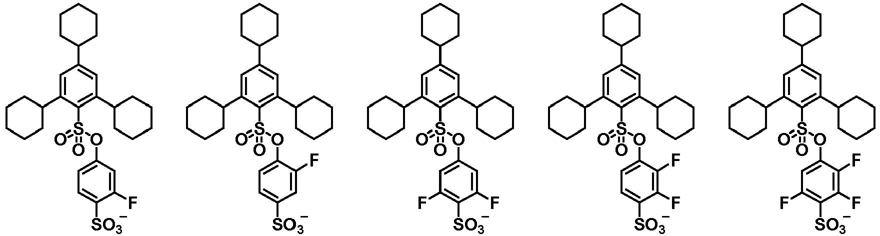

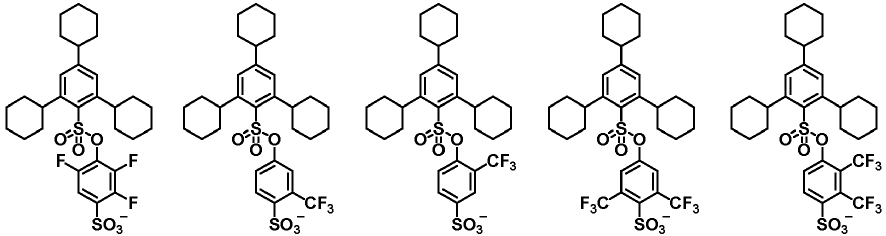

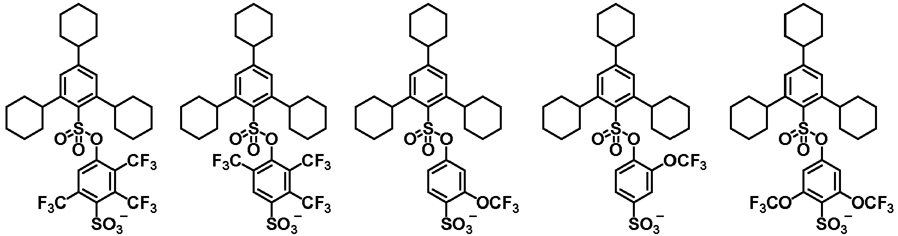

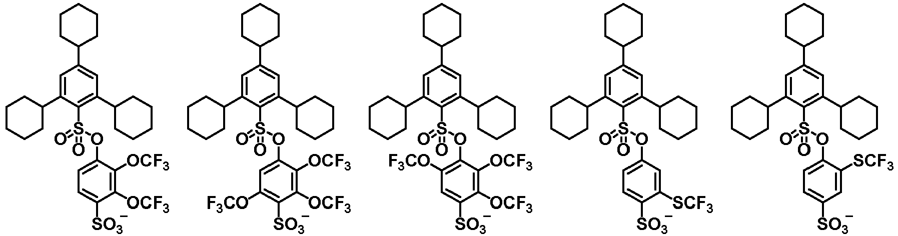

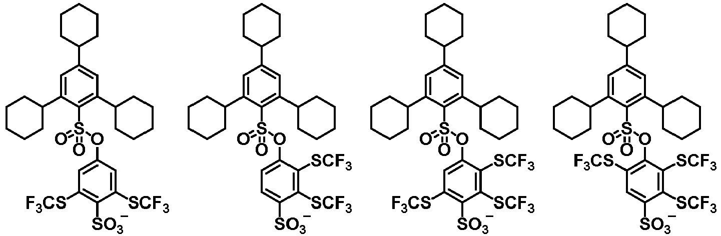

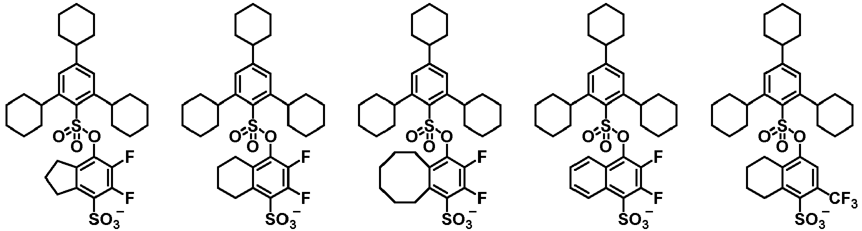

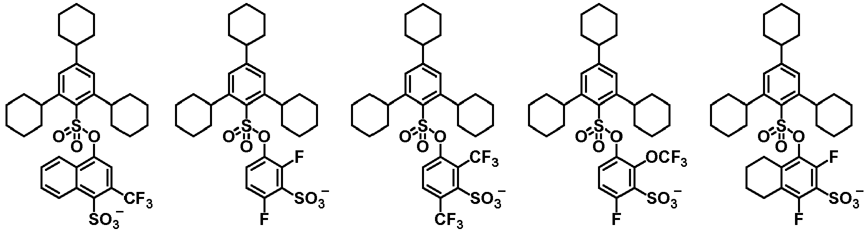

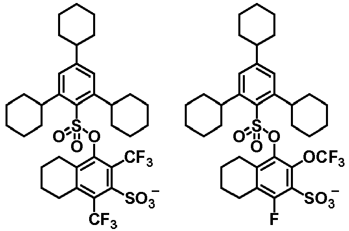

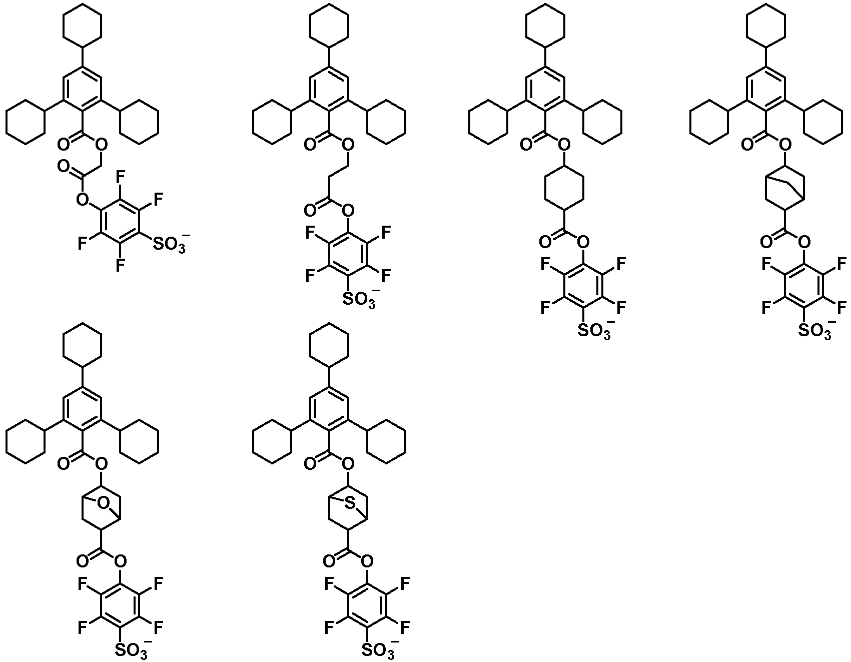

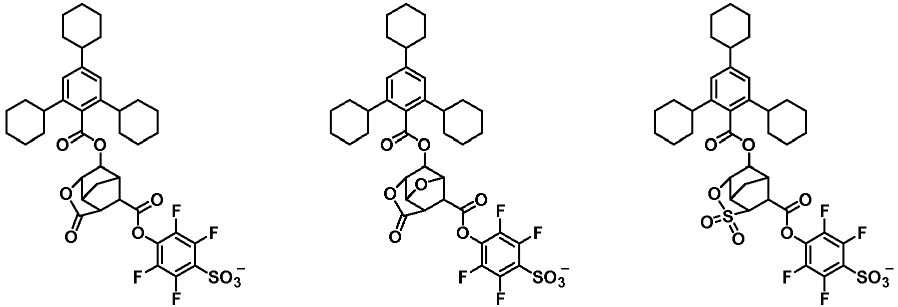

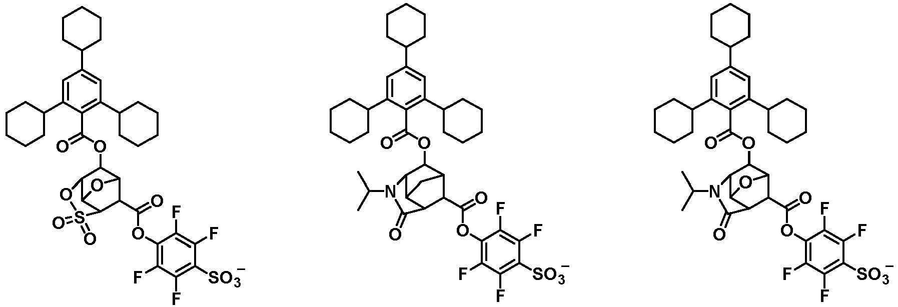

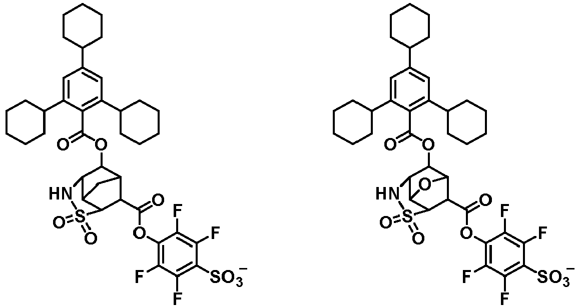

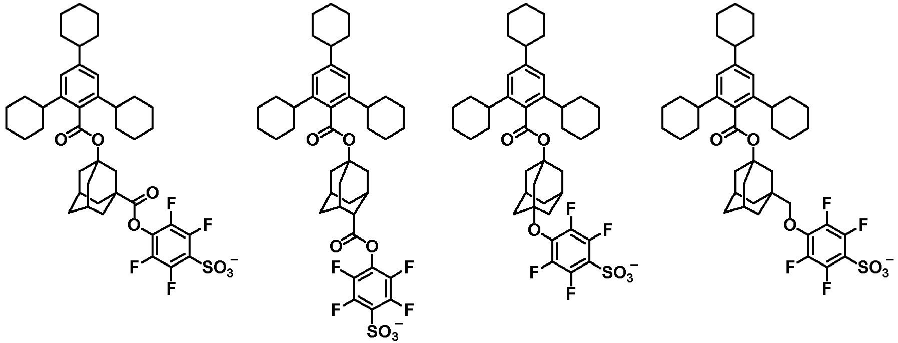

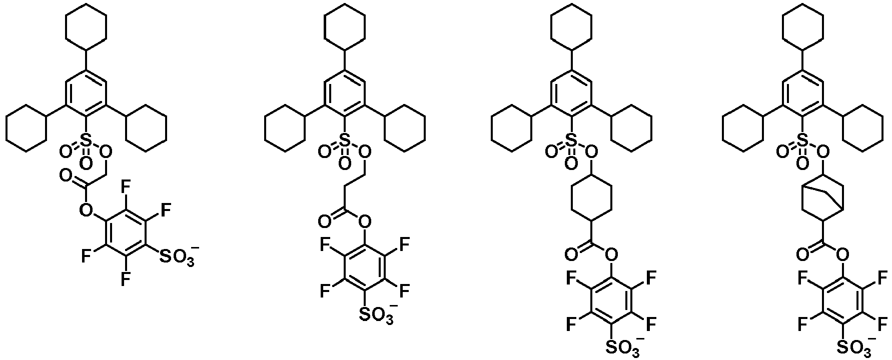

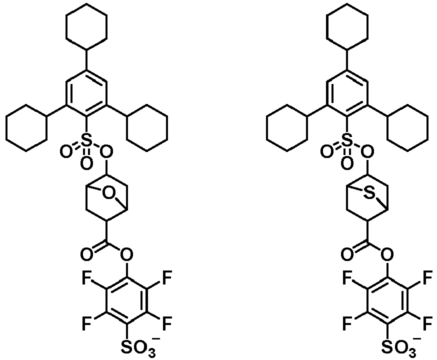

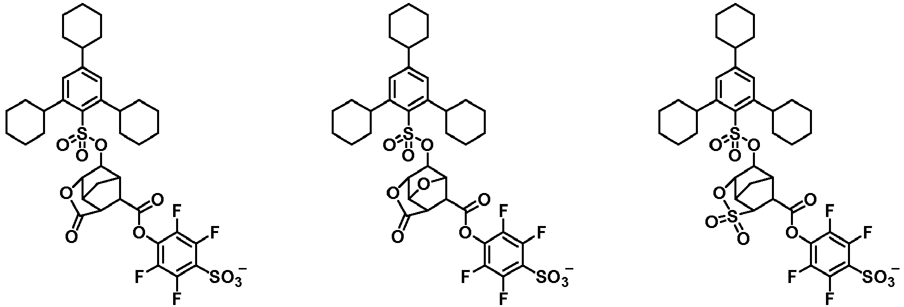

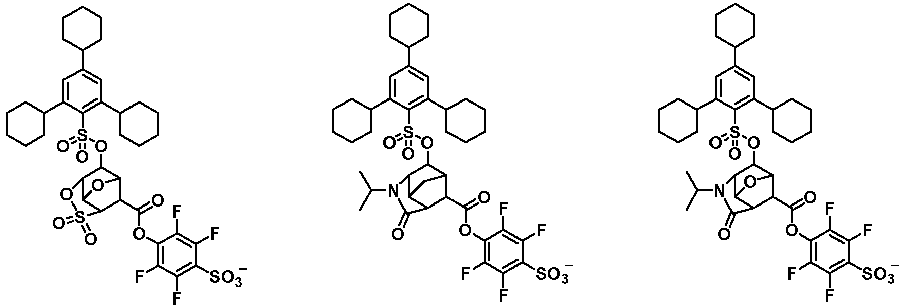

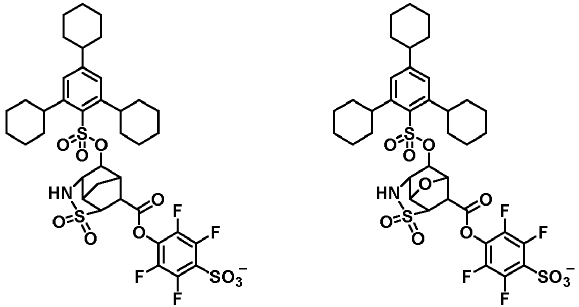

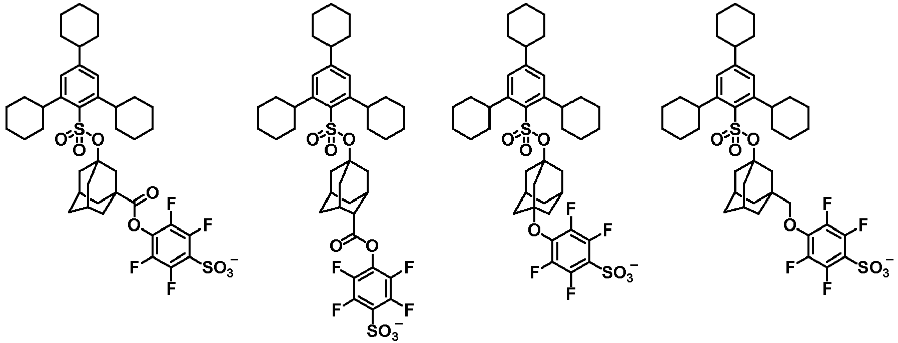

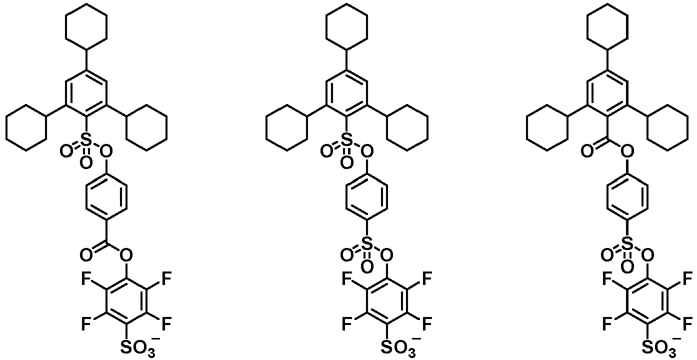

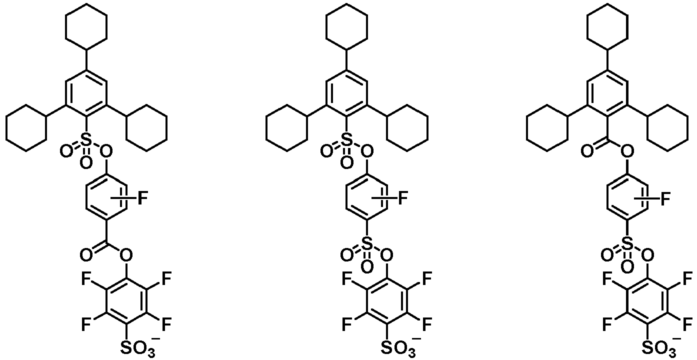

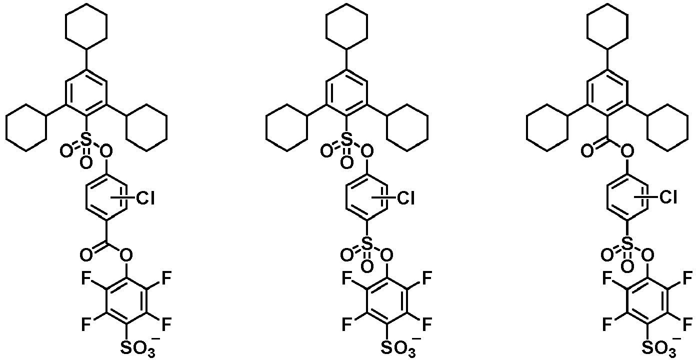

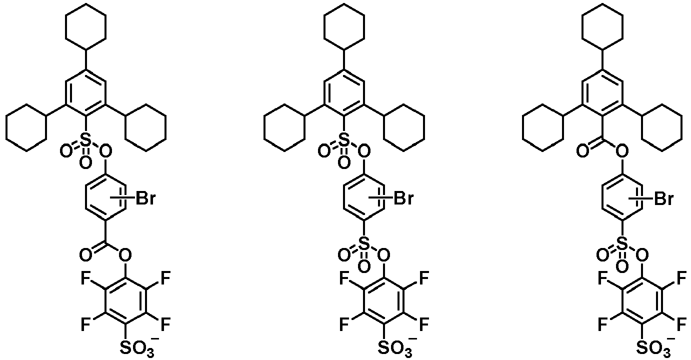

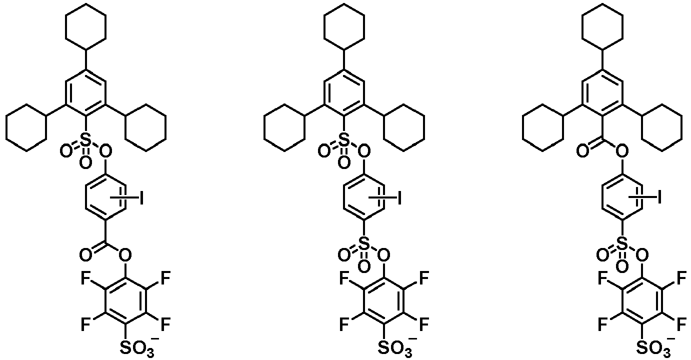

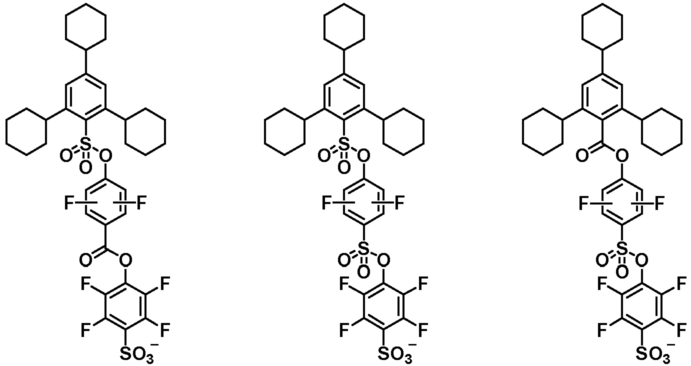

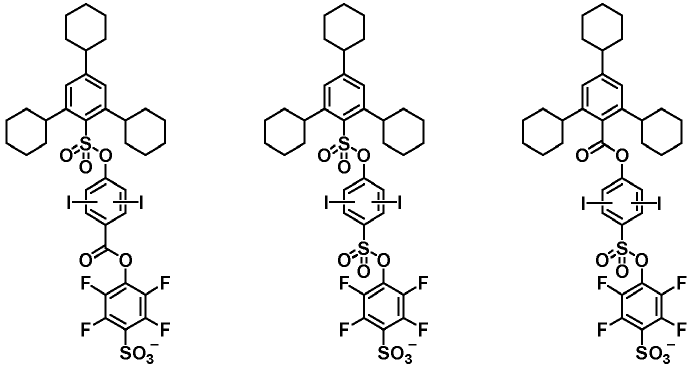

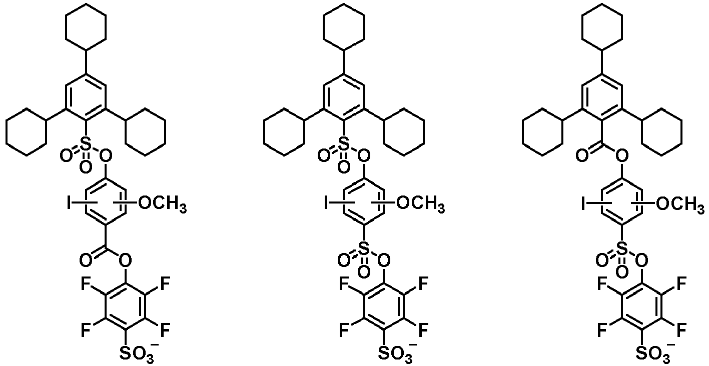

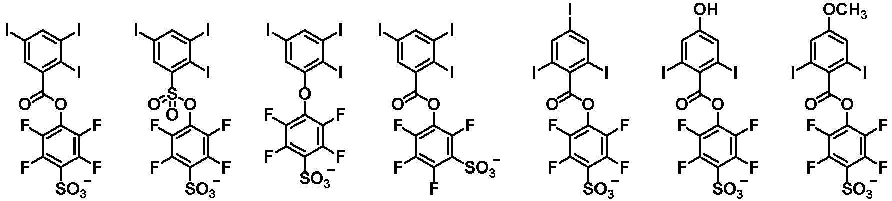

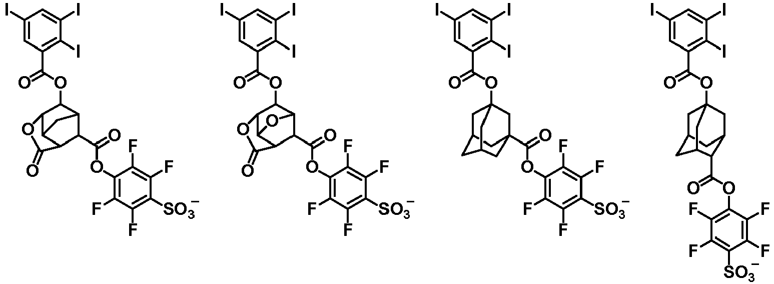

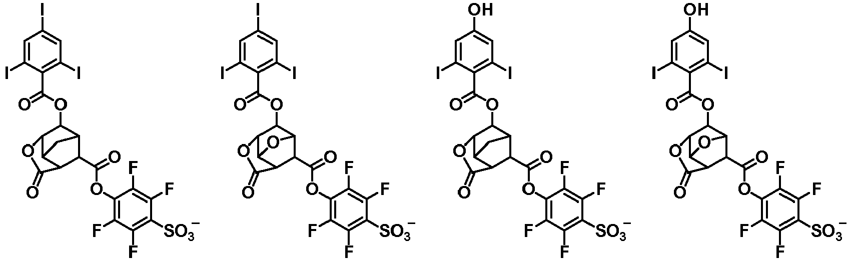

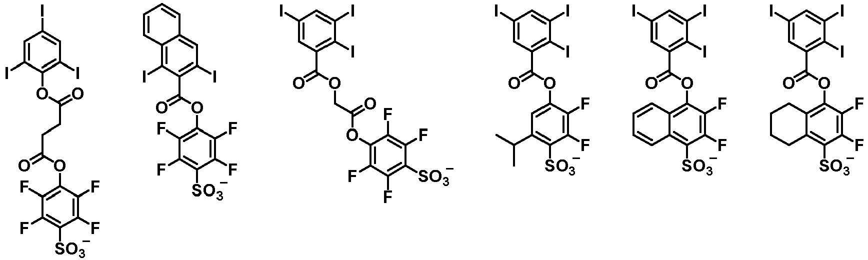

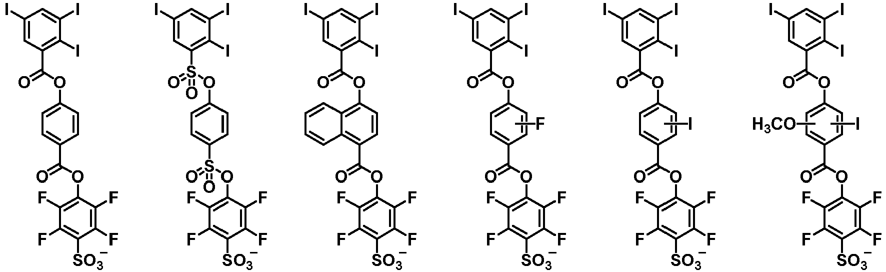

An onium salt compound containing an anion having the formula (B-3) is also preferred as the PAG (B).

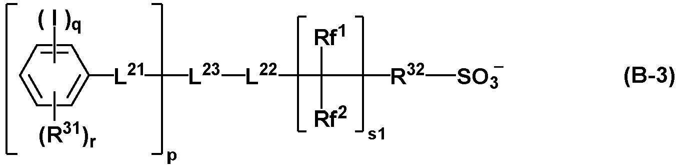

In formula (B-3), p is 1, 2 or 3, q is an integer of 1 to 5, r is an integer of 0 to 3, and s1 is 0 or 1.

In formula (B-3), L²¹ is a single bond, ether bond, ester bond, sulfonate ester bond, carbonate bond or carbamate bond.

In formula (B-3), L²² is an ether bond, ester bond, sulfonate ester bond, carbonate bond or carbamate bond.

In formula (B-3), L²³ is a single bond or C₁-C₂₀ hydrocarbylene group when p=1, and a C₁-C₂₀ (p+1)-valent hydrocarbon group when p=2 or 3. The hydrocarbylene group and (p+1)-valent hydrocarbon group may contain at least one moiety selected from an ether bond, carbonyl moiety, ester bond, amide bond, sultone ring, lactam ring, carbonate bond, halogen, hydroxy moiety, and carboxy moiety.

The C₁-C₂₀ hydrocarbylene group L²³ may be saturated or unsaturated and straight, branched or cyclic. Examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; C₃-C₂₀ cyclic saturated hydrocarbylene groups such as cyclopentanediyl, cyclohexanediyl, norbornanediyl and adamantanediyl; C₂-C₂₀ unsaturated aliphatic hydrocarbylene groups such as vinylene and propene-1,3-diyl; C₆-C₂₀ arylene groups such as phenylene and naphthylene; and combinations thereof. The C₁-C₂₀ (p+1)-valent hydrocarbon group L²³ may be saturated or unsaturated and straight, branched or cyclic. Examples thereof include those exemplified above for the C₁-C₂₀ hydrocarbylene group, with one or two hydrogen atoms being eliminated.

In formula (B-3), Rf¹ and Rf² are each independently hydrogen, fluorine or trifluoromethyl, at least one being fluorine or trifluoromethyl.

In formula (B-3), R³¹ is hydroxy, carboxy, a C₁-C₆ saturated hydrocarbyl group, C₁-C₆ saturated hydrocarbyloxy group, C₂-C₆ saturated hydrocarbylcarbonyloxy group, fluorine, chlorine, bromine, -N(R^{31A})(R^{31B})-, -N(R^{31c})-C(=O)-R^{31D} or -N(R^{31C})-C(=O)-O-R^{31D}. R^{31A} and R^{31B} are each independently hydrogen or a C₁-C₆ saturated hydrocarbyl group. R^{31C} is hydrogen or a C₁-C₆ saturated hydrocarbyl group. R^{31D} is a C₁-C₆ saturated hydrocarbyl group or C₂-C₈ unsaturated aliphatic hydrocarbyl group.

The C₁-C₆ saturated hydrocarbyl group represented by R³¹, R^{31A}, R^{31B} and R^{31C} may be straight, branched or cyclic. Examples thereof include C₁-C₆ alkyl groups such as methyl, ethyl, n-propyl, isopropyl, n-butyl, isobutyl, sec-butyl, tert-butyl, n-pentyl, and n-hexyl; and C₃-C₆ cyclic saturated hydrocarbyl groups such as cyclopropyl, cyclobutyl, cyclopentyl, and cyclohexyl. Examples of the saturated hydrocarbyl moiety in the C₁-C₆ saturated hydrocarbyloxy group represented by R³¹ are as exemplified above for the saturated hydrocarbyl group. Examples of the saturated hydrocarbyl moiety in the C₂-C₆ saturated hydrocarbylcarbonyloxy group represented by R³¹ are as exemplified above for the C₁-C₆ saturated hydrocarbyl group, but of 1 to 5 carbon atoms.

The C₂-C₈ unsaturated aliphatic hydrocarbyl group represented by R^{31D} may be straight, branched or cyclic and examples thereof include C₂-C₈ alkenyl groups such as vinyl, propenyl, butenyl, and hexenyl; C₂-C₈ alkynyl groups such as ethynyl, propynyl, and butynyl; and C₃-C₈ cyclic unsaturated aliphatic hydrocarbyl groups such as cyclohexenyl and norbornenyl.

In formula (B-3), R³² is a C₁-C₂₀ saturated hydrocarbylene group or C₆-C₂₀ arylene group. Some or all of the hydrogen atoms in the saturated hydrocarbylene group may be substituted by halogen exclusive of fluorine. Some or all of the hydrogen atoms in the arylene group may be substituted by a substituent selected from C₁-C₂₀ saturated hydrocarbyl groups, C₁-C₂₀ saturated hydrocarbyloxy groups, C₆-C₂₀ aryl groups, halogen, and hydroxy.

The C₁-C₂₀ hydrocarbylene group represented by R³² may be saturated or unsaturated and straight, branched or cyclic. Examples thereof are as exemplified above for the C₁-C₂₀ hydrocarbylene group L²³.

Examples of the C₆-C₂₀ arylene group represented by R³² include phenylene, naphthylene, phenanthrenediyl, and anthracenediyl. The C₁-C₂₀ saturated hydrocarbyl moiety and hydrocarbyl moiety in the C₁-C₂₀ hydrocarbyloxy moiety, which are substituents on the arylene group, may be straight, branched or cyclic and examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; and C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl. Examples of the C₆-C₁₄ arylene moiety which is a substituent on the arylene group include phenylene, naphthylene, phenanthrenediyl and anthracenediyl.

Of the anions having formula (B-3), anions having the formula (B-3-1) are preferred.

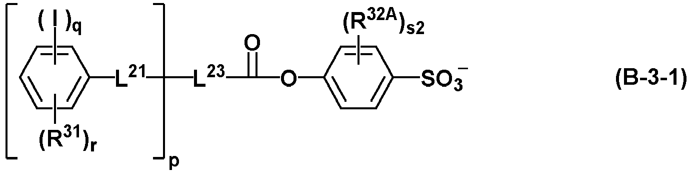

In formula (B-3-1), p, q, r, L²¹, L²³, and R³¹ are as defined above. The subscript s2 is an integer of 1 to 4. R^{32A} is a C₁-C₂₀ saturated hydrocarbyl group, C₁-C₂₀ saturated hydrocarbyloxy group, C₆-C₁₄ aryl group, halogen or hydroxy group. When s2 is 2, 3 or 4, a plurality of R^{32A} may be identical or different.

Examples of the anion having formula (B-3) are shown below, but not limited thereto.

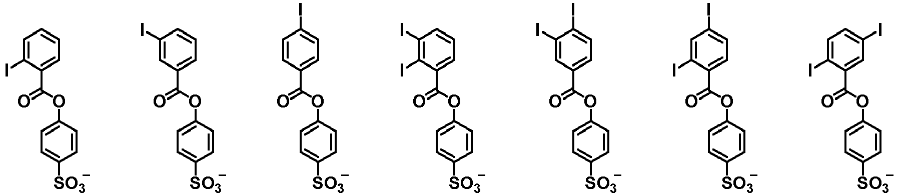

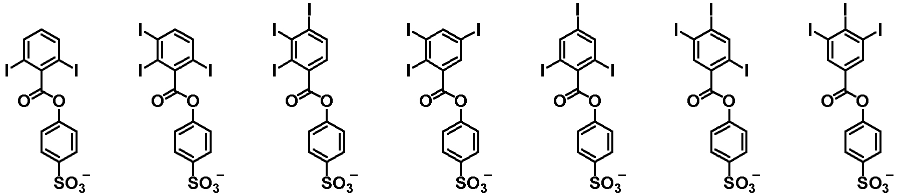

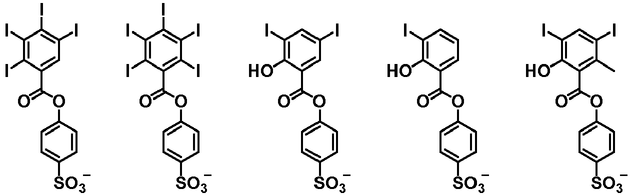

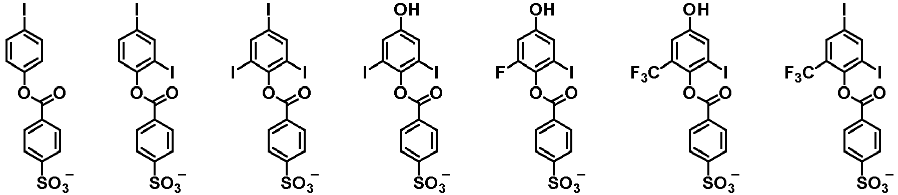

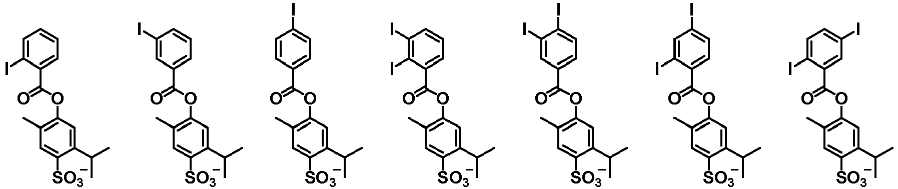

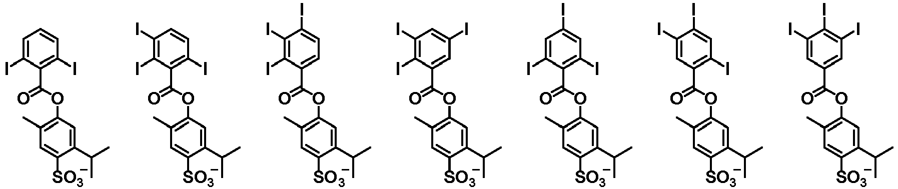

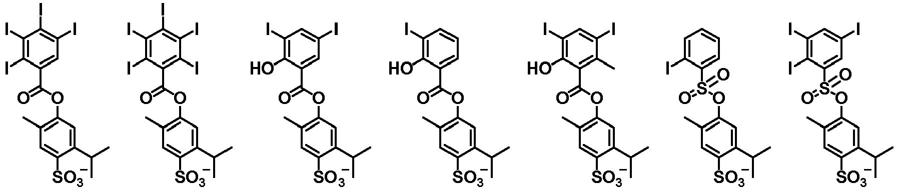

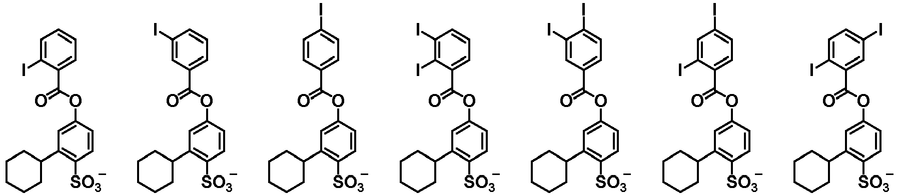

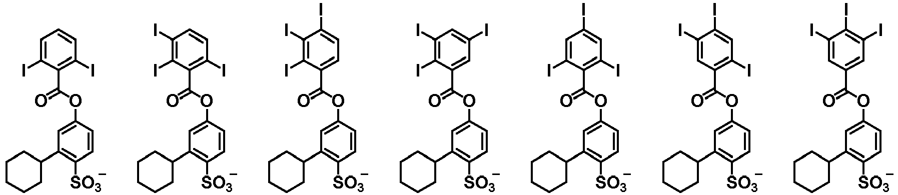

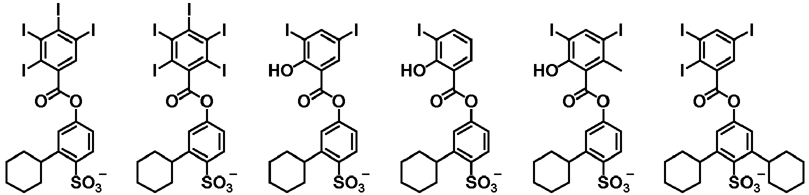

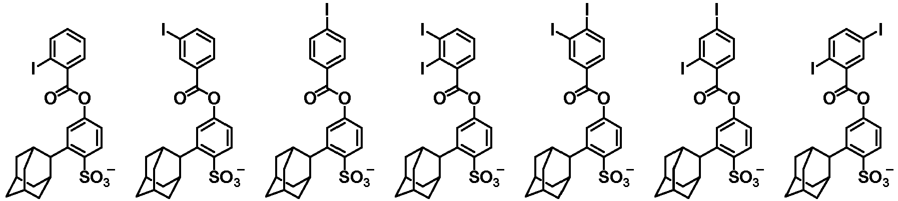

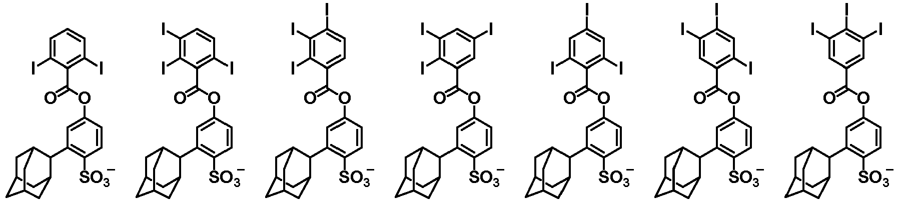

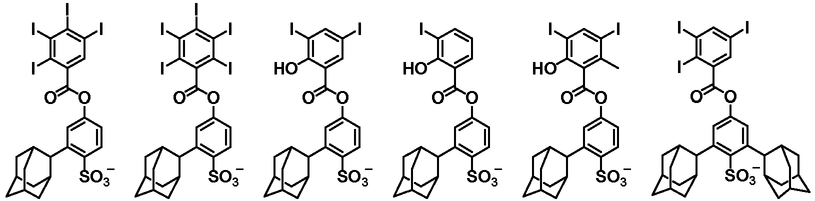

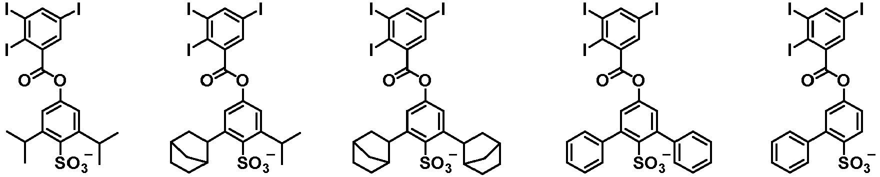

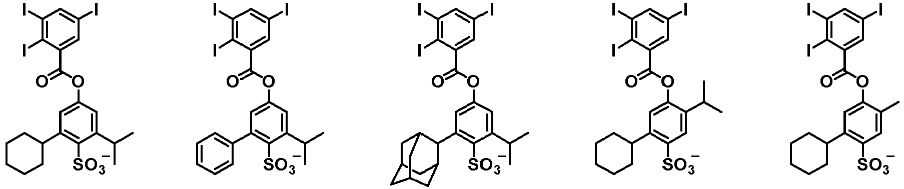

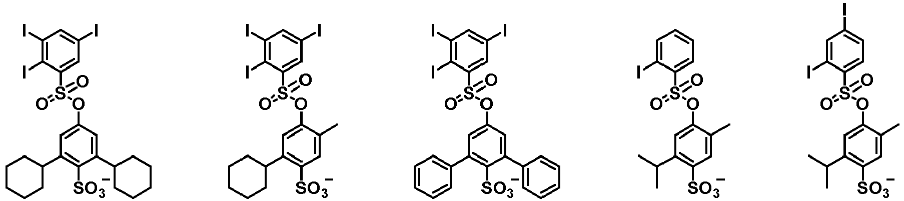

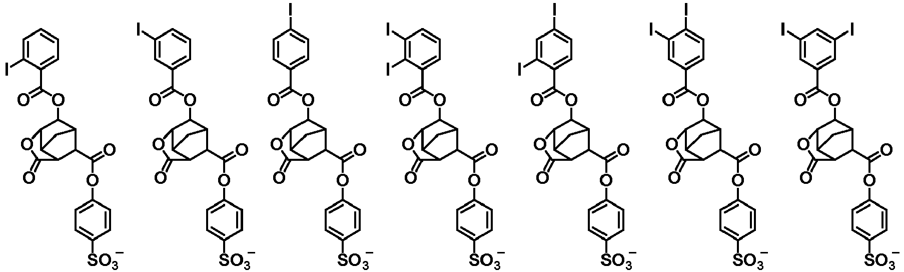

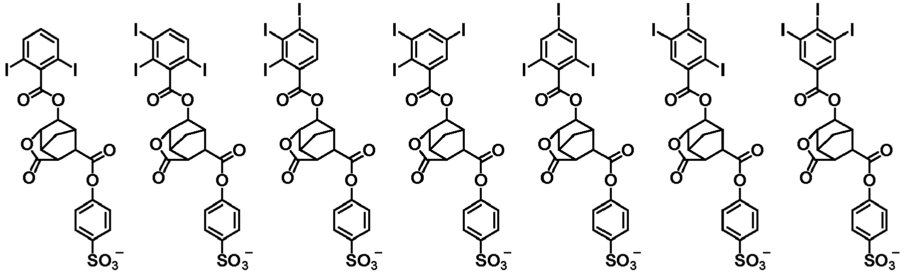

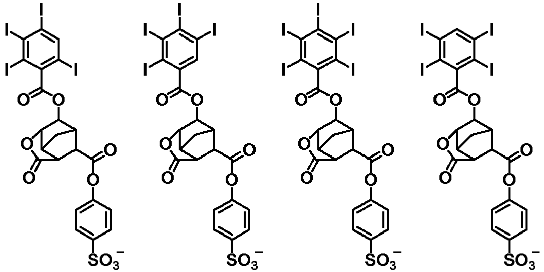

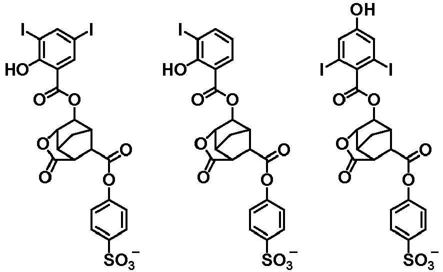

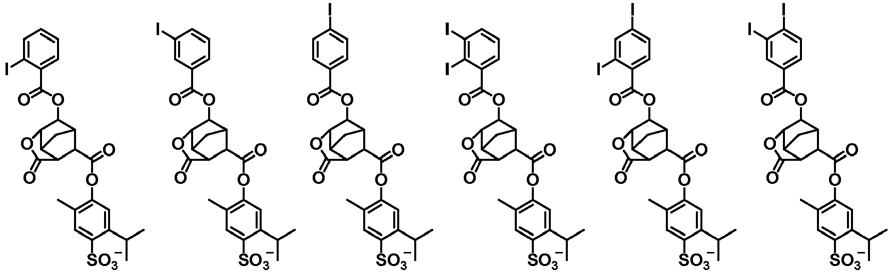

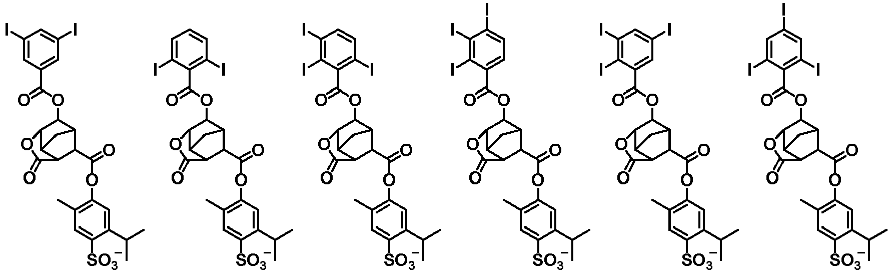

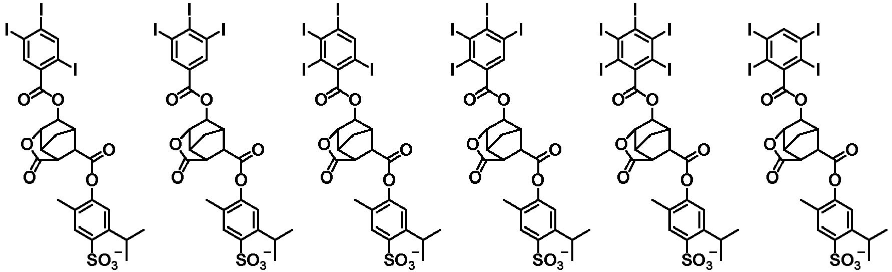

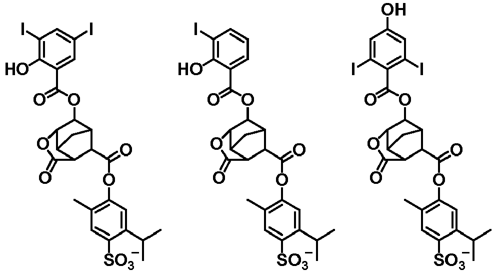

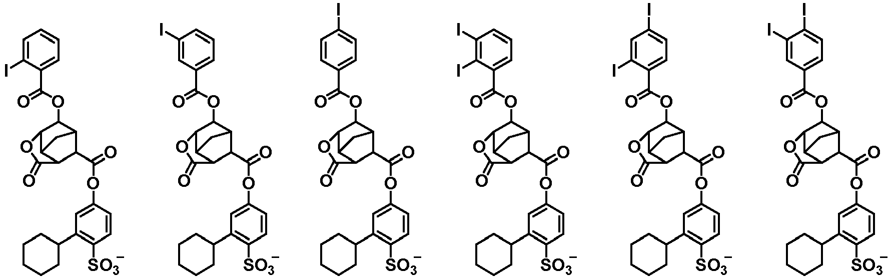

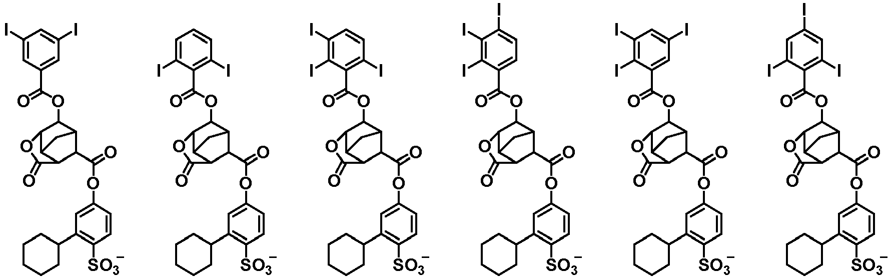

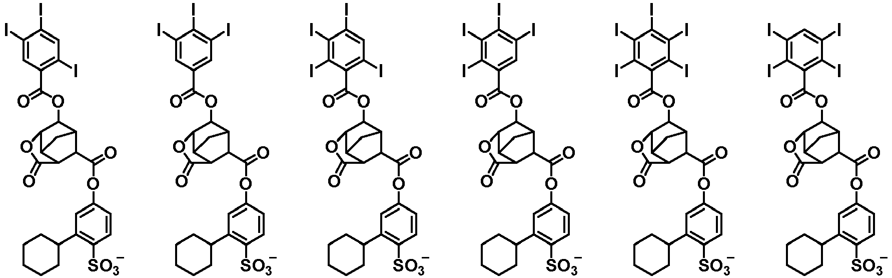

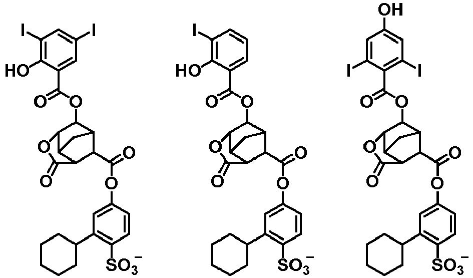

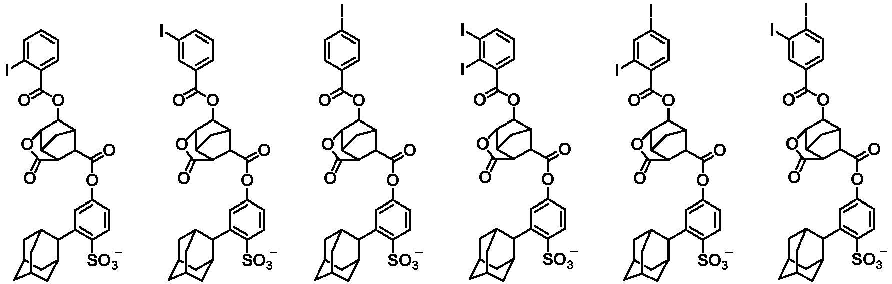

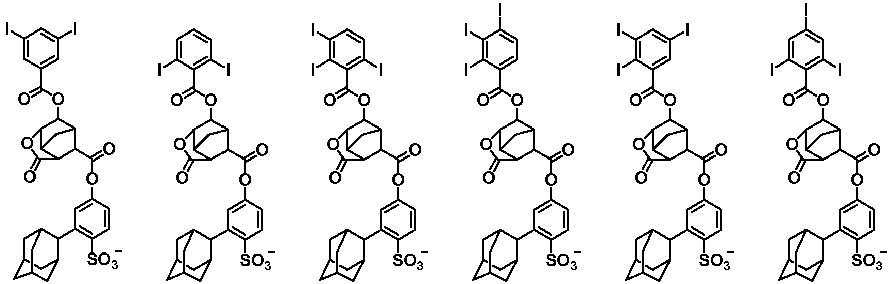

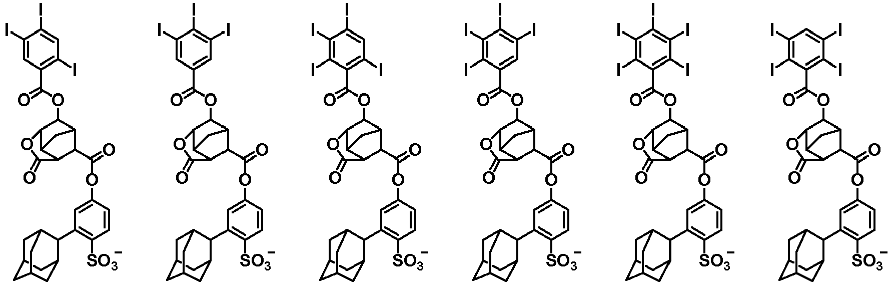

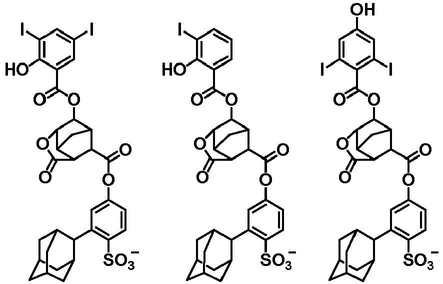

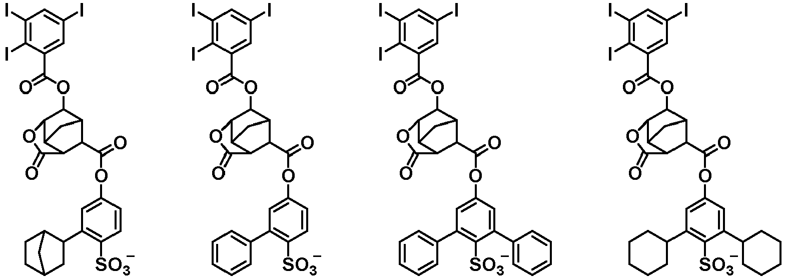

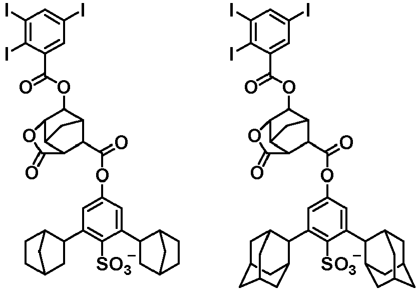

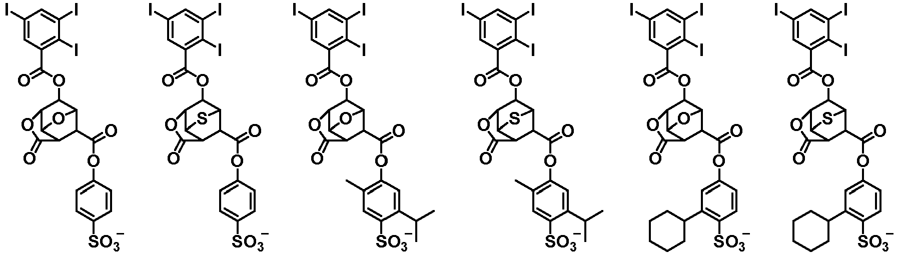

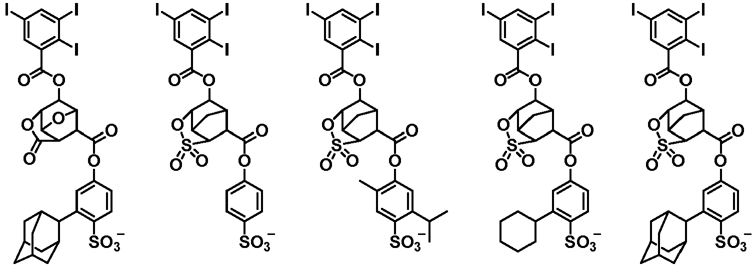

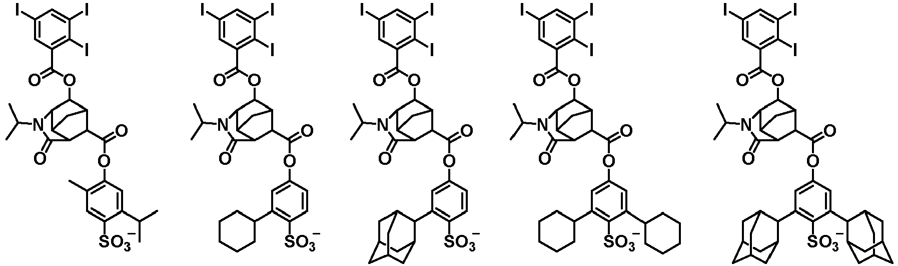

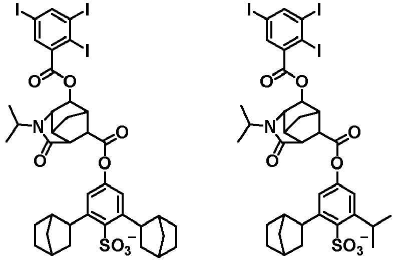

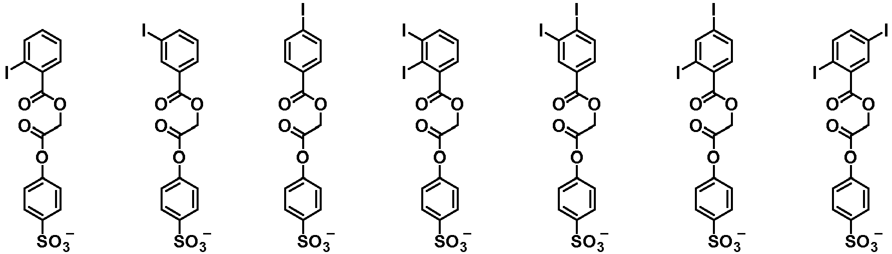

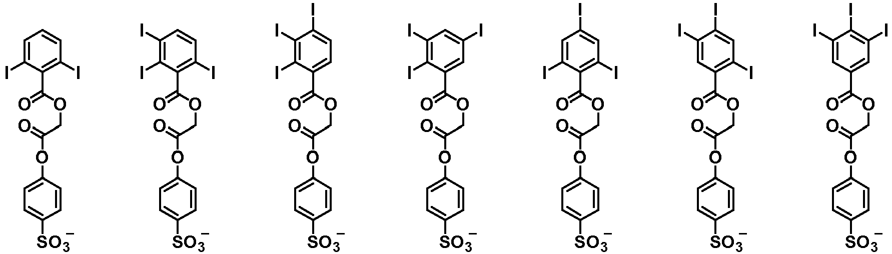

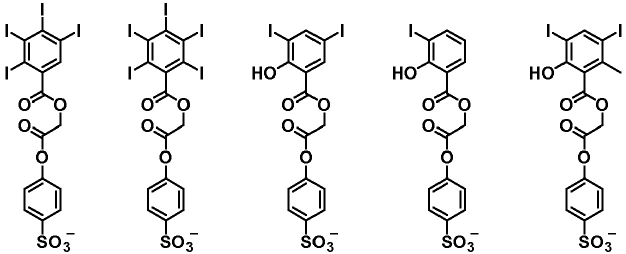

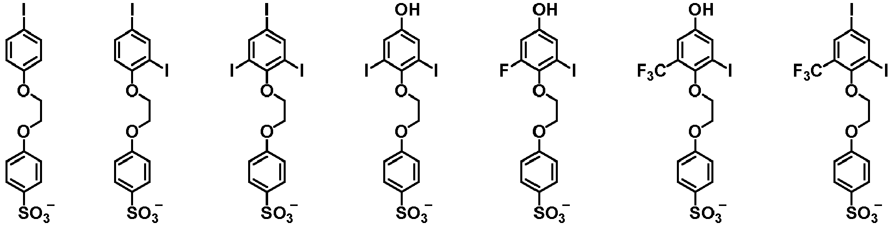

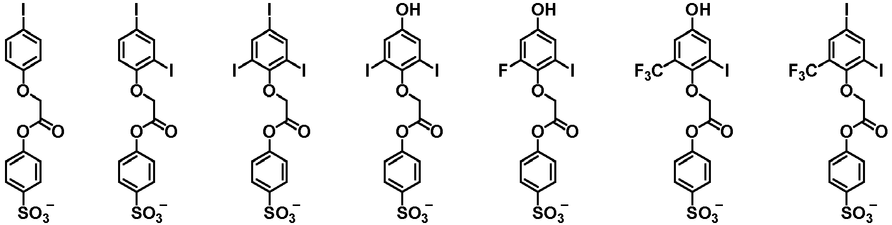

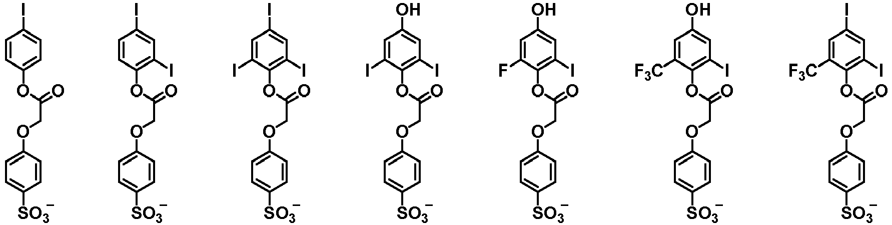

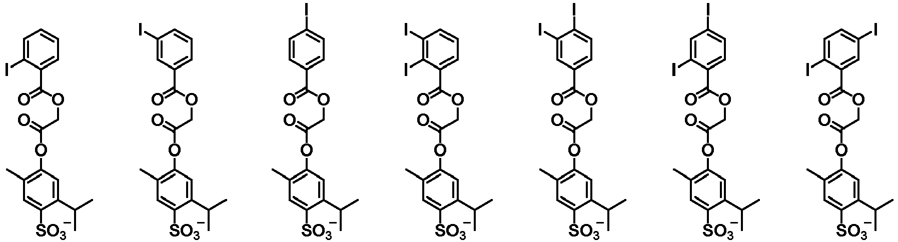

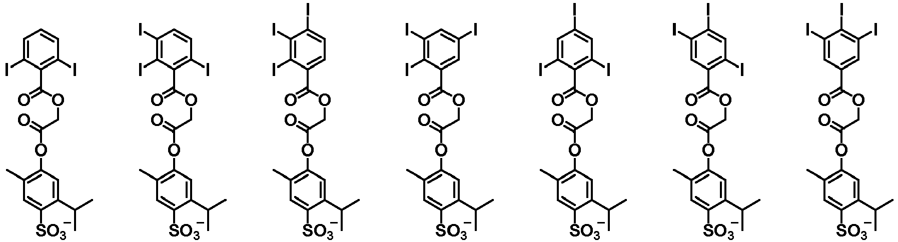

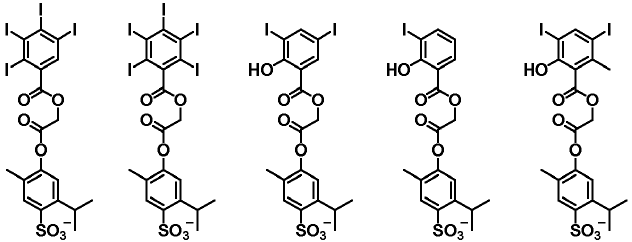

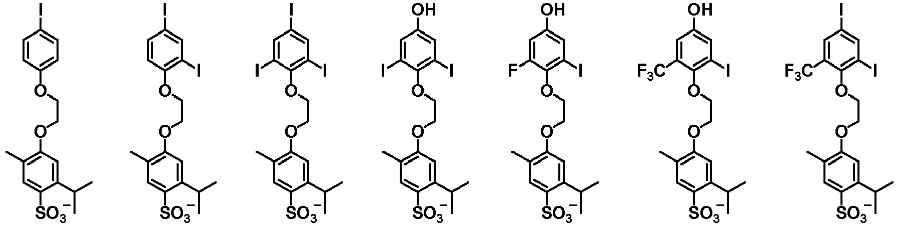

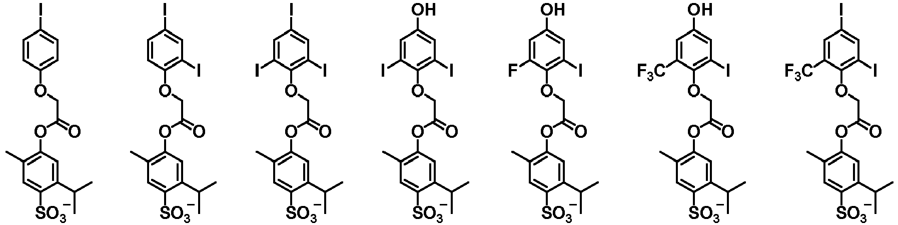

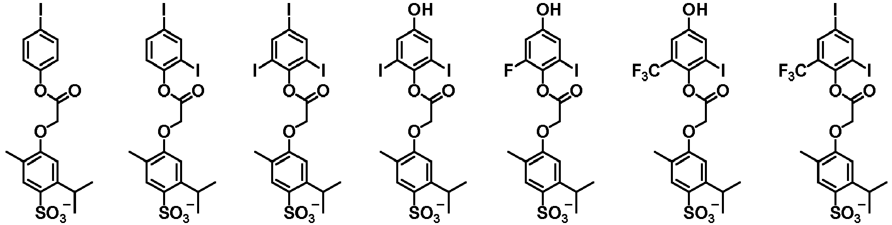

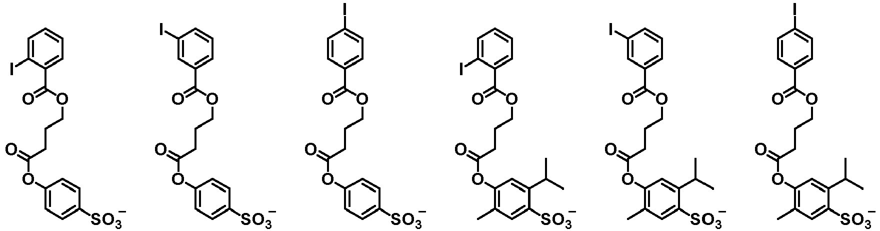

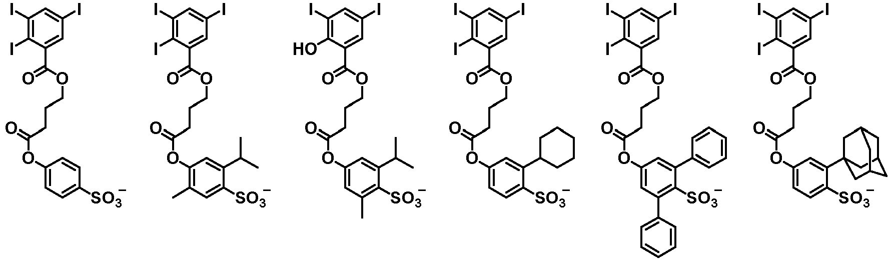

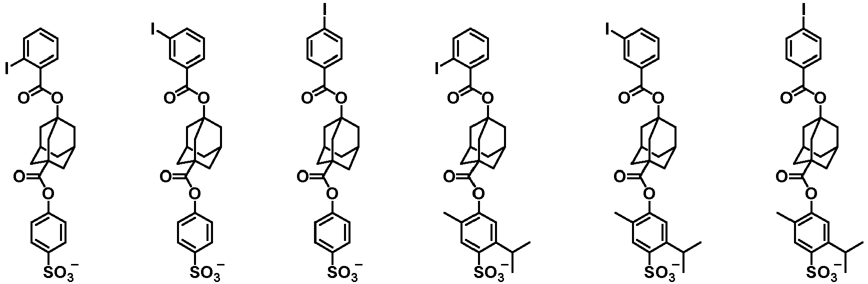

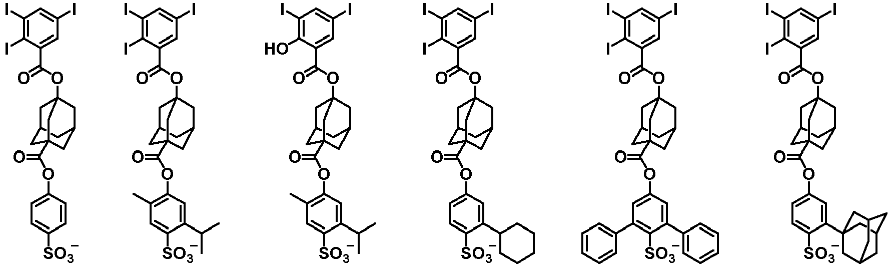

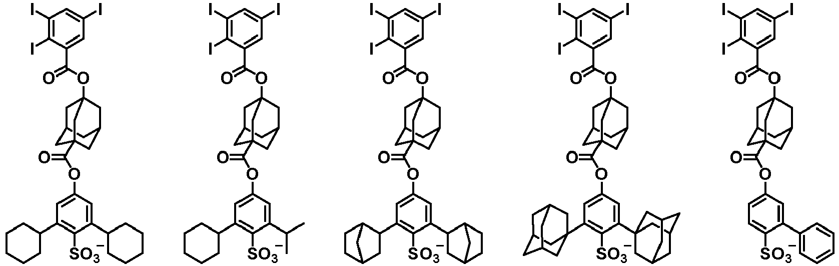

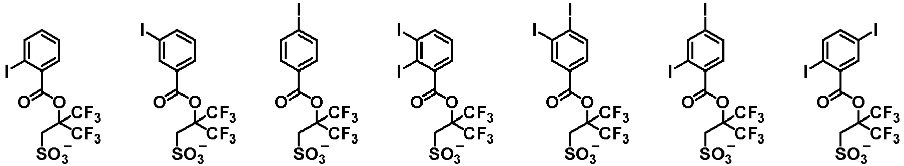

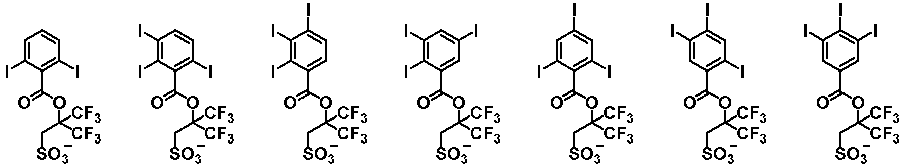

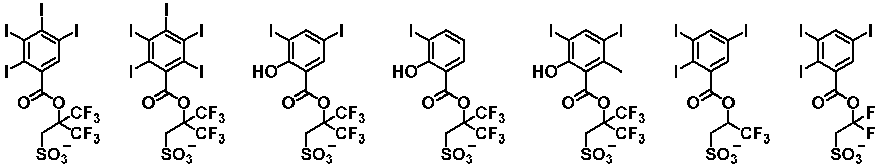

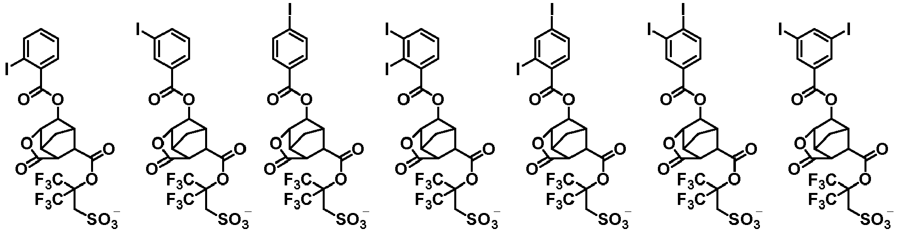

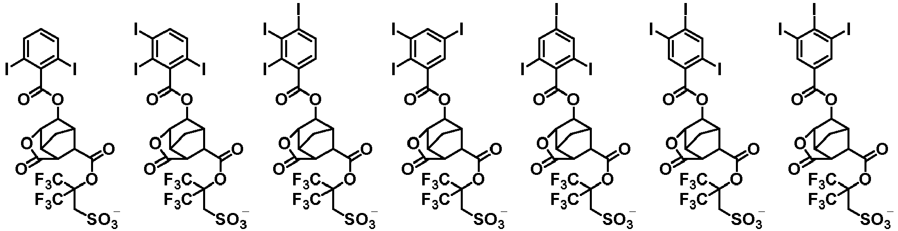

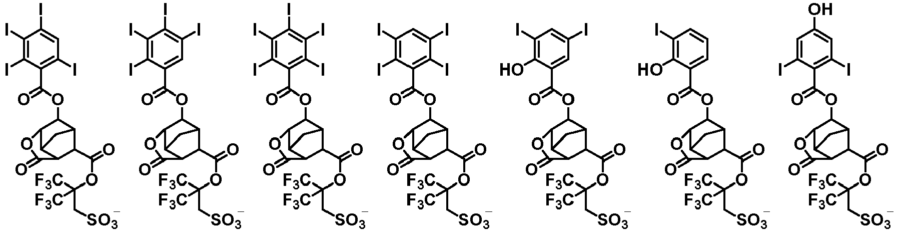

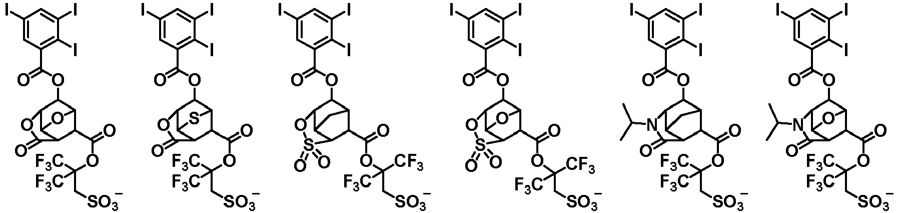

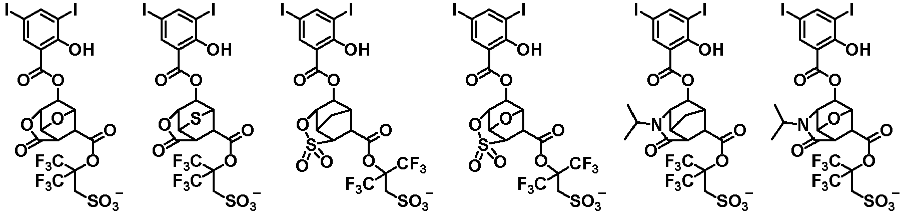

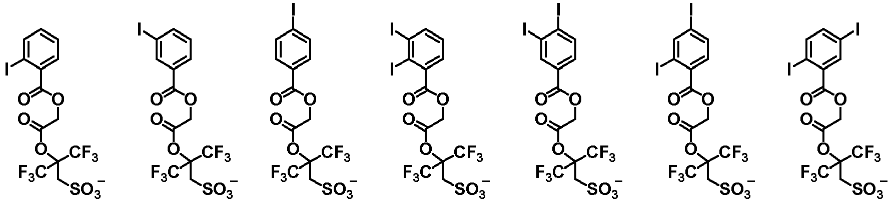

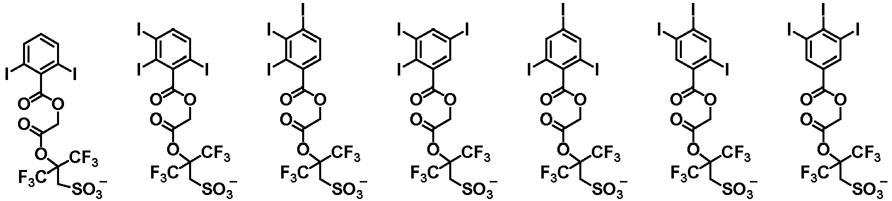

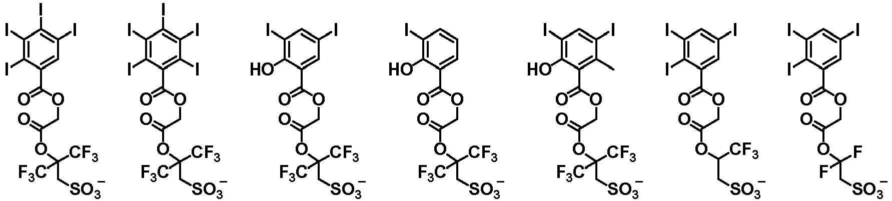

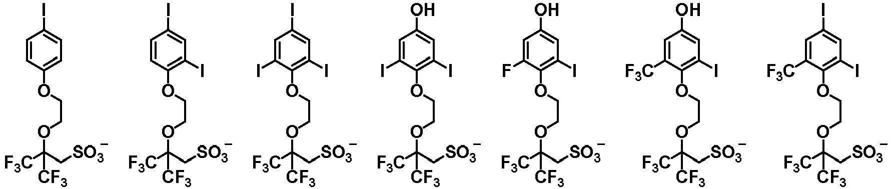

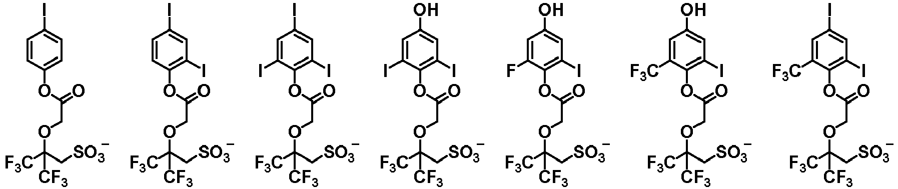

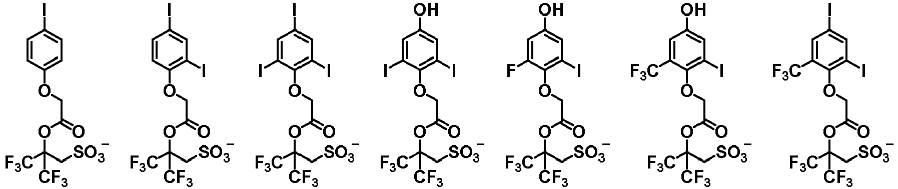

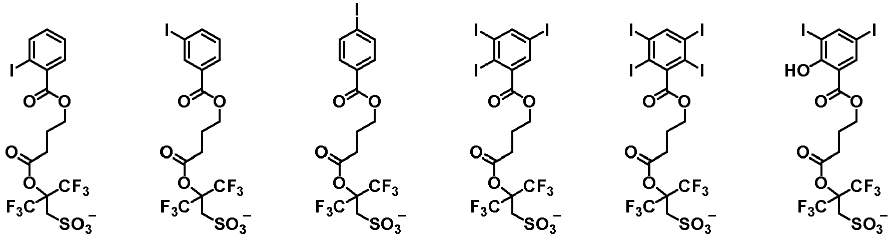

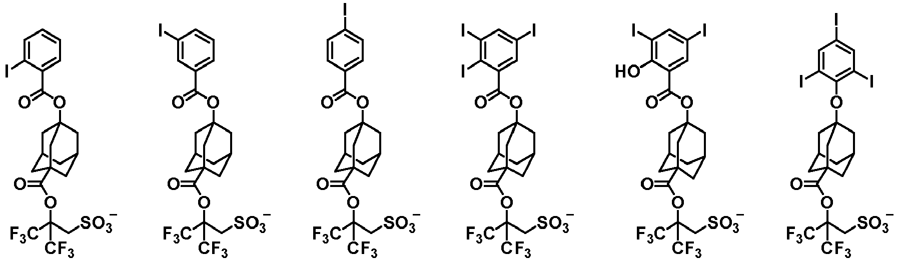

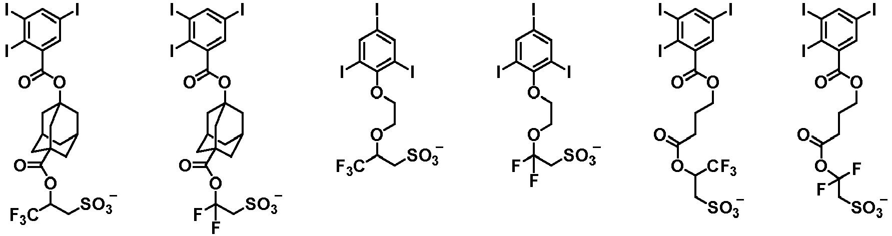

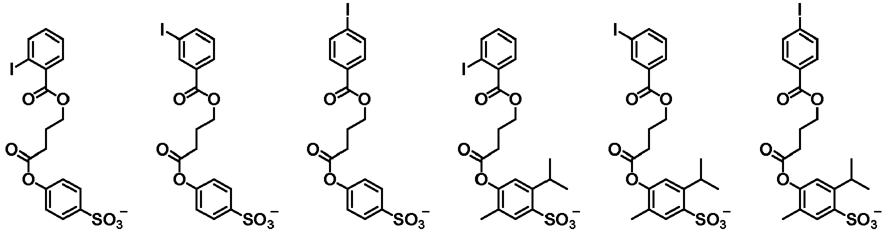

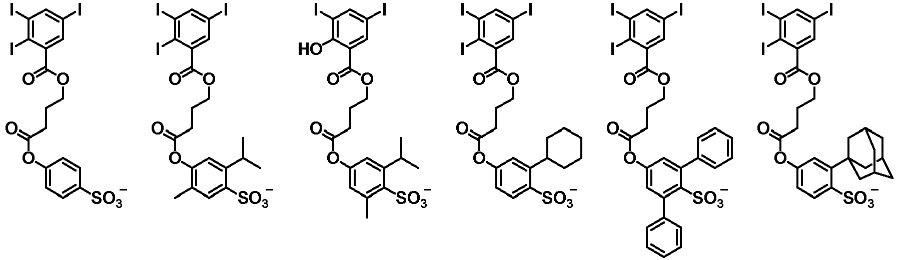

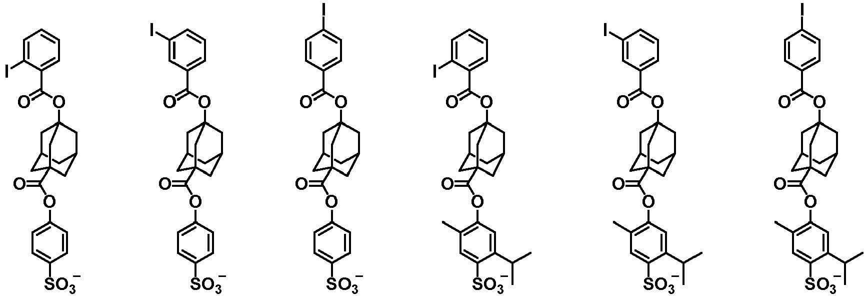

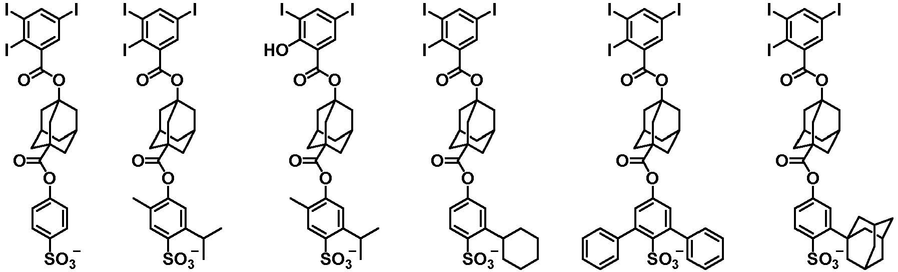

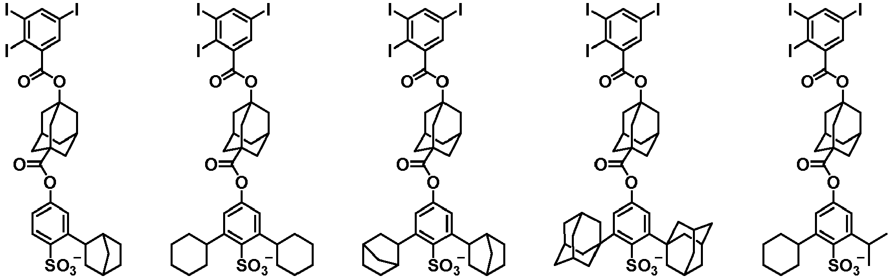

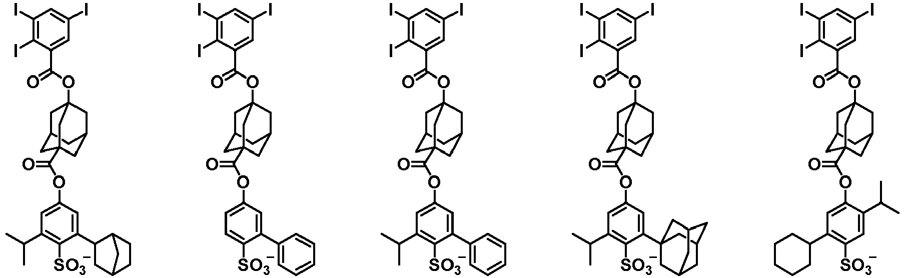

Preferred examples of the cation that pairs with the anion of the onium salt include sulfonium cations having the formula (B-4) and iodonium cations having the formula (B-5).

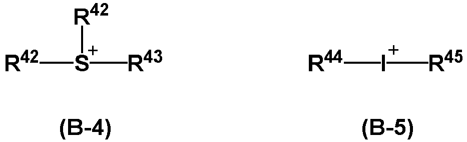

In formulae (B-4) and (B-5), R⁴¹ to R⁴⁵ are each independently halogen or a C₁-C₂₀ hydrocarbyl group which may contain a heteroatom.

Suitable halogen atoms include fluorine, chlorine, bromine and iodine.

The C₁-C₂₀ hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, tert-pentyl, n-hexyl, n-octyl, 2-ethylhexyl, n-nonyl and n-decyl; C₃-C₂₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₆-C₂₀ aryl groups such as phenyl, naphthyl and anthracenyl, and combinations thereof. In the hydrocarbyl groups, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-) or haloalkyl moiety.

Also, R⁴¹ and R⁴² may bond together to form a ring with the sulfur atom to which they are attached. Examples of the ring are shown below. 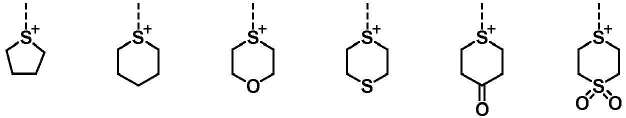 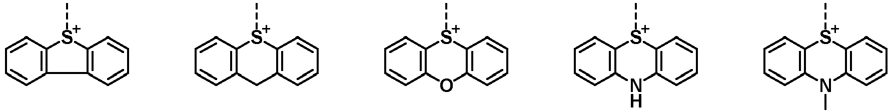 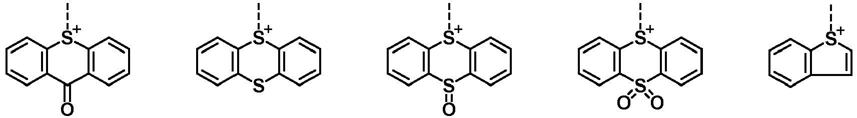 Herein, the broken line designates a point of attachment to R⁴³.

Exemplary structures of the sulfonium cation having formula (B-4) are shown below, but not limited thereto.

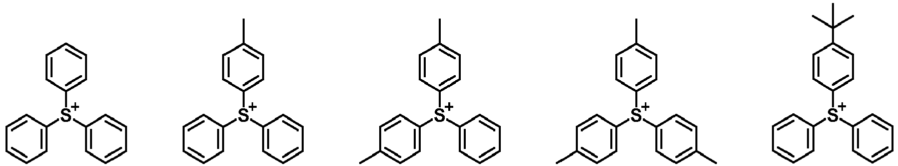

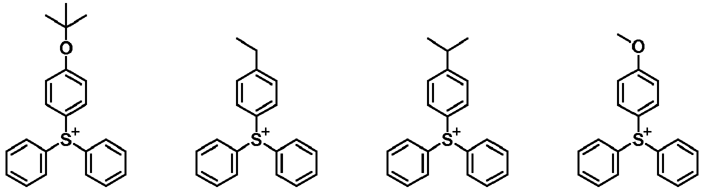

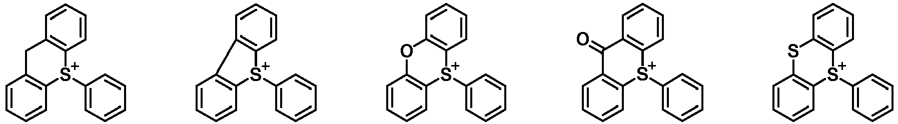

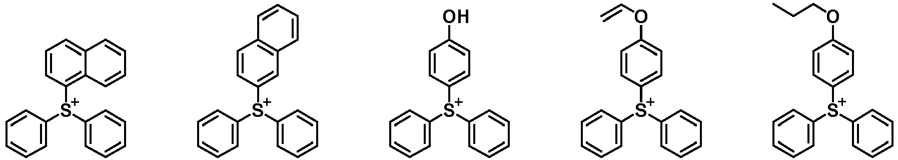

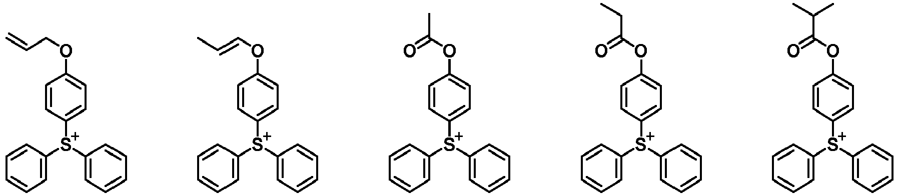

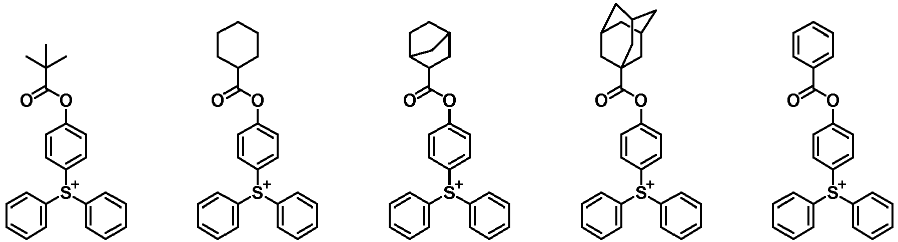

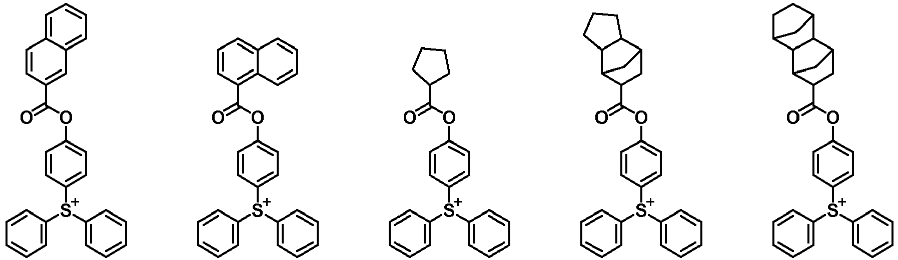

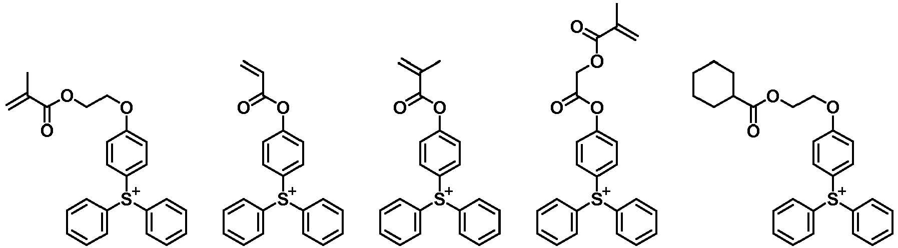

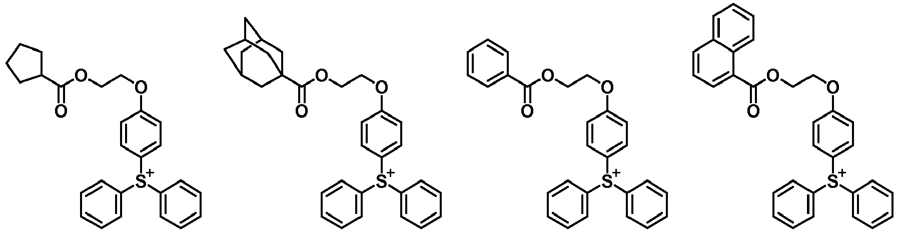

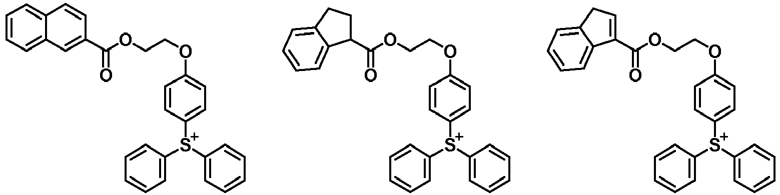

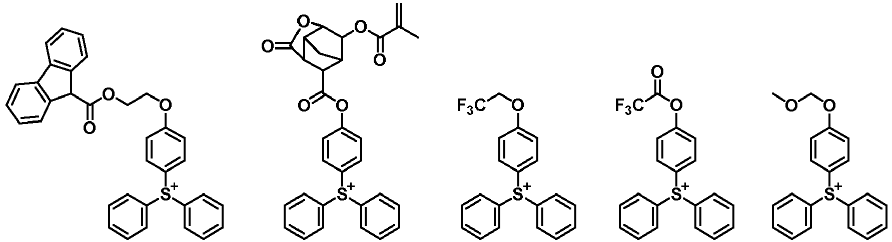

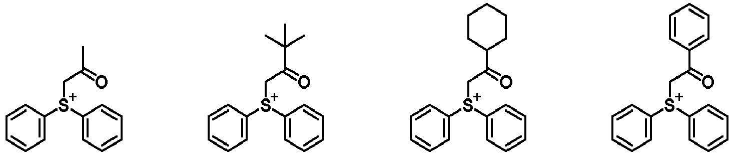

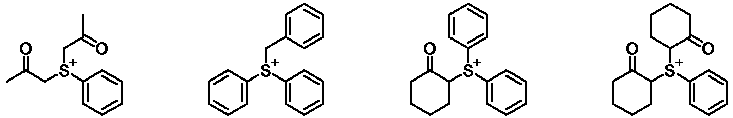

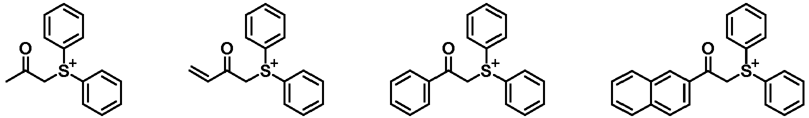

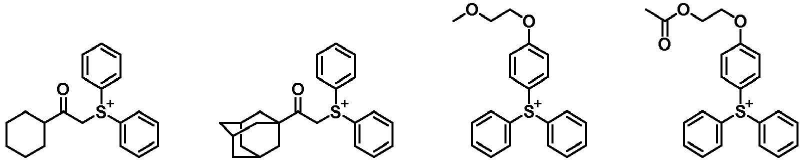

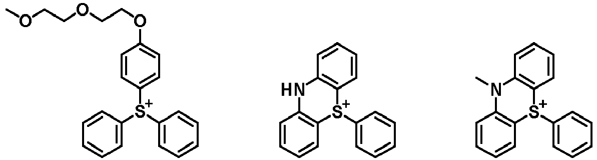

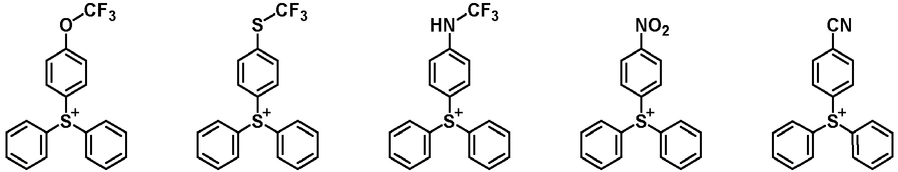

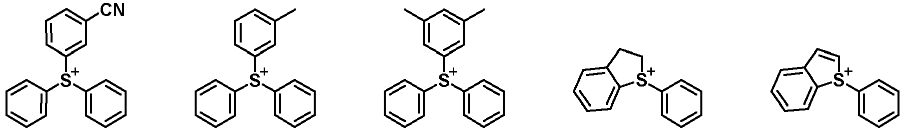

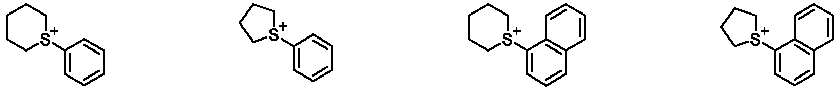

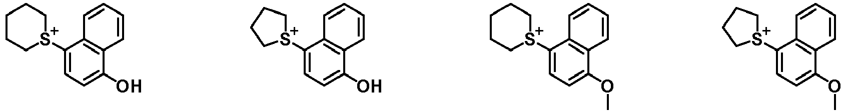

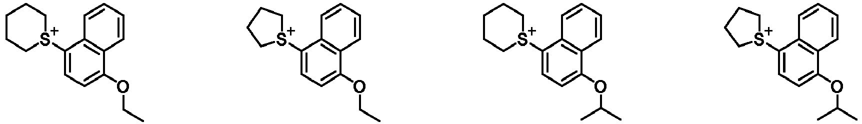

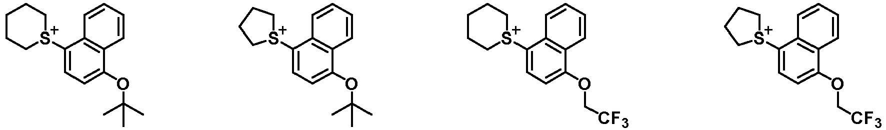

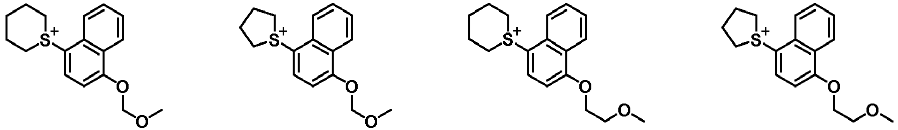

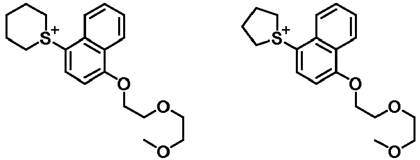

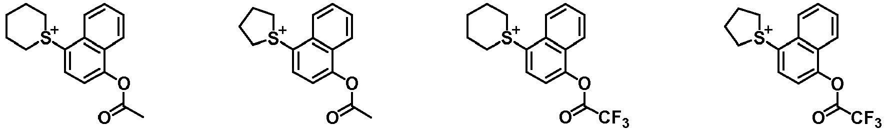

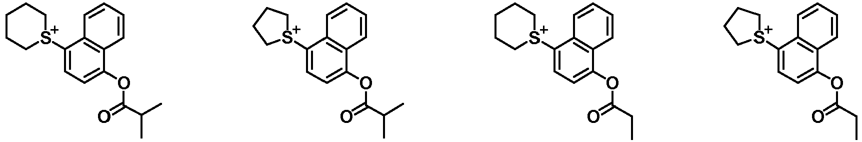

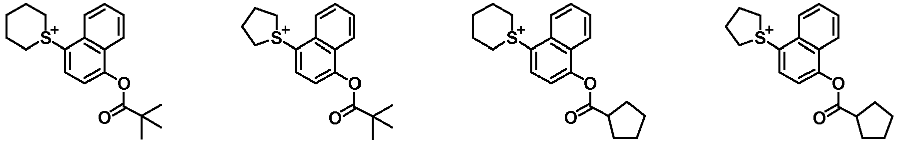

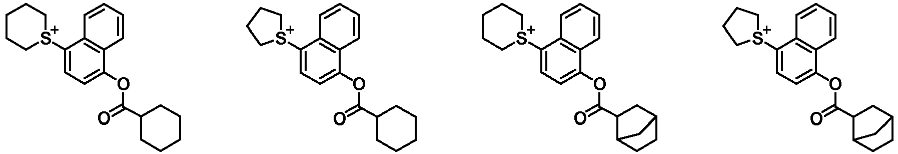

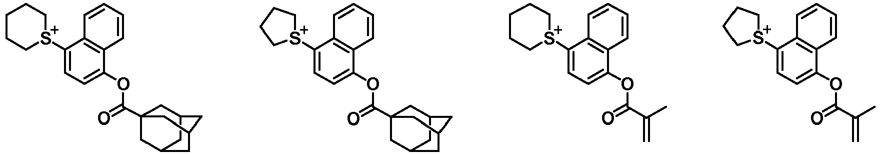

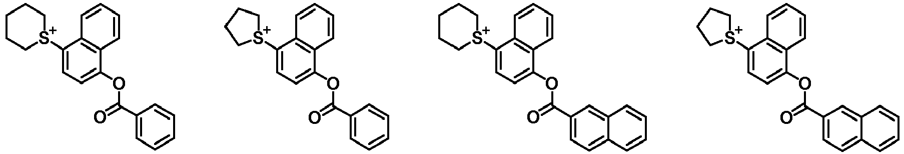

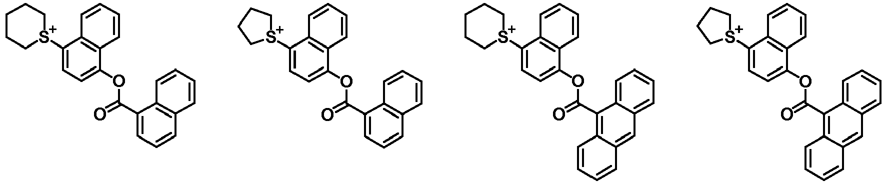

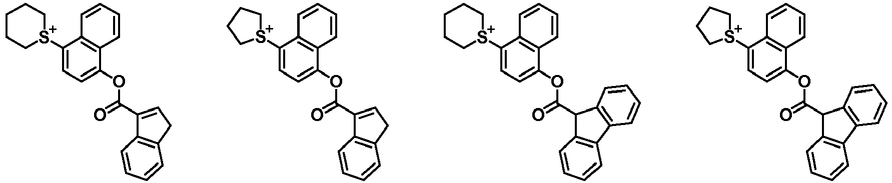

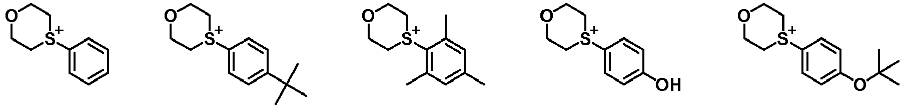

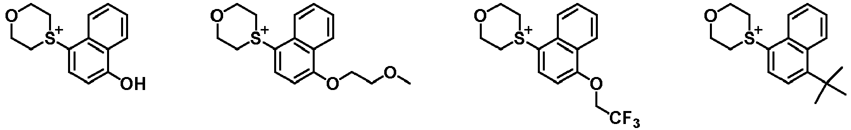

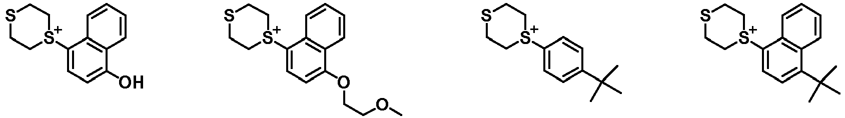

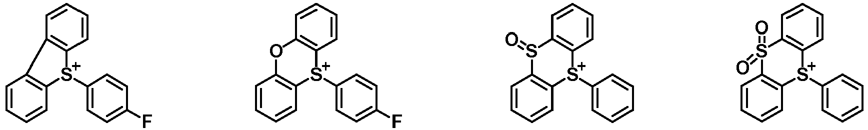

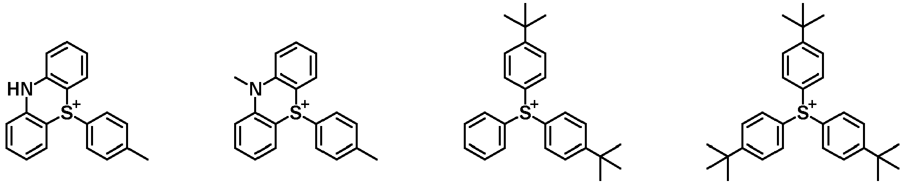

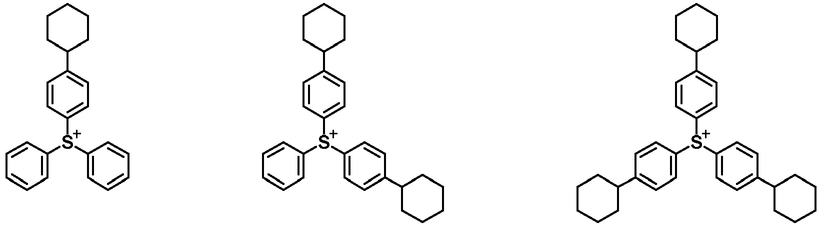

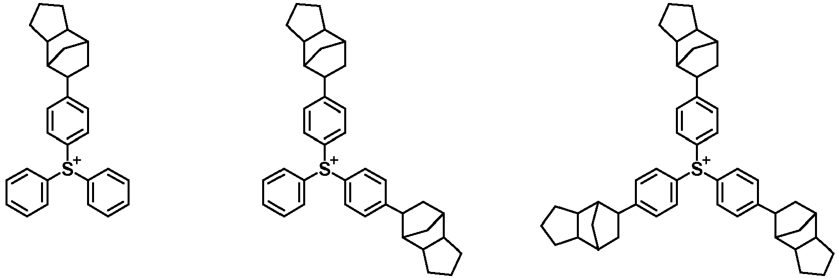

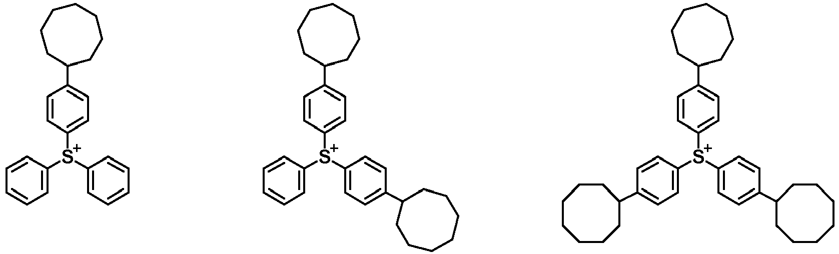

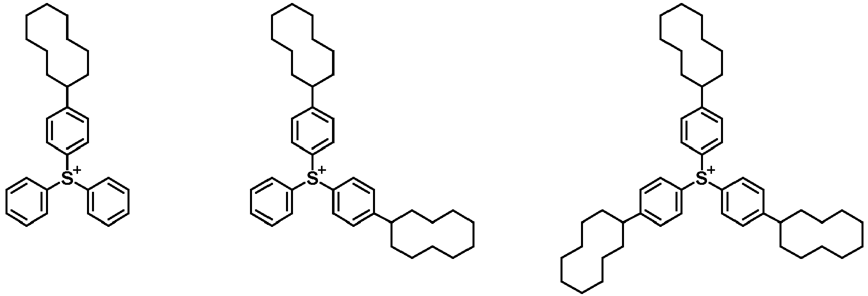

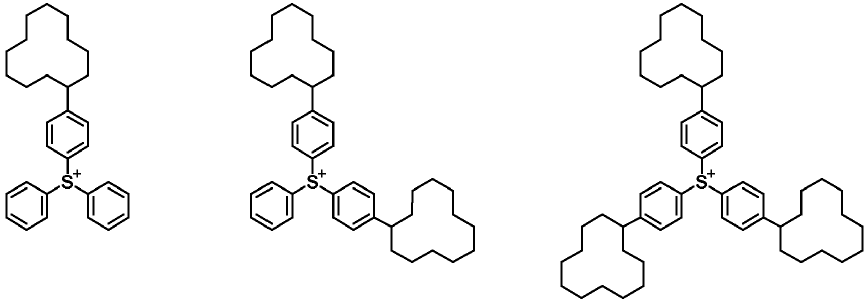

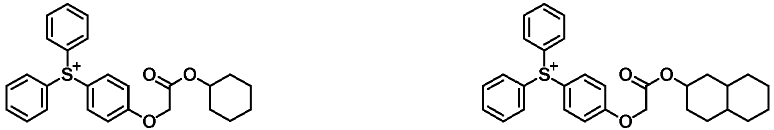

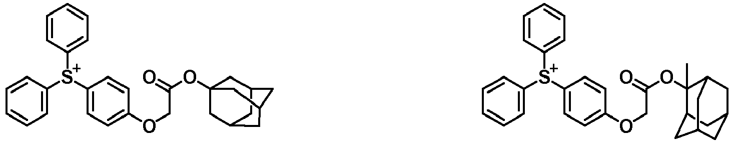

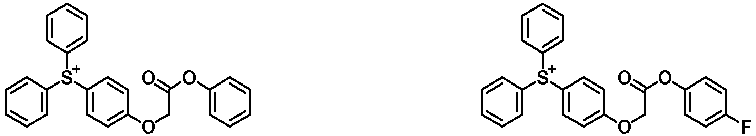

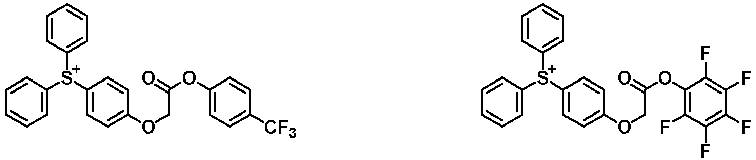

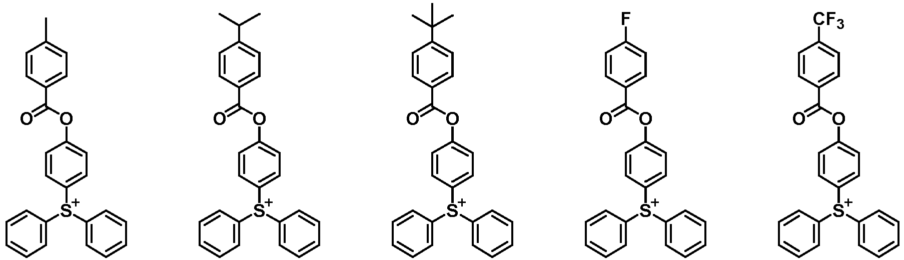

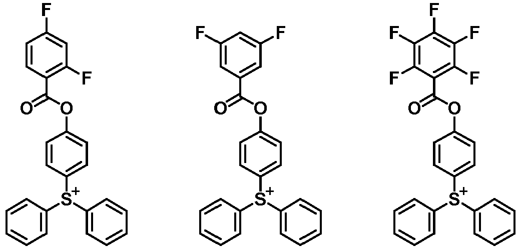

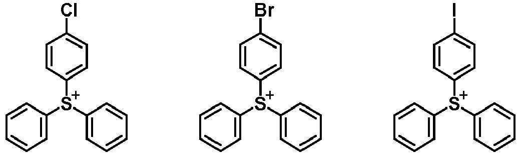

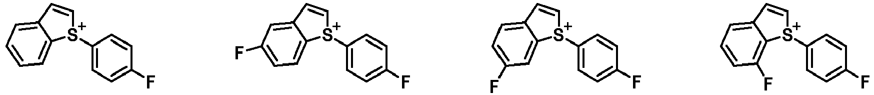

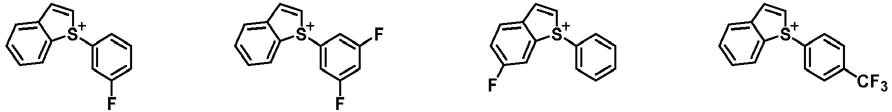

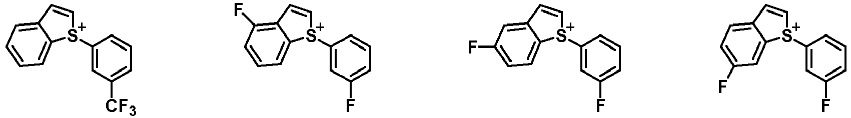

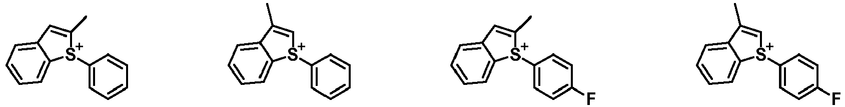

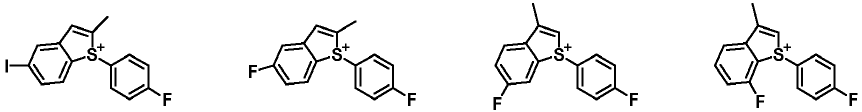

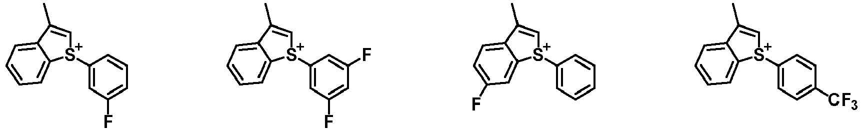

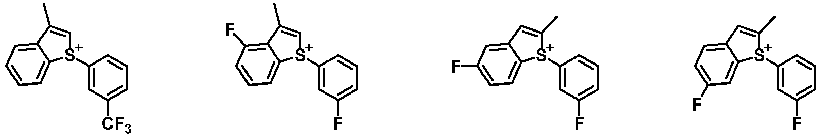

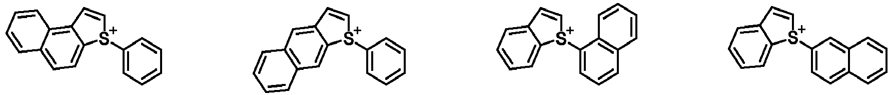

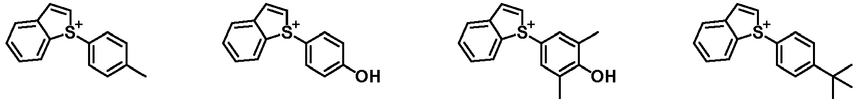

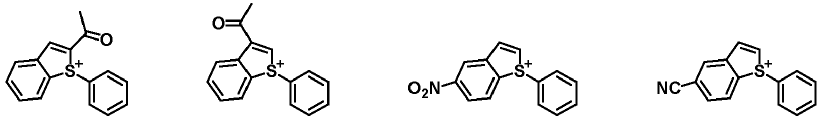

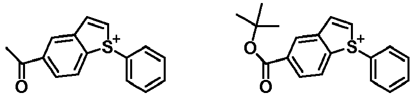

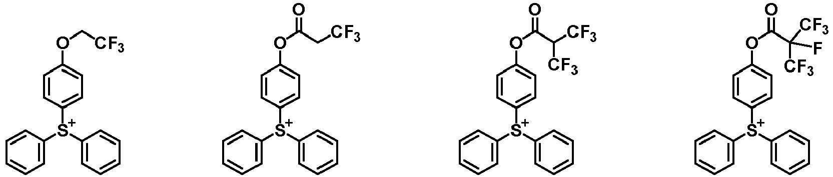

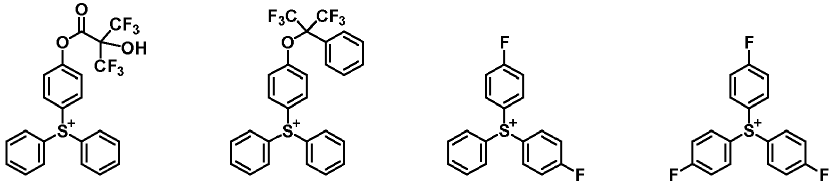

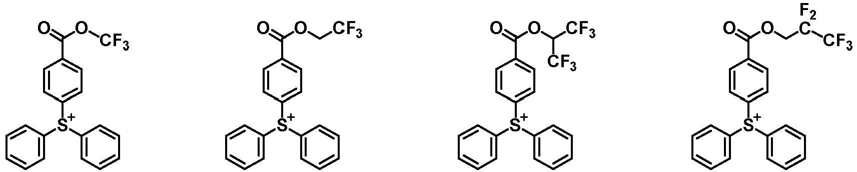

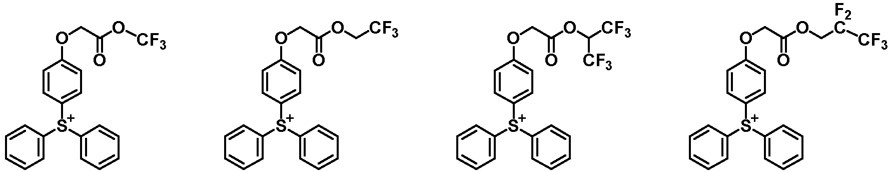

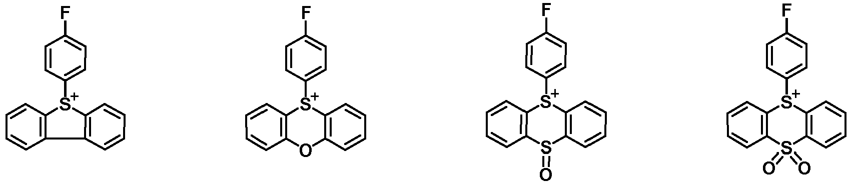

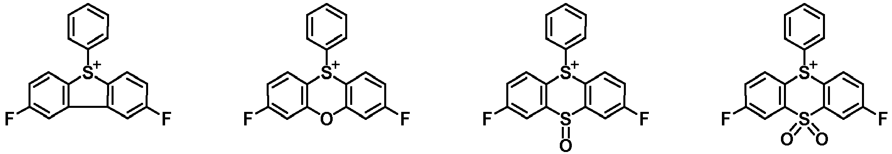

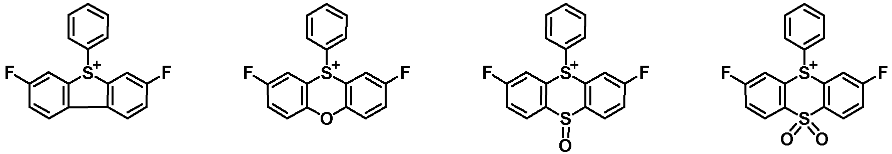

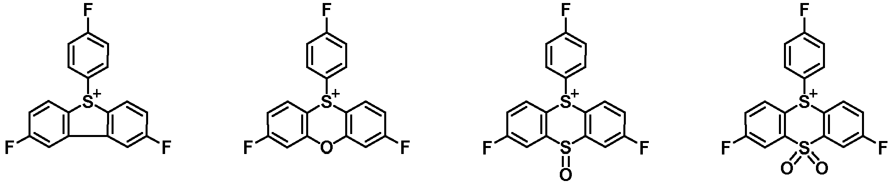

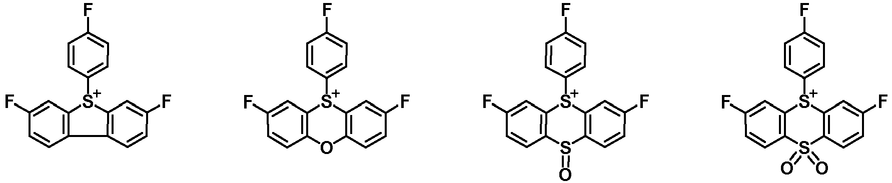

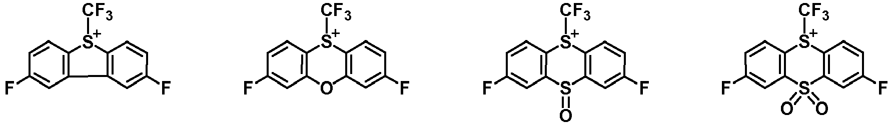

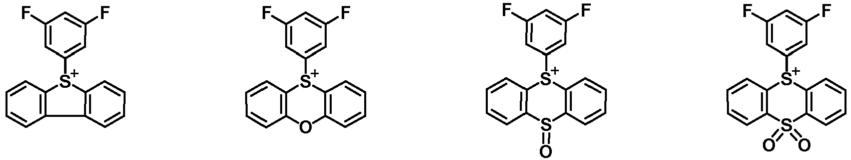

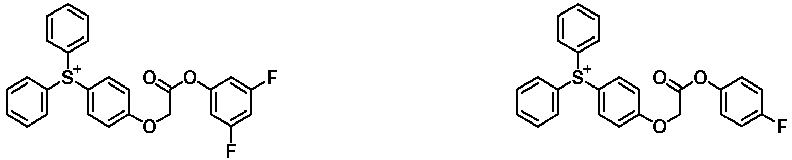

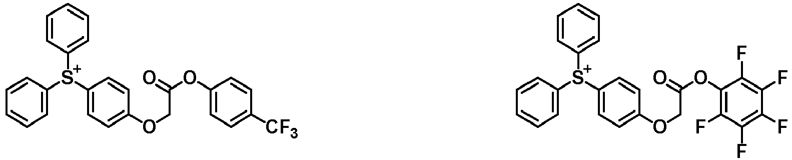

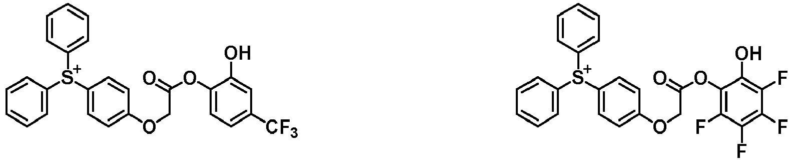

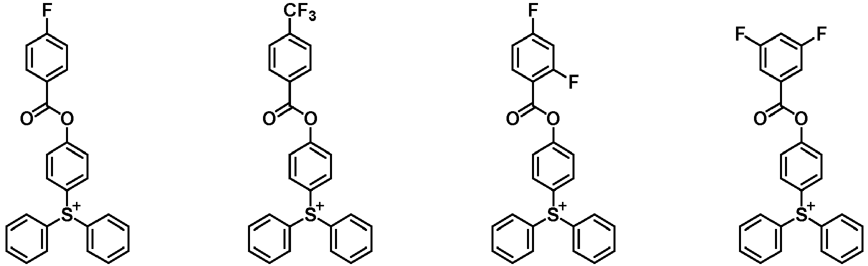

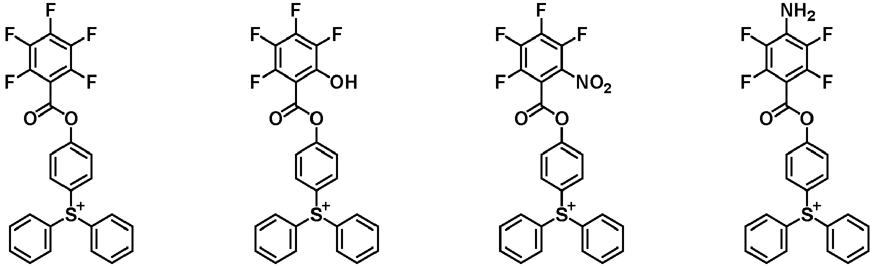

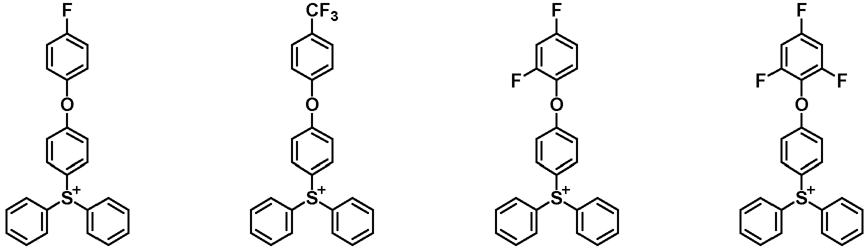

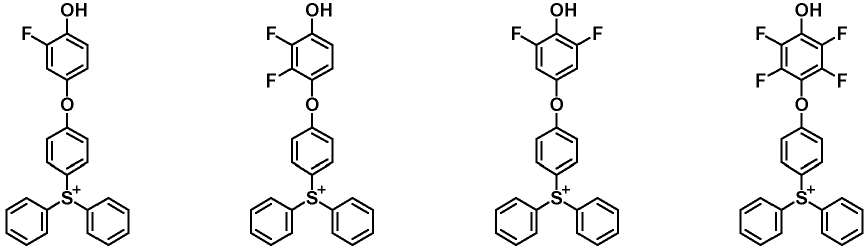

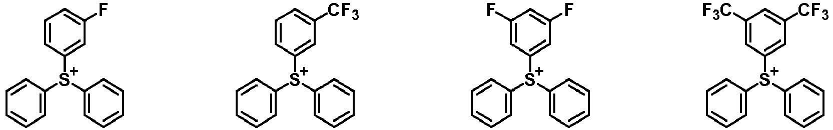

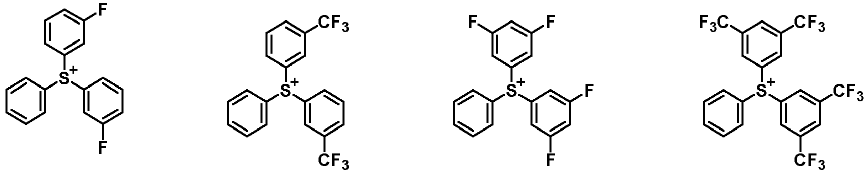

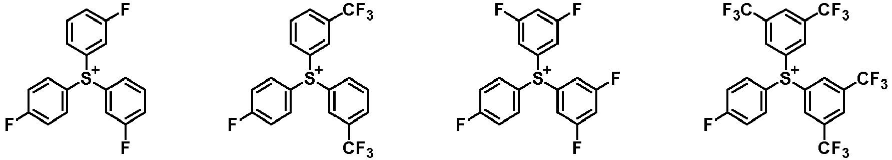

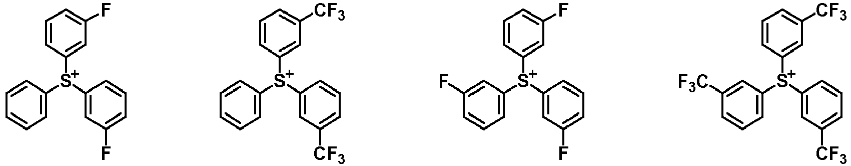

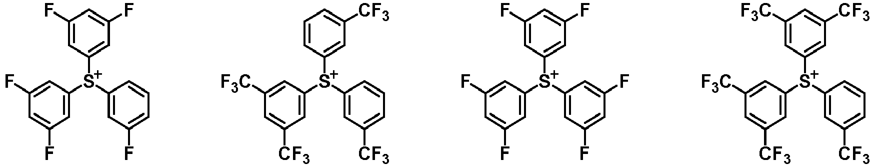

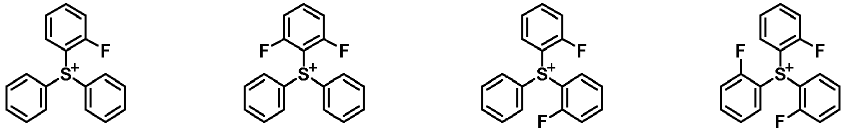

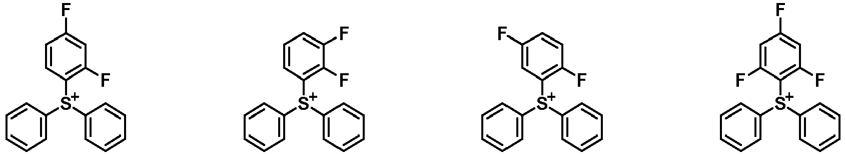

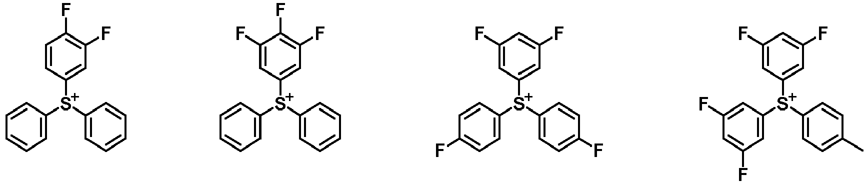

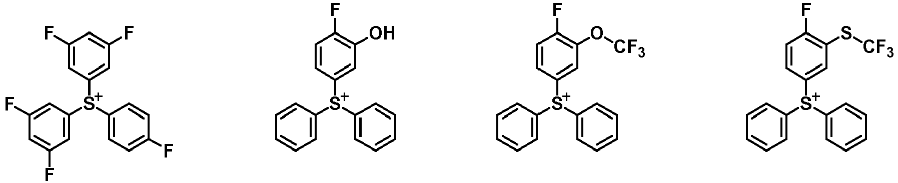

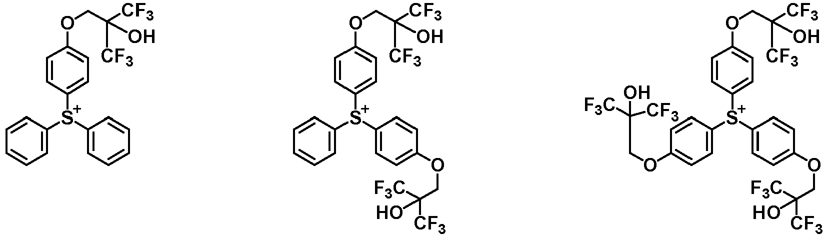

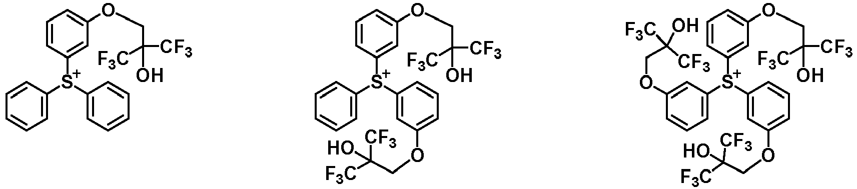

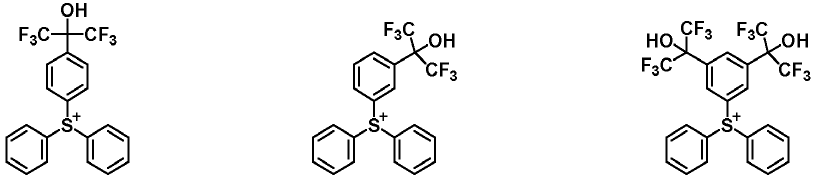

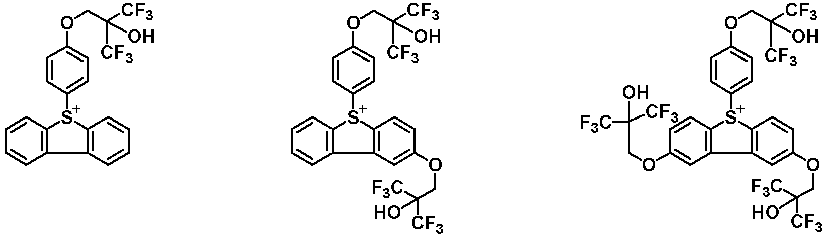

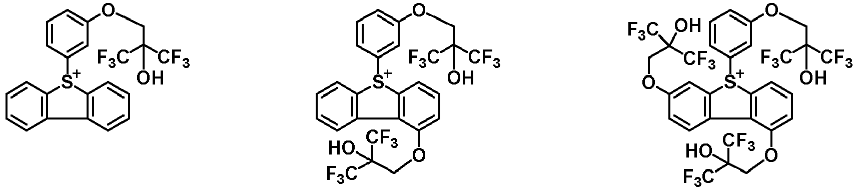

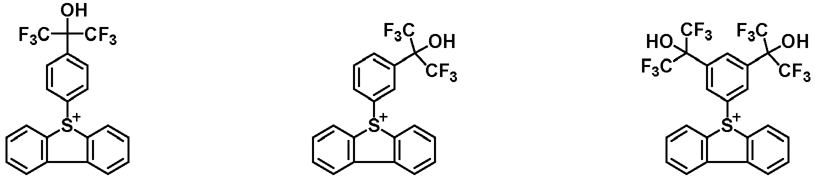

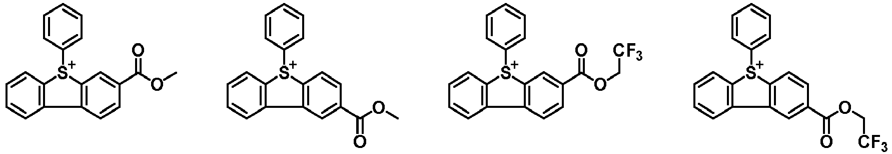

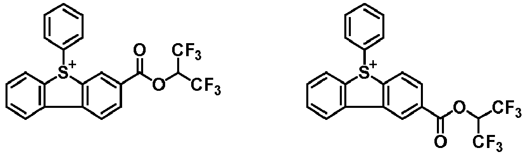

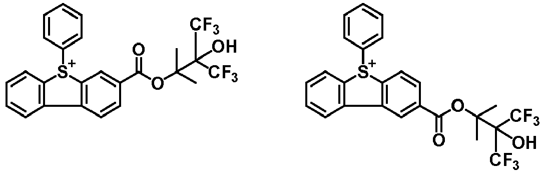

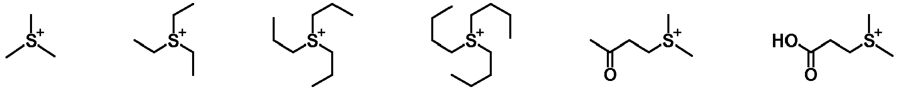

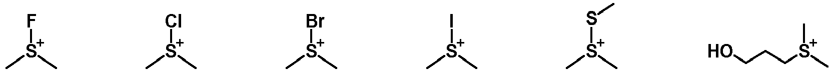

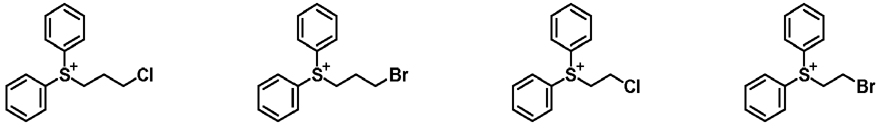

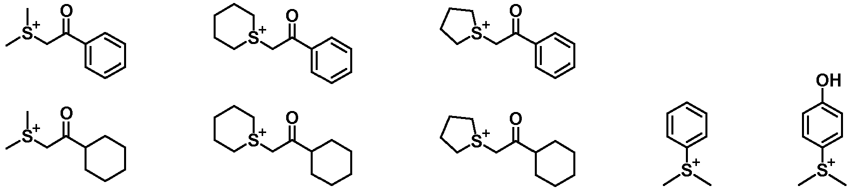

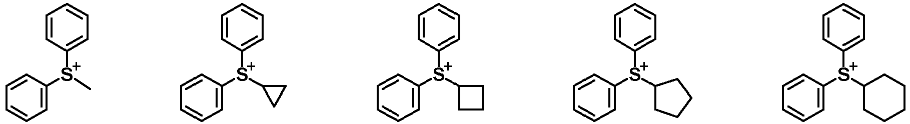

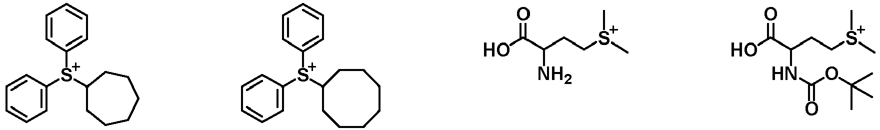

Exemplary structures of the iodonium cation having formula (B-5) are shown below, but not limited thereto.

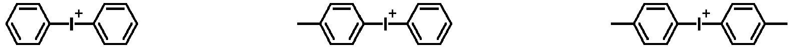

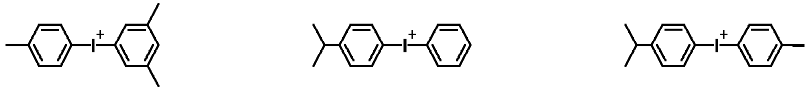

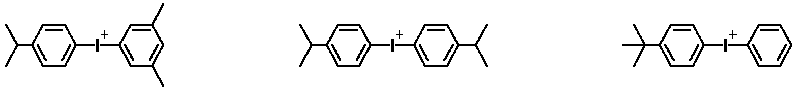

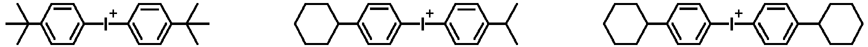

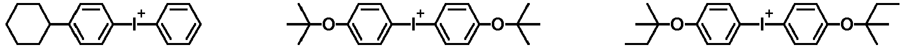

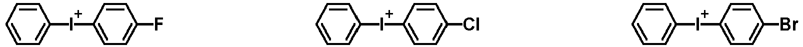

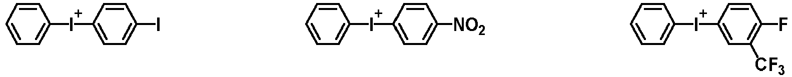

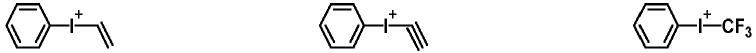

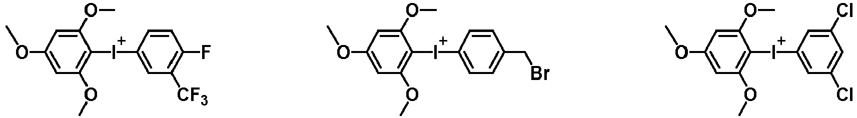

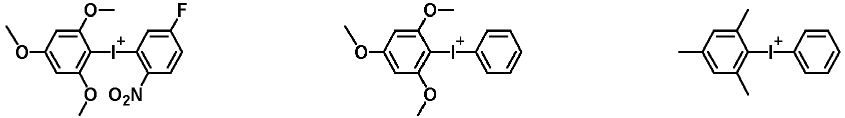

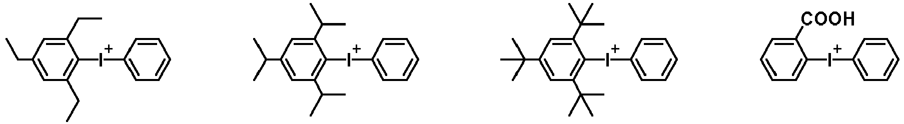

Specific structures of the onium salt include arbitrary combinations of the anion with the cation, both as exemplified above.

The PAG generates an acid having a pKa value of preferably -3.0 or larger, more preferably -1.0 or larger. The upper limit of pKa is preferably 2.0. Notably, the pKa value is computed using pKa DB in software ACD/Chemsketch ver: 9.04 of Advanced Chemistry Development Inc.

An appropriate amount of the PAG (B) used is 1 to 30 parts, more preferably 2 to 20 parts by weight per 80 parts by weight of the base polymer (A). The PAG may be used alone or in admixture.

### [(C) Quencher]

The positive resist composition contains a quencher or acid diffusion-suppressing agent. The quencher refers to a compound having a function of trapping the acid generated by the PAG for thereby preventing the acid from diffusing into the unexposed region and thus forming the pattern as desired.

The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonate ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. The α-non-fluorinated carboxylic acid functions as a quencher because it does not induce substantial deprotection reaction.

Examples of the onium salt of α-non-fluorinated carboxylic acid include compounds having the formula (C1).

**R⁵¹-CO₂⁻ Mq_{A}⁺** **(C1)**

In formula (C1), R⁵¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R⁵¹ may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), di- and trialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the hydrocarbyl groups, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, lactone ring, sultone ring, carboxylic anhydride (-C(=O)-O-C(=O)-), or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (C1), Mq_{A}⁺ is an onium cation. The onium cation is preferably selected from sulfonium, iodonium and ammonium cations, more preferably sulfonium and iodonium cations. Exemplary sulfonium cations are as exemplified above for the sulfonium cation having formula (B-4). Exemplary iodonium cations are as exemplified above for the iodonium cation having formula (B-5).

Examples of the anion in the onium salt having formula (C1) are shown below, but not limited thereto.

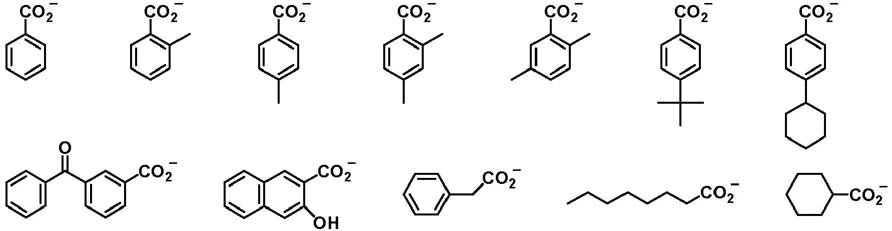

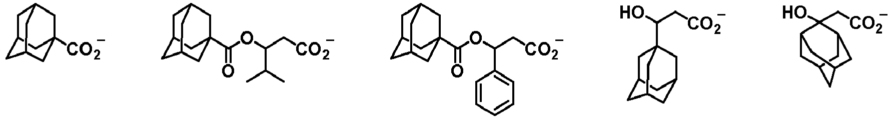

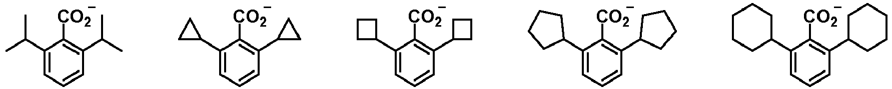

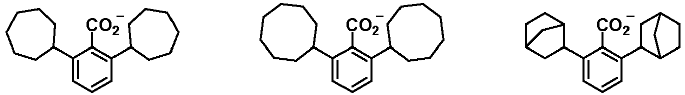

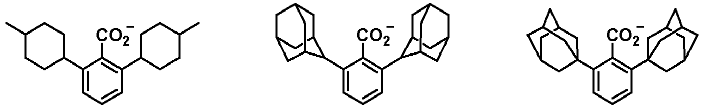

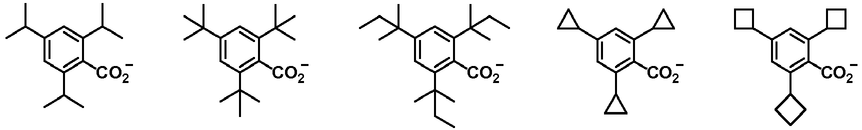

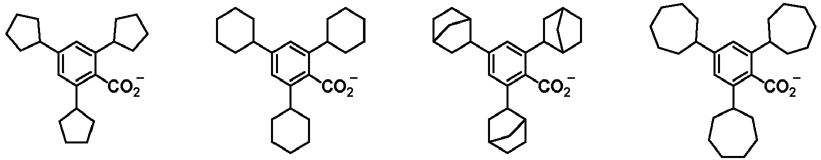

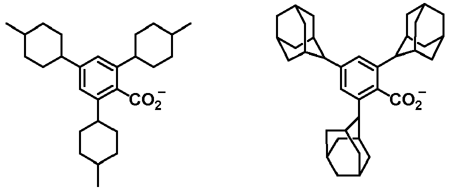

A sulfonium salt of iodized benzene ring-containing carboxylic acid having the formula (C2) is also useful as the quencher.

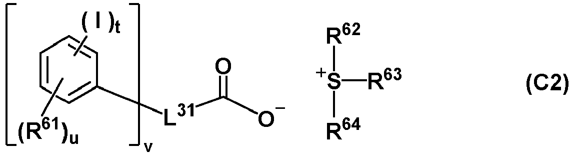

In formula (C2), t is an integer of 1 to 5, u is an integer of 0 to 3, and v is an integer of 1 to 3.

In formula (C2), R⁶¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{61A})-C(=O)-R^{61B}, or -N(R^{61A})-C(=O)-O-R^{61B}. R^{61A} is hydrogen or a C₁-C₆ saturated hydrocarbyl group. R^{61B} is a C₁-C₆ saturated hydrocarbyl or C₂-C₈ unsaturated aliphatic hydrocarbyl group. A plurality of R⁶¹ may be the same or different when u and/or v is 2 or 3.

In formula (C2), L³¹ is a single bond, or a C₁-C₂₀ (v+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (C2), R⁶², R⁶³ and R⁶⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate bond or sulfonate ester bond. Also R⁶² and R⁶³ may bond together to form a ring with the sulfur atom to which they are attached.

Examples of the compound having formula (C2) include those described in USP 10,295,904 (JP-A 2017-219836). These compounds exert a sensitizing effect due to remarkable absorption and an acid diffusion-controlling effect.

A nitrogen-containing carboxylic acid salt compound having the formula (C3) is also useful as the quencher.

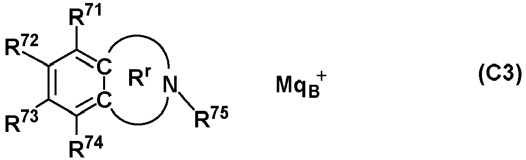

In formula (C3), R⁷¹ to R⁷⁴ are each independently hydrogen, -L⁴¹-CO₂⁻, or a C₁-C₂₀ hydrocarbyl group which may contain a heteroatom. R⁷¹ and R⁷², R⁷² and R⁷³, or R⁷³ and R⁷⁴ may bond together to form a ring with the carbon atom to which they are attached. L⁴¹ is a single bond or a C₁-C₂₀ hydrocarbylene group which may contain a heteroatom. R⁷⁵ is hydrogen or a C₁-C₂₀ hydrocarbyl group which may contain a heteroatom.

In formula (C3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L⁴¹-CO₂⁻ and in which some carbon may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (C3) has at least one -L⁴¹-CO₂⁻. That is, at least one of R⁶¹ to R⁶⁴ is -L⁴¹-CO₂⁻, and/or at least one of hydrogen atoms bonded to carbon atoms in the ring R^{r} is substituted by -L⁴¹-CO₂⁻.

In formula (C3), Mq_{B}⁺ is a sulfonium, iodonium or ammonium cation, with the sulfonium cation being preferred. Examples of the sulfonium cation are as exemplified above for the sulfonium cation having formula (B-4).

Examples of the anion in the compound having formula (C3) are shown below, but not limited thereto.

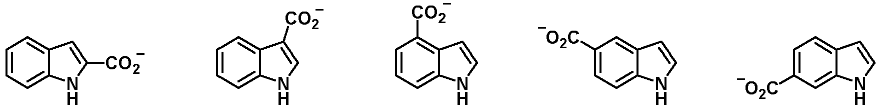

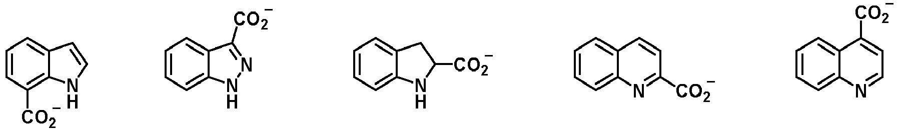

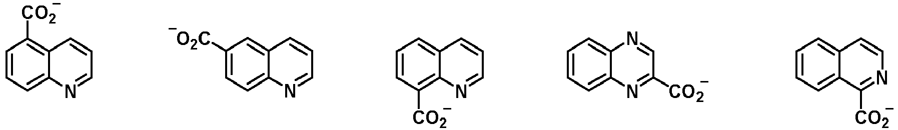

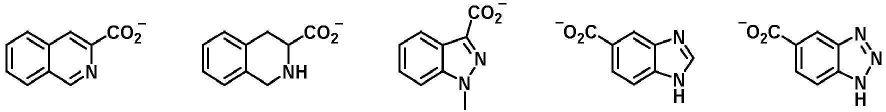

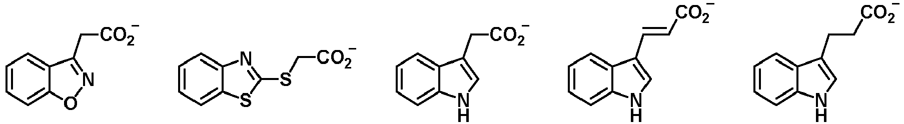

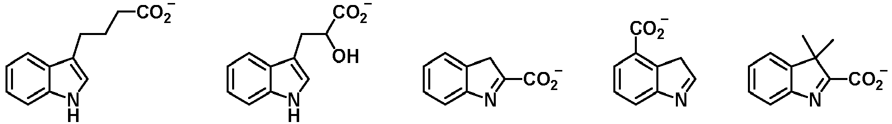

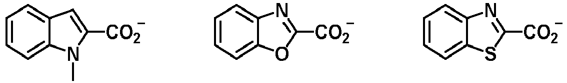

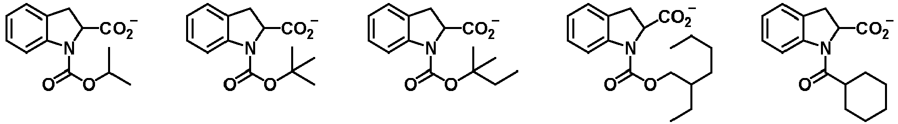

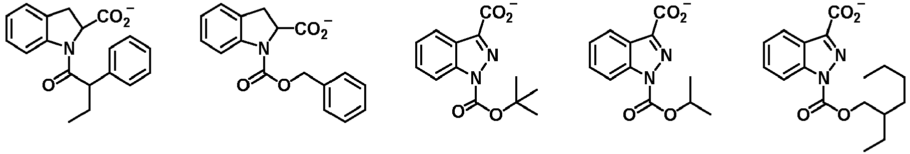

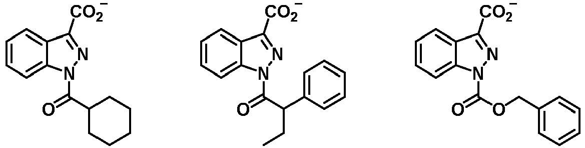

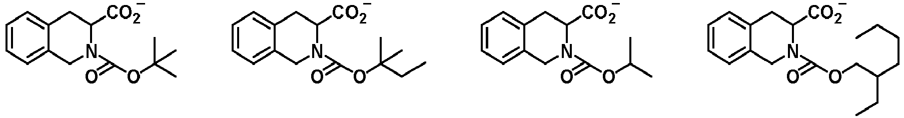

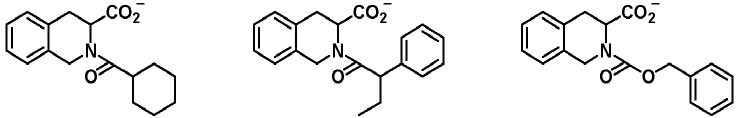

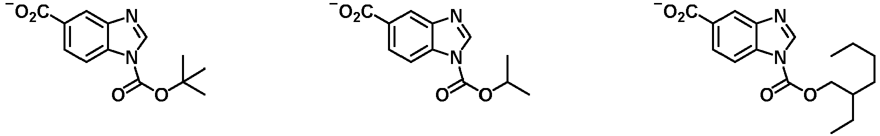

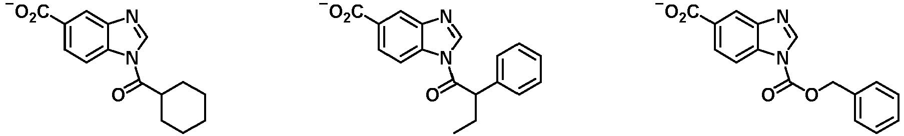

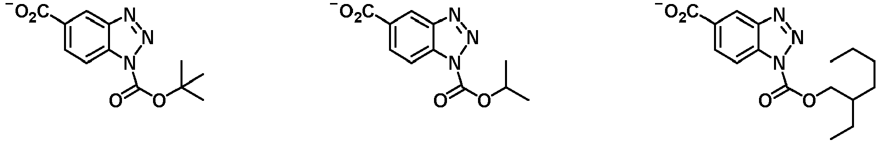

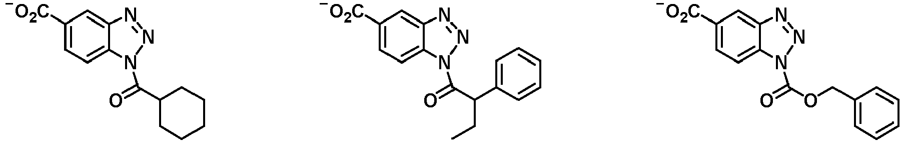

Weak acid betaine compounds are also useful as the quencher. Non-limiting examples thereof are shown below.

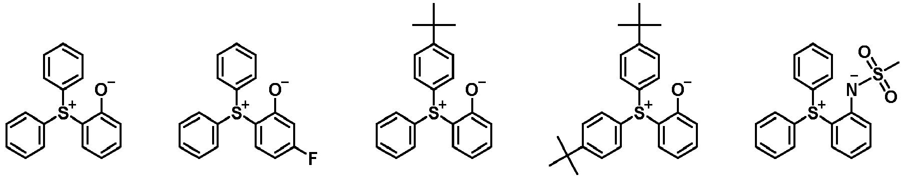

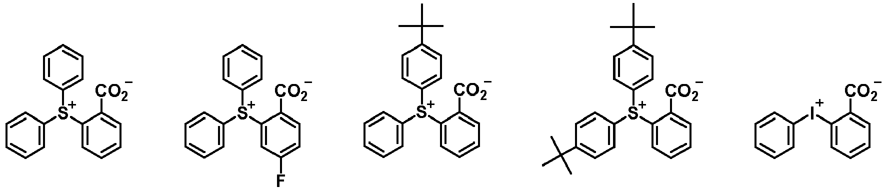

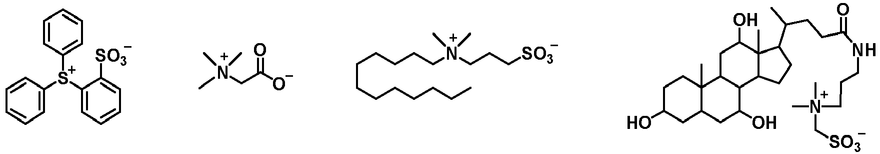

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

The quencher (C) is preferably added in an amount of 0.01 to 50 parts, more preferably 0.1 to 30 parts by weight per 80 parts by weight of the base polymer (A). The quencher may be used alone or in admixture.

In the chemically amplified positive resist composition containing the PAG (B) and the quencher (C), the weight ratio (B/C) of the PAG to the quencher is preferably less than 3/1, more preferably less than 2.5/1, even more preferably less than 2/1. As long as the weight ratio of the PAG to the quencher is in the range, the resist composition is able to fully suppress acid diffusion and to form a pattern of satisfactory profile having a high resolution and dimensional uniformity when processed by the EB lithography which is affected by forward and backward scattering.

### [(D) Fluorinated polymer]

The chemically amplified positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

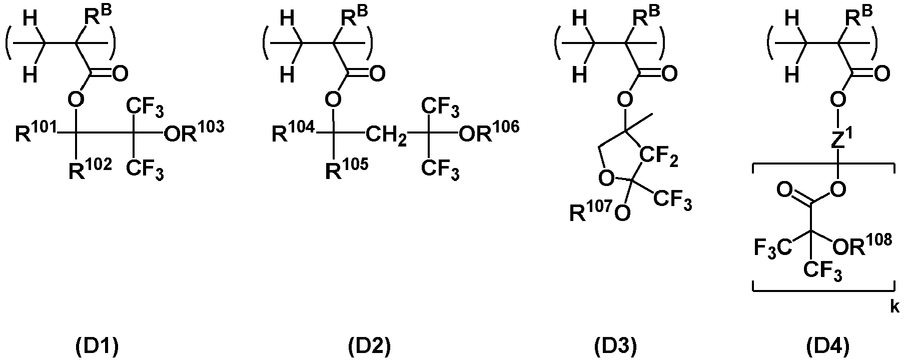

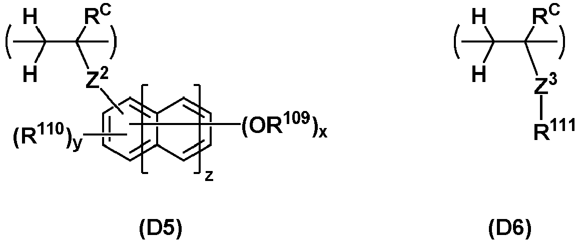

In formulae (D1) to (D6), x is 1, 2 or 3, y is an integer satisfying: 0 ≤ y ≤ 5+2z-x, z is 0 or 1, and k is 1, 2 or 3. R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group. An ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. R¹¹⁰ is a C₁-C₅ straight or branched hydrocarbyl group in which a heteroatom-containing moiety may intervene in a carbon-carbon bond. R¹¹¹ is a C₁-C₂₀ saturated hydrocarbyl group in which at least one hydrogen is substituted by fluorine and some constituent -CH₂- may be replaced by an ester bond or ether bond. Z¹ is a C₁-C₂₀ (k+1)-valent hydrocarbon group or C₁-C₂₀ (k+1)-valent fluorinated hydrocarbon group. Z² is a single bond, *-C(=O)-O- or *-C(=O)-NH-. Z³ is a single bond, -O-, *-C(=O)-O-Z³¹-Z³²- or *-C(=O)-NH-Z³¹-Z³²-, wherein Z³¹ is a single bond or a C₁-C₁₀ saturated hydrocarbylene group, and Z³² is a single bond, ester bond, ether bond or sulfonamide bond. The asterisk (*) designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (k+1)-valent hydrocarbon group Z¹ include the foregoing C₁-C₂₀ alkyl groups and C₃-C₂₀ cyclic saturated hydrocarbyl groups, with k number of hydrogen atoms being eliminated. Examples of the C₁-C₂₀ (k+1)-valent fluorinated hydrocarbon group Z¹ include the foregoing (k+1)-valent hydrocarbon groups in which at least one hydrogen atom is substituted by fluorine.

Examples of the repeat units D1 to D4 are given below, but not limited thereto. Herein R^{B} is as defined above.

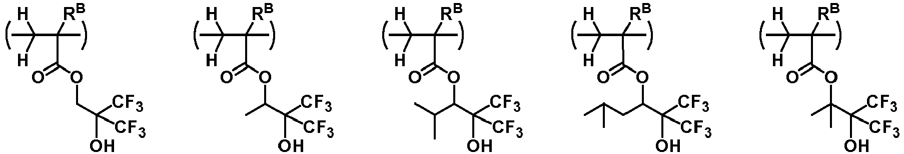

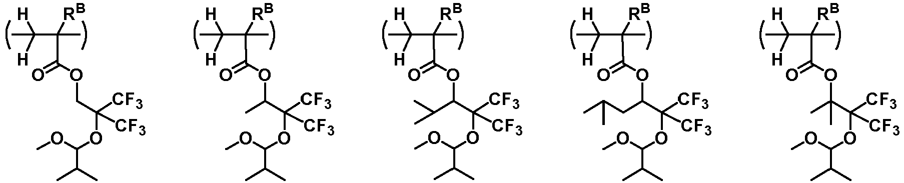

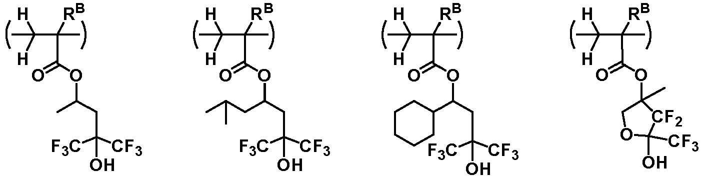

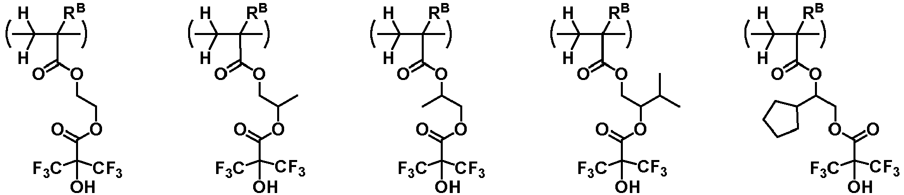

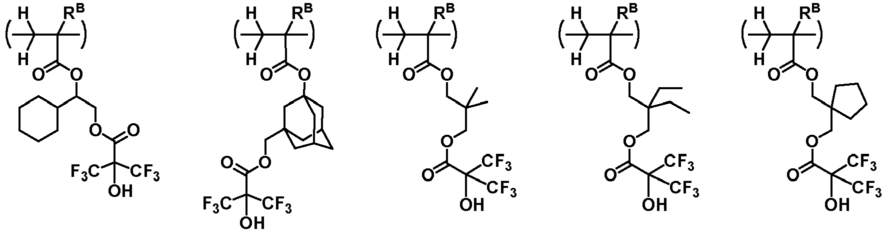

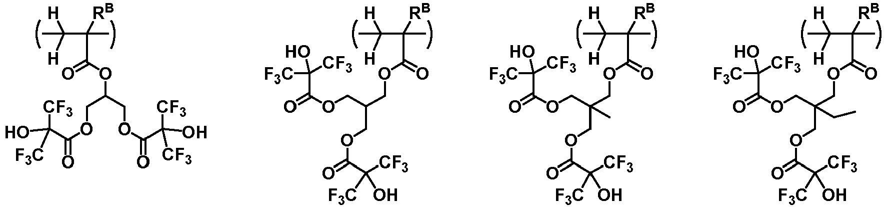

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), Z² is preferably *-C(=O)-O- or *-C(=O)-NH-. Also preferably R^{C} is methyl. The inclusion of carbonyl in Z² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

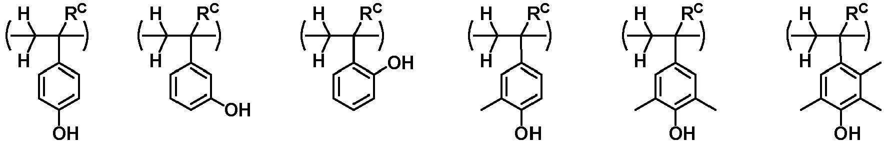

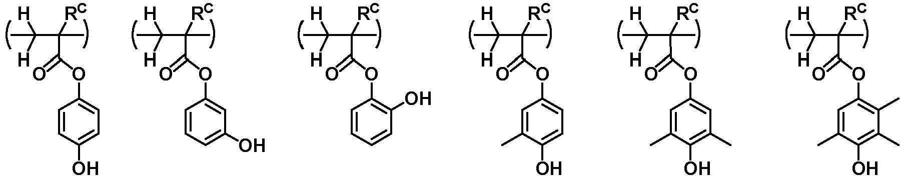

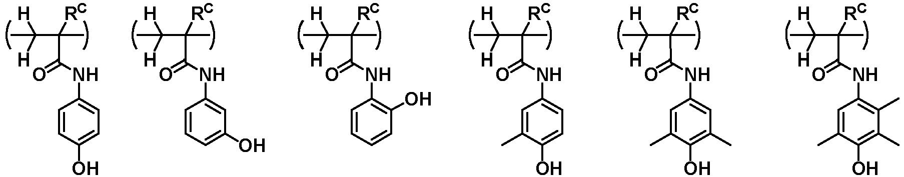

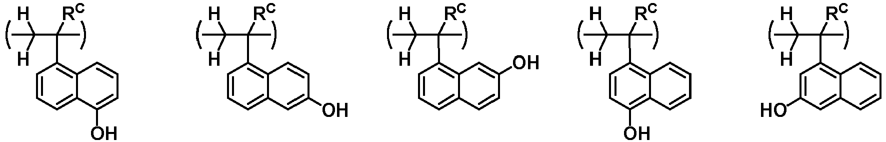

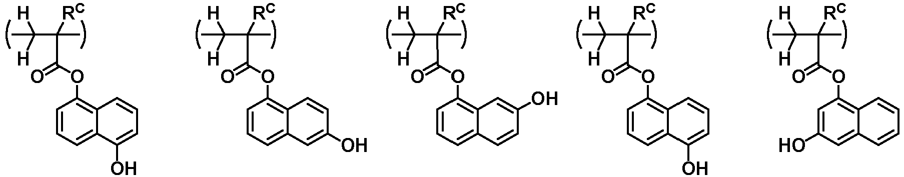

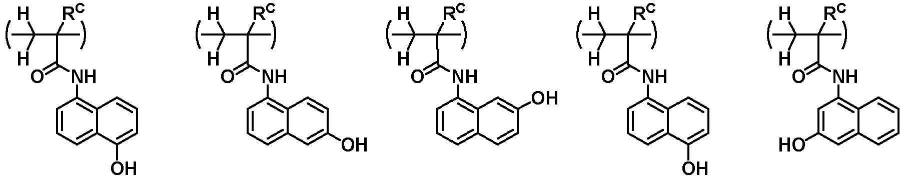

In formula (D6), the C₁-C₁₀ saturated hydrocarbylene group Z³ may be straight, branched or cyclic and examples thereof include methylene, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{C} is as defined above.

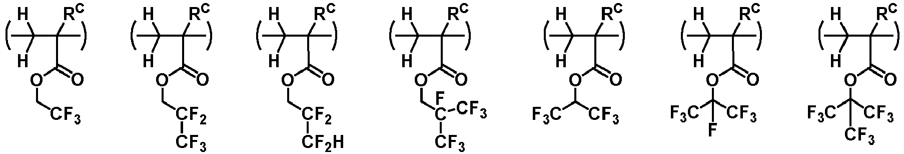

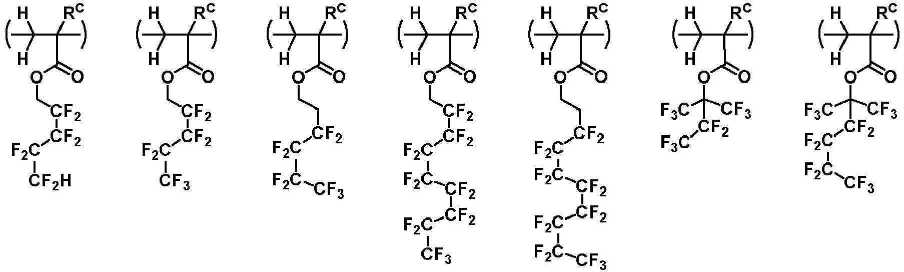

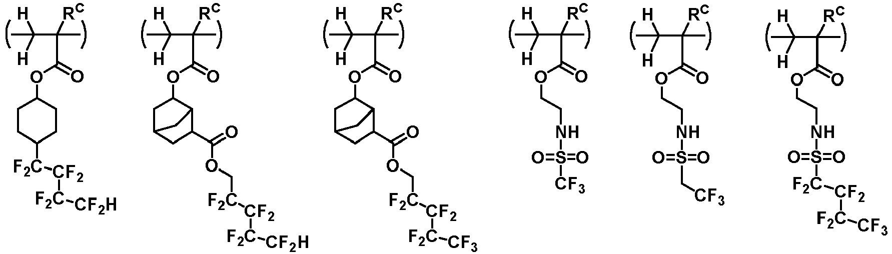

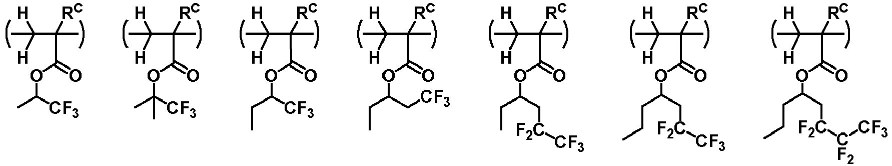

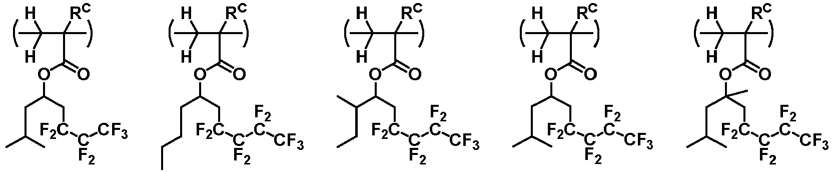

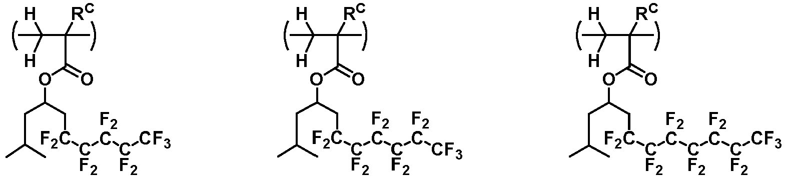

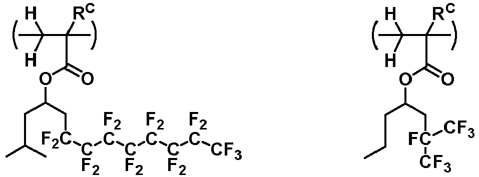

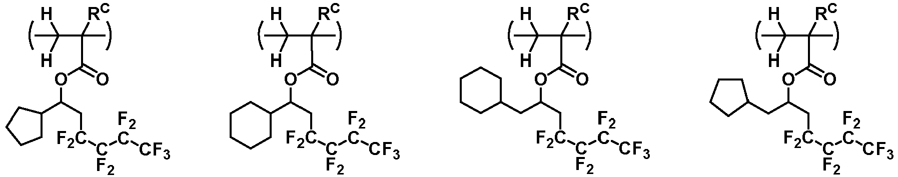

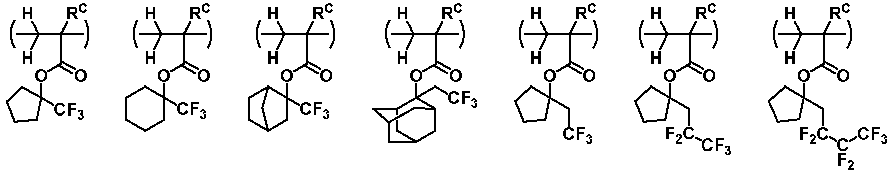

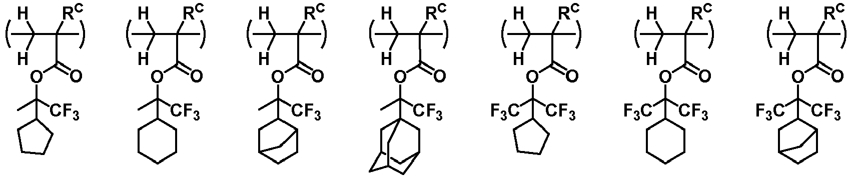

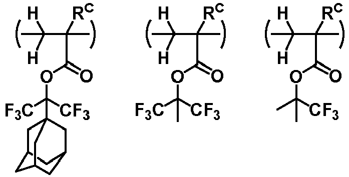

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of less than 2,000 helps acid diffusion, degrading resolution and detracting from age stability. A polymer with too high Mw has a reduced solubility in solvent, with a risk of leaving coating defects. The fluorinated polymer preferably has a dispersity (Mw/Mn) of 1.0 to 2.2, more preferably 1.0 to 1.7.

In the resist composition, the fluorinated polymer (D) is preferably used in an amount of 0.01 to 30 parts by weight, more preferably 0.1 to 20 parts by weight, even more preferably 0.5 to 10 parts by weight per 80 parts by weight of the base polymer (A). The fluorinated polymer may be used alone or in admixture.

### [(E) Organic solvent]

The chemically amplified positive resist composition may comprise an organic solvent. The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclopentanone, cyclohexanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol (DAA); ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone (GBL), and mixtures thereof. Where an acid labile group of acetal form is used, a high boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the resist composition, the organic solvent (E) is preferably used in an amount of 200 to 10,000 parts, more preferably 400 to 5,000 parts by weight per 80 parts by weight of the base polymer (A). The organic solvent may be used alone or in admixture.

### [(F) Surfactant]

The resist composition may contain any conventional surfactants for facilitating to coat the composition to the substrate. A number of surfactants are known in the art as described in JP-A 2004-115630, and any suitable one may be chosen therefrom. The amount of the surfactant (F) added is preferably 0 to 5 parts by weight per 80 parts by weight of the base polymer (A). The surfactant may be used alone or in admixture. It is noted that the surfactant need not be added when the positive resist composition contains a fluorinated polymer as mentioned above, which also plays the role of a surfactant.

The positive resist composition may be prepared by dissolving components (A) to (C) and optional components (D) and (F) in an organic solvent (E) at the same time or in any desired order to form a uniform resist solution. The resist solution is preferably filtered. Using a filter of nylon or polyethylene for filtration, gel fractions and particles can be effectively removed from the resist solution. Also preferably, a filter having a pore size of up to 20 nm is used because the quality of the resist solution is maintained adequate for the lithography of the advanced generation.

From the standpoint of improving the develop loading effect, the positive resist composition is preferably designed such that a resist film formed therefrom in an exposed region may have a dissolution rate in alkaline developer of at least 50 nm/sec, more preferably at least 80 nm/sec. As long as the dissolution rate is at least 50 nm/sec, the resist film is uniformly dissolved in alkaline developer independent of a pattern layout difference in the case of a grouped/isolated pattern, and the variation of line width can be minimized. It is noted that the dissolution rate of a resist film in an exposed region is computed by spin coating the positive resist composition onto a 200-mm (8-inch) silicon wafer, baking at 110°C for 60 seconds to form a resist film of 90 nm thick, exposing the resist film to KrF excimer laser radiation in a sufficient energy dose to complete deprotection reaction on the polymer, baking at 110°C for 60 seconds, developing the film in a 2.38 wt% TMAH aqueous solution at 23°C, and measuring a loss of film thickness by means of a resist development analyzer.

The resist film formed from the chemically amplified positive resist composition in an unexposed region preferably has a dissolution rate in alkaline developer of up to 10 nm/min, more preferably up to 9 nm/min, even more preferably up to 8 nm/min. Where the resist film is in the thin film range of up to 100 nm, the influence of pattern film thickness loss in alkaline developer becomes greater. If the dissolution rate in unexposed region is more than 10 nm/min, pattern collapse occurs, failing to form a small-size pattern. This becomes outstanding in the fabrication of photomasks requiring to be defectless and having a tendency of strong development process. It is noted that the dissolution rate of a resist film in an unexposed region is computed by spin coating the positive resist composition onto a 150-mm (6-inch) silicon wafer, baking at 110°C for 240 seconds to form a resist film of 80 nm thick, developing the film in a 2.38 wt% TMAH aqueous solution at 23°C for 80 seconds, and measuring a loss of film thickness.

### Pattern forming process

Another embodiment of the invention is a process for forming a resist pattern comprising the steps of applying the chemically amplified positive resist composition onto a substrate to form a resist film thereon, exposing patternwise the resist film to EUV or EB, especially EB, and developing the exposed resist film in an alkaline developer.

The resist composition is first applied onto a substrate on which an integrated circuit is to be formed (e.g., Si, SiO, SiO₂, SiN, SiON, TiN, WSi, BPSG, SOG, or organic antireflective coating) or a substrate on which a mask circuit is to be formed (e.g., Cr, CrO, CrON, MoSi₂, Si, SiO, SiO₂, SiON, SiONC, CoTa, NiTa, TaBN, or SnO₂) by a suitable coating technique such as spin coating. The coating is prebaked on a hot plate at a temperature of preferably 60 to 150°C for 1 to 20 minutes, more preferably at 80 to 140°C for 1 to 10 minutes. The resulting resist film is generally 0.03 to 2 µm thick.

The resist film is then exposed to a desired pattern of EUV or EB. Exposure using EB is preferred. For forming the desired pattern, EB is preferably irradiated so as to give a dose of 10 to 500 µC/cm², more preferably 50 to 400 µC/cm².

The exposure may be performed by conventional lithography whereas the immersion lithography of holding a liquid, typically water between the resist film and the mask may be employed if desired. In the case of immersion lithography, a protective film which is insoluble in water may be formed on the resist film.

After the exposure, the resist film may be baked (PEB) on a hotplate preferably at 60 to 150°C for 1 to 20 minutes, more preferably at 80 to 140°C for 1 to 10 minutes.

After the exposure or PEB, the resist film is developed in a developer in the form of an aqueous alkaline solution for preferably 0.1 to 3 minutes, more preferably 0.5 to 2 minutes by conventional techniques such as dip, puddle and spray techniques. A typical developer is a 0.1 to 5 wt%, preferably 2 to 3 wt% aqueous solution of tetramethylammonium hydroxide (TMAH) or another alkali. In this way, the desired pattern is formed on the substrate.

From the positive resist composition, a pattern with a satisfactory resolution and reduced LER can be formed. The resist composition is effectively applicable to a substrate, specifically a substrate having a surface layer of material to which a resist film is less adherent and which is likely to invite pattern stripping or pattern collapse. A typical substrate has an outermost surface of a material containing at least one element selected from chromium, silicon, tantalum, molybdenum, cobalt, nickel, tungsten, and tin. Preferred are substrates having sputter deposited on their outermost surface metallic chromium or a chromium compound containing at least one light element selected from oxygen, nitrogen and carbon and substrates having an outermost surface layer of SiO, SiOₓ, or a tantalum compound, molybdenum compound, cobalt compound, nickel compound, tungsten compound or tin compound. The substrate to which the positive resist composition is applied is most typically a photomask blank which may be either of transmission or reflection type. A mask blank of transmission or reflection type which is coated with the chemically amplified positive resist composition is also contemplated herein.

The mask blank of transmission type is typically a photomask blank having a light-shielding film of chromium-based material. It may be either a photomask blank for binary masks or a photomask blank for phase shift masks. In the case of the binary mask-forming photomask blank, the light-shielding film may include an antireflection layer of chromium-based material and a light-shielding layer. In one example, the antireflection layer on the surface layer side is entirely composed of a chromium-based material. In an alternative example, only a surface side portion of the antireflection layer on the surface layer side is composed of a chromium-based material and the remaining portion is composed of a silicon compound-based material which may contain a transition metal. In the case of the phase shift mask-forming photomask blank, it may include a phase shift film and a chromium-based light-shielding film thereon.

Photomask blanks having an outermost layer of chromium base material are well known as described in JP-A 2008-026500 and JP-A 2007-302873 and the references cited therein. Although the detail description is omitted herein, the following layer construction may be employed when a light-shielding film including an antireflective layer and a light-shielding layer is composed of chromium base materials.

In the example where a light-shielding film including an antireflective layer and a light-shielding layer is composed of chromium base materials, layers may be stacked in the order of an antireflective layer and a light-shielding layer from the outer surface side, or layers may be stacked in the order of an antireflective layer, a light-shielding layer, and an antireflective layer from the outer surface side. Each of the antireflective layer and the light-shielding layer may be composed of multiple sub-layers. When the sub-layers have different compositions, the composition may be graded discontinuously or continuously from sub-layer to sub-layer. The chromium base material used herein may be metallic chromium or a material consisting of metallic chromium and a light element such as oxygen, nitrogen or carbon. Examples used herein include metallic chromium, chromium oxide, chromium nitride, chromium carbide, chromium oxynitride, chromium oxycarbide, chromium nitride carbide, and chromium oxide nitride carbide.

The mask blank of reflection type includes a substrate, a multilayer reflective film formed on one major surface (front surface) of the substrate, for example, a multilayer reflective film of reflecting exposure radiation such as EUV radiation, and an absorber film formed on the multilayer reflective film, for example, an absorber film of absorbing exposure radiation such as EUV radiation to reduce reflectivity. From the reflection type mask blank (reflection type mask blank for EUV lithography), a reflection type mask (reflection type mask for EUV lithography) having an absorber pattern (patterned absorber film) formed by patterning the absorber film is produced. The EUV radiation used in the EUV lithography has a wavelength of 13 to 14 nm, typically about 13.5 nm.

The multilayer reflective film is preferably formed contiguous to one major surface of a substrate. An underlay film may be disposed between the substrate and the multilayer reflective film as long as the benefits of the invention are not lost. The absorber film may be formed contiguous to the multilayer reflective film while a protective film (protective film for the multilayer reflective film) may be disposed between the multilayer reflective film and the absorber film, preferably contiguous to the multilayer reflective film, more preferably contiguous to the multilayer reflective film and the absorber film. The protective film is used for protecting the multilayer reflective film in a cleaning, tailoring or otherwise processing step. Also preferably, the protective film has an additional function of protecting the multilayer reflective film or preventing the multilayer reflective film from oxidation during the step of patterning the absorber film by etching. Besides, an electroconductive film, which is used for electrostatic chucking of the reflection type mask to an exposure tool, may be disposed below the other major surface (back side surface) which is opposed to the one major surface of the substrate, preferably contiguous to the other major surface. It is provided herein that a substrate has one major surface which is a front or upper side surface and another major surface which is a back or lower side surface. The terms "front and back" sides or "upper and lower" sides are used for the sake of convenience. One or another major surface may be either of the two major surfaces (film-bearing surfaces) of a substrate, and in this sense, front and back or upper and lower are exchangeable. Specifically, the multilayer reflective film may be formed by any of the methods of JP-A 2021-139970 and the references cited therein.

The resist pattern forming process is successful in forming patterns having a high resolution, suppressed influences of develop loading and residue defects, and a small size difference independent of pattern density (grouped and isolated patterns), even on a substrate (typically mask blank of transmission or reflection type) whose outermost surface is made of a material tending to affect resist pattern profile such as a chromium, silicon or tantalum-containing material.

### EXAMPLES

Examples of the invention are given below by way of illustration and not by way of limitation. The abbreviation "pbw" is parts by weight. For copolymers, the compositional ratio is a molar ratio and Mw is determined by GPC versus polystyrene standards.

### [1] Synthesis of polymers

### Synthesis Example

### Synthesis of Polymer P-1

A 200-ml flask was charged with 20 g of a hydroxystyrene-acenaphthylene copolymer and 180 g of THF solvent. In nitrogen atmosphere, 12 g of triethylamine was added at ~25°C, after which 19 g of acetal modifier Ac-1 was added dropwise over 30 minutes. The solution was held at room temperature for 3 hours for reaction. At the end of reaction, 12 g of acetic acid was added to the reaction solution, which was added dropwise to 500 g of hexane for precipitation. The copolymer precipitate was collected by filtration and washed twice with 120 g of hexane. The copolymer was dissolved in a mixture of 60 g of ethyl acetate and 20 g of water. The resulting solution was transferred to a separatory funnel where water washing/separatory operation was carried out. The organic layer as separated was concentrated, the concentrate was dissolved in 40 g of acetone, and the solution was added dropwise to 600 g of water. The crystalline precipitate was collected by filtration, washed with water, and dried, obtaining 20.8 g of the target polymer P-1 as a white polymer. Polymer P-1 was analyzed by ¹H-NMR, ¹³C-NMR, and GPC, with the analytical results shown below. 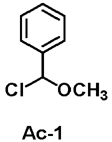
P-1
(a=0.64, b=0.11, c=0.25, Mw=5100)

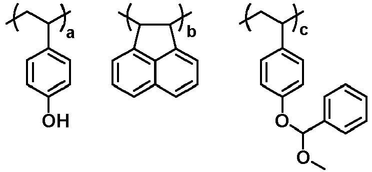

Polymers P-2 to P-19, comparative polymers cP-1 to cP-5, and AP-1 to AP-5 were synthesized as in Synthesis Example or by the standard method except that the type and amount of monomers were changed.

| | |
|---|---|
| P-2 (a=0.63, **b=0.11,** c=0.26, **Mw=5300)** | P-3 (a=0.63, b=0.15, c=0.22, Mw=4200) |
| 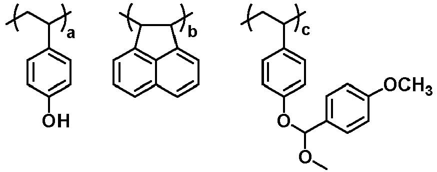 | 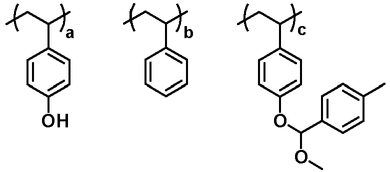 |
| **P-4** (a=0.63, **b=0.11,** c=0.26, **Mw=5200)** | P-5 (a=0.64, b=0.11, c=0.25, Mw=5300) |
| 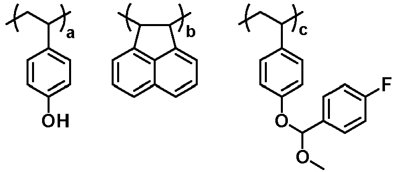 | 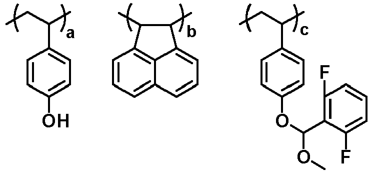 |
| P-6 (a=0.64, b=0.11, c=0.25, Mw=5400) | P-7 (a=0.64, b=0.11, c=0.25, Mw=5300) |
| 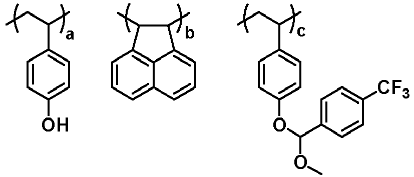 | 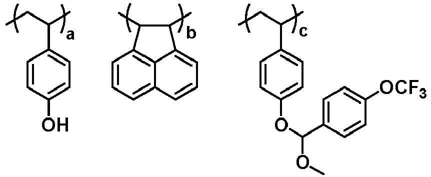 |
| **P-8 (a=0.64, b=0.11, c=0.25, Mw=5500)** | **P-9 (a=0.64, b=0.11, c=0.25, Mw=5600)** |
| 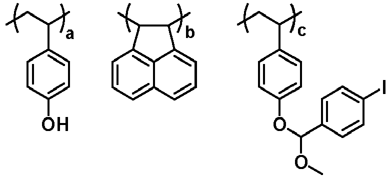 | 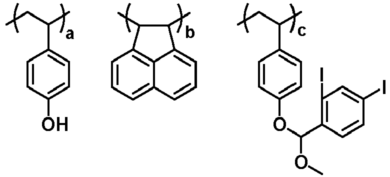 |

| | |
|---|---|
| **P-10 (a=0.66, b=0.10, c=0.24, Mw=5800)** | **P-11 (a=0.70, b=0.10, c=0.20, Mw=6200)** |
| 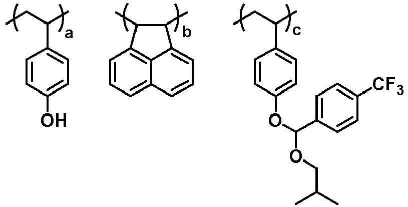 | 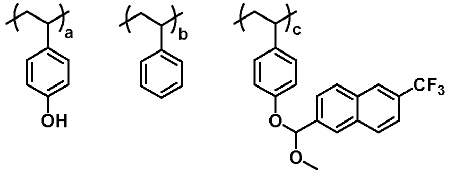 |
| **P-12 (a=0.68, b=0.10, c=0.22, Mw=5900)** | **P-13 (a=0.69, b=0.10, c=0.21, Mw=6000)** |
| 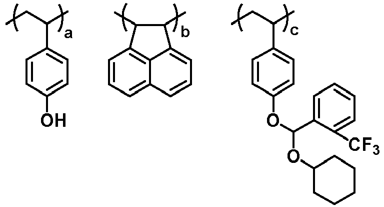 | 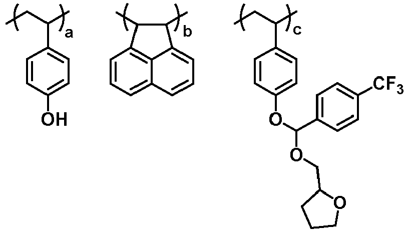 |
| **P-14 (a=0.75, b=0.10, c=0.15, Mw=6800)** | **P-15 (a=0.73, b=0.11, c=0.16, Mw=6900)** |
| 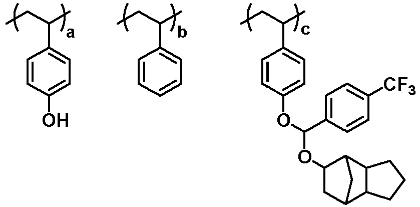 | 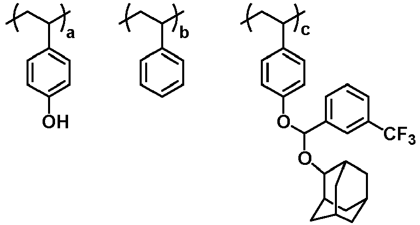 |
| **P-16 (a=0.64, b=0.11, c=0.25, Mw=5400)** | **P-17 (a=0.68, b=0.10, c=0.22, Mw=5900)** |
| 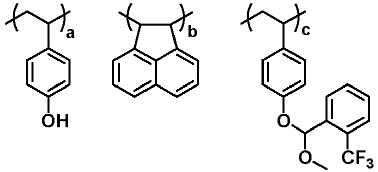 | 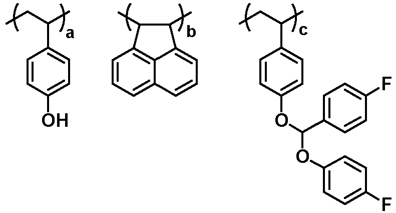 |

| | |
|---|---|
| **P-18 (a=0.70, b=0.10, c=0.20, Mw=6100)** | **P-19 (a=0.67, b=0.10, c=0.23, Mw=5600)** |
| 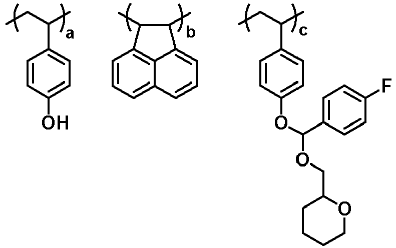 | 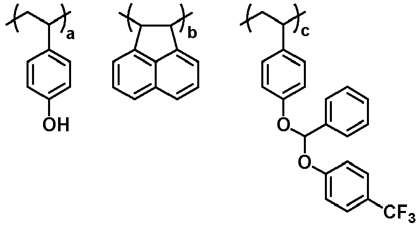 |
| **cP-1 (a=0.64, b=0.11, c=0.25, Mw=6900)** | **cP-2 (a=0.73, b=0.11, c=0.16, Mw=5800)** |
| 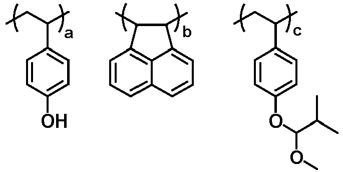 | 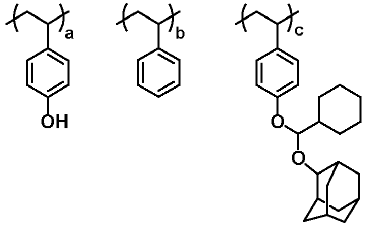 |
| **cP-3 (a=0.64, b=0.11, c=0.25, Mw=5600)** | **cP-4 (a=0.64, b=0.11, c=0.25, Mw=5500)** |
| 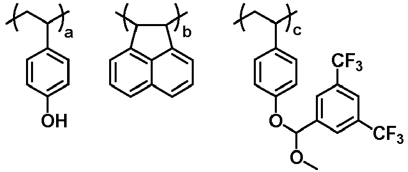 | 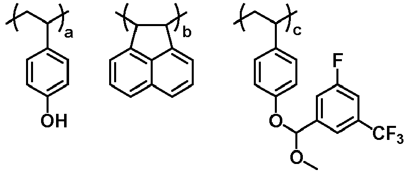 |
| **cP-5 (a=0.79, b=0.12, c=0.09, Mw=5100)** | |
| 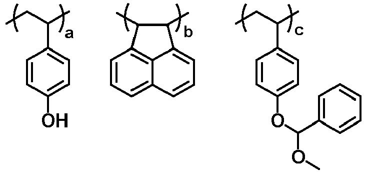 | |

| | |
|---|---|
| **AP-1 (a=0.67, b=0.10, c=0.23, Mw=5500)** | **AP-2 (a=0.60, b=0.10, c=0.30, Mw=5200)** |
| 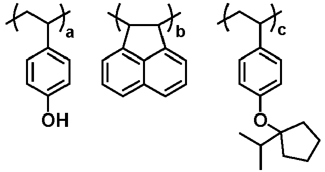 | 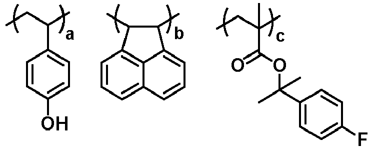 |
| **AP-3 (a=0.65, b=0.10, c=0.10, d=0.15, Mw=5200)** | **AP4 (a=0.70, b=0.15, c=0.15, Mw=4700)** |
| 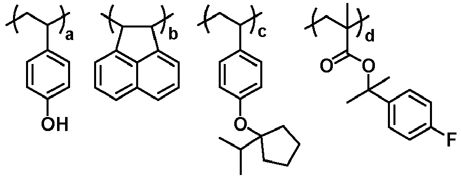 | 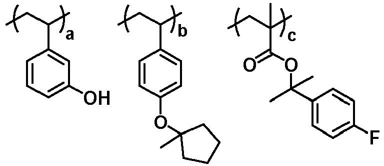 |
| **AP-5 (a=0.70, b=0.30, Mw=4500)** | |
| 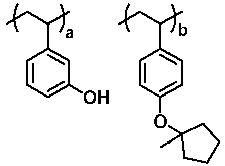 | |

The dissolution rate of a polymer in alkaline developer was computed by spin coating a 16.7 wt% solution of a polymer in PGMEA solvent onto a 8-inch silicon wafer, baking at 100°C for 90 seconds to form a film of 1,000 nm thick, developing the film in a 2.38 wt% TMAH aqueous solution at 23°C for 100 seconds, and measuring a loss of film thickness. As a result, Polymers P-1 to P-19, AP-1 to AP-5 and cP-1 to cP-4 showed a dissolution rate of less than 5 nm/min and comparative Polymer cP-5 showed a dissolution rate of 14 nm/min.

### [2] Preparation of chemically amplified positive resist composition

### Examples 1-1 to 1-41 and Comparative Examples 1-1 to 1-5

A chemically amplified positive resist composition (R-1 to R-41, CR-1 to CR-5) was prepared by dissolving selected components in an organic solvent in accordance with the formulation shown in Tables 1 to 3 and filtering the solution through a nylon filter with a pore size of 5 nm and a UPE filter with a pore size of 1 nm. The organic solvent was a mixture of 940 pbw of PGMEA, 1,870 pbw of EL, and 1,870 pbw of PGME.

The dissolution rate of a resist composition in alkaline developer was computed by spin coating the resist composition onto a 8-inch silicon wafer, baking at 110°C for 240 seconds to form a resist film of 80 nm thick, developing the film in a 2.38 wt% TMAH aqueous solution at 23°C for 80 seconds, and measuring a loss of film thickness. As a result, the resist films of resist compositions R-1 to R-41, CR-1 to CR-5 showed a dissolution rate of less than 10 nm/min and the resist film of resist composition CR-6 showed a dissolution rate of 16 nm/min.

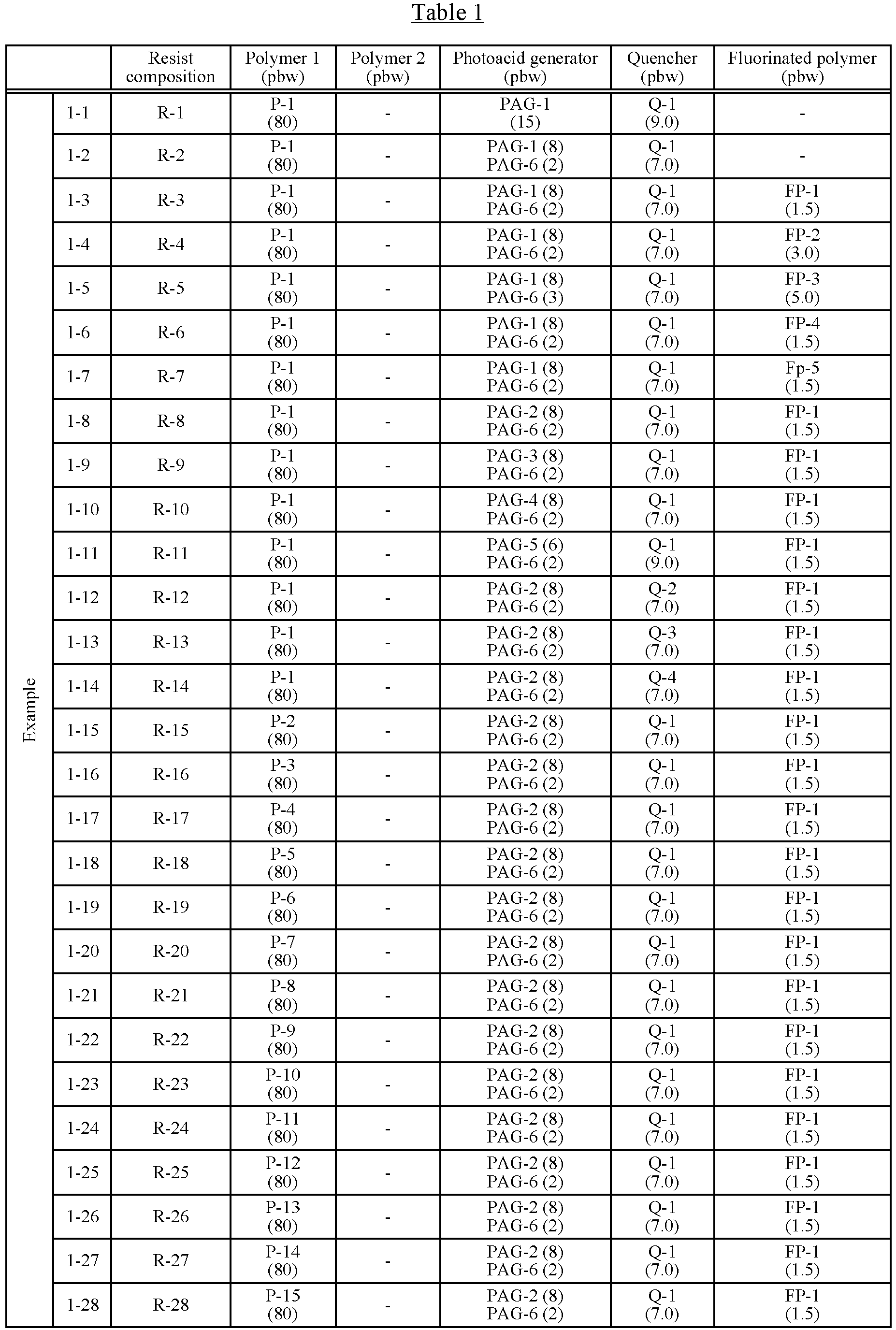

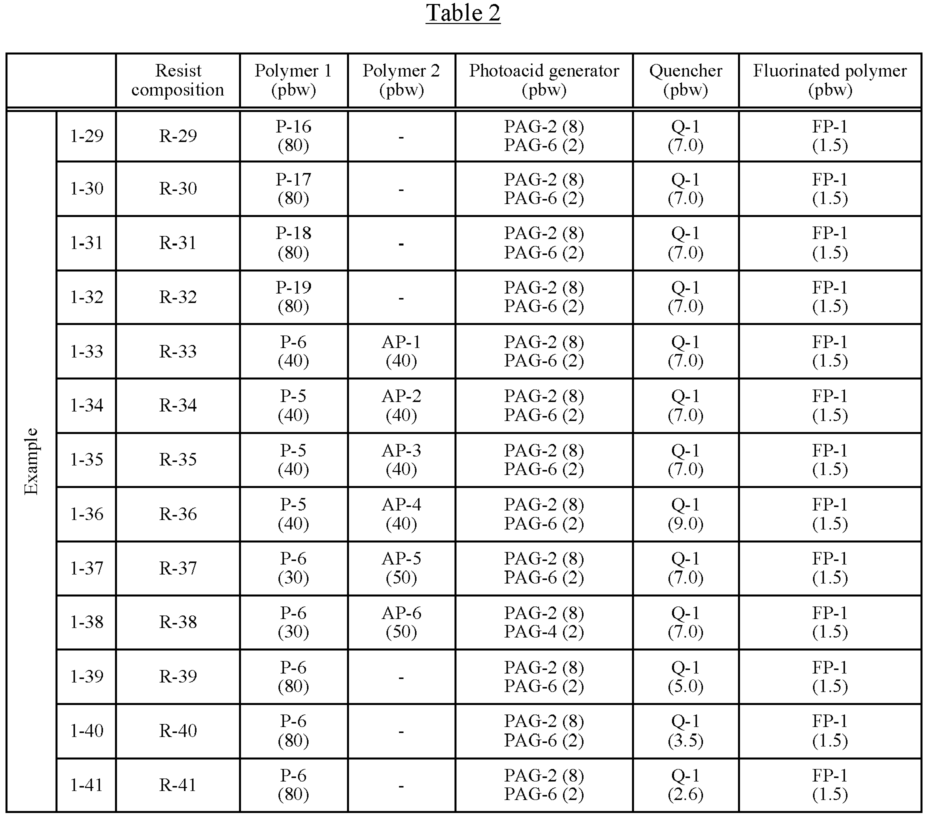

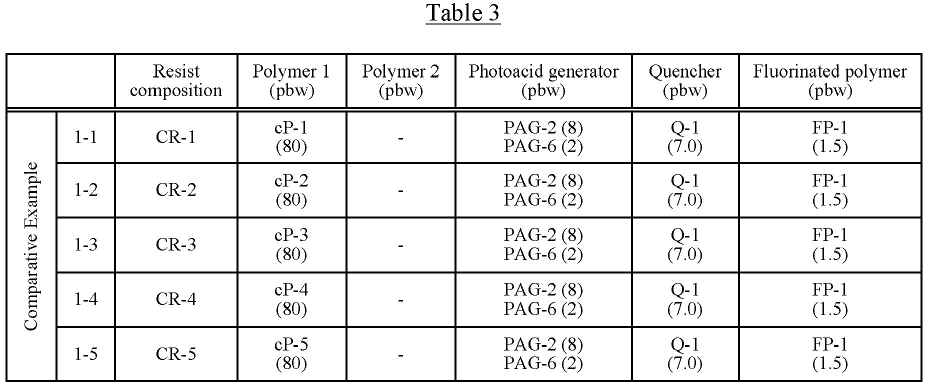

The components in Tables 1 to 3 are identified below.

### Photoacid generator: PAG-1 to PAG-6

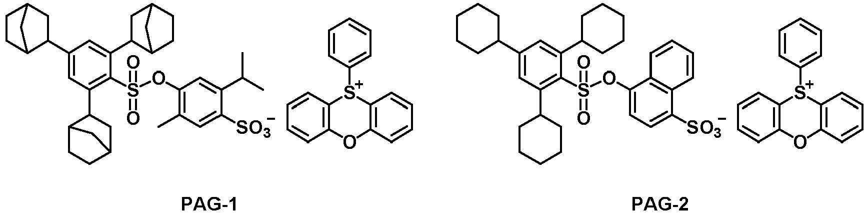

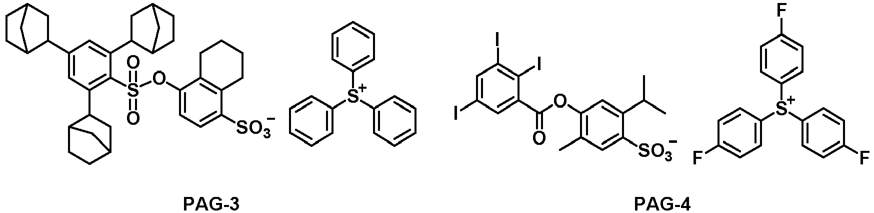

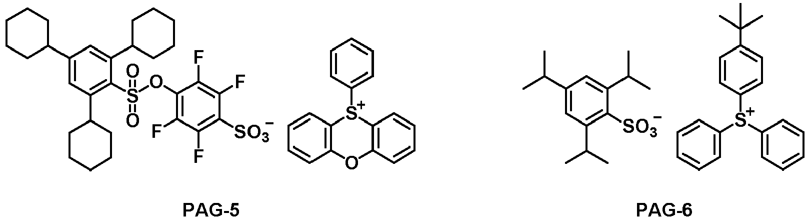

### Quencher: Q-1 to Q-4

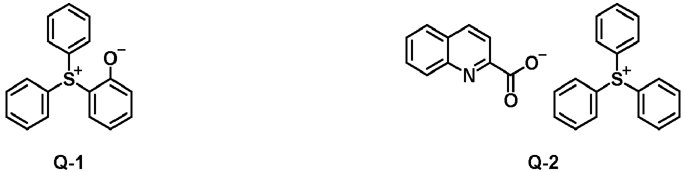

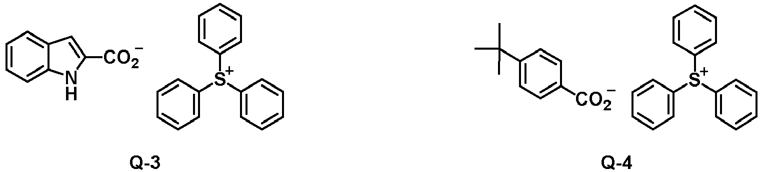

### Fluorinated polymer: FP-1 to FP-5

| | | |
|---|---|---|
| FP-1 (a=0.80, b=0.20, Mw=6000) | FP-2 (a=0.80, b=0.20, Mw=6400) | FP-3 (a=0.80, b=0.20, Mw=6500) |
| 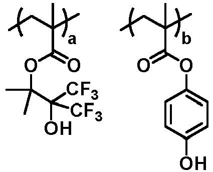 | 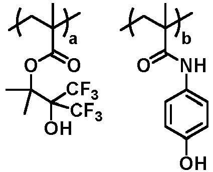 | 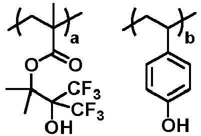 |
| FP-4 (a=0.80, b=0.20, Mw=8200) | FP-5 (a=1.0, Mw=8600) | |
| 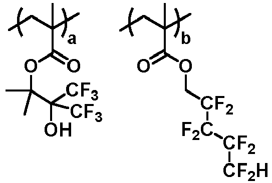 | 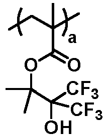 | |

### [3] EB lithography test

### Examples 2-1 to 2-41 and Comparative Examples 2-1 to 2-5

There was furnished a reflection type mask blank for EUV lithography masks. Namely, a mask blank was furnished by forming a multilayer reflective film of 40 Mo/Si layers having a thickness of 284 nm on a low thermal expansion glass substrate of 6 inch squares, then successively depositing thereon a Ru film of 3.5 nm thick as a protective film, a TaN film of 70 nm thick as an absorber layer, and a CrN film of 6 nm thick as a hard mask.

Using a coater/developer system ACT-M (Tokyo Electron Ltd.), each of the positive resist compositions (R-1 to R-41, CR-1 to CR-5) was spin coated onto the reflection type photomask blank and prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding an outer rim portion extending 10 mm inward from the periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1: 1 resolution at the top and bottom of a 200-nm 1: 1 line-and-space (LS) pattern. The resolution (or maximum resolution) was defined as the minimum size at the dose which provided a 1:1 resolution for a 200-nm LS pattern. The edge roughness (LER) of a 200-nm LS pattern was measured under SEM. Also, the pattern was visually observed to judge whether or not the profile was rectangular. The results are shown in Tables 4 to 6.

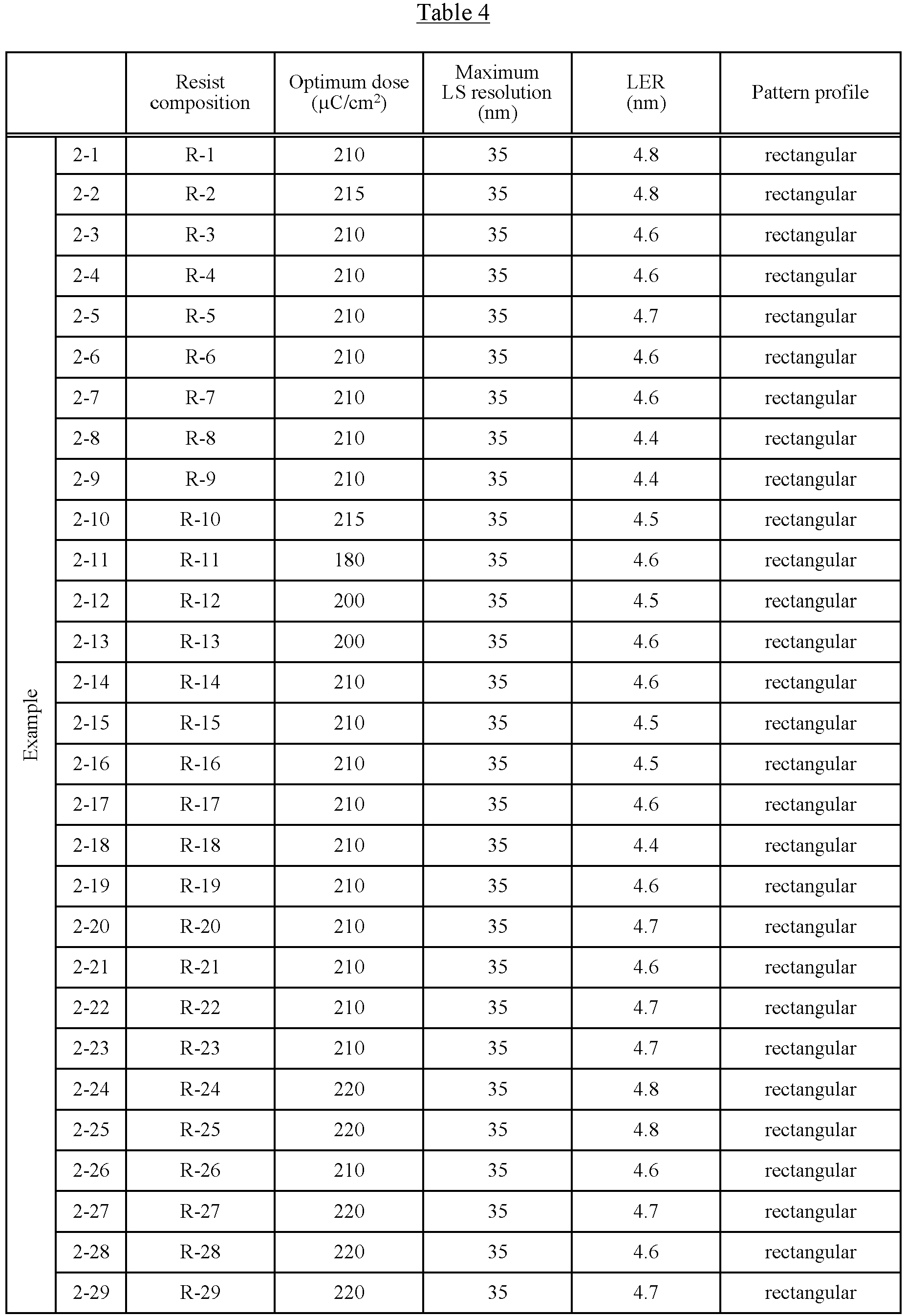

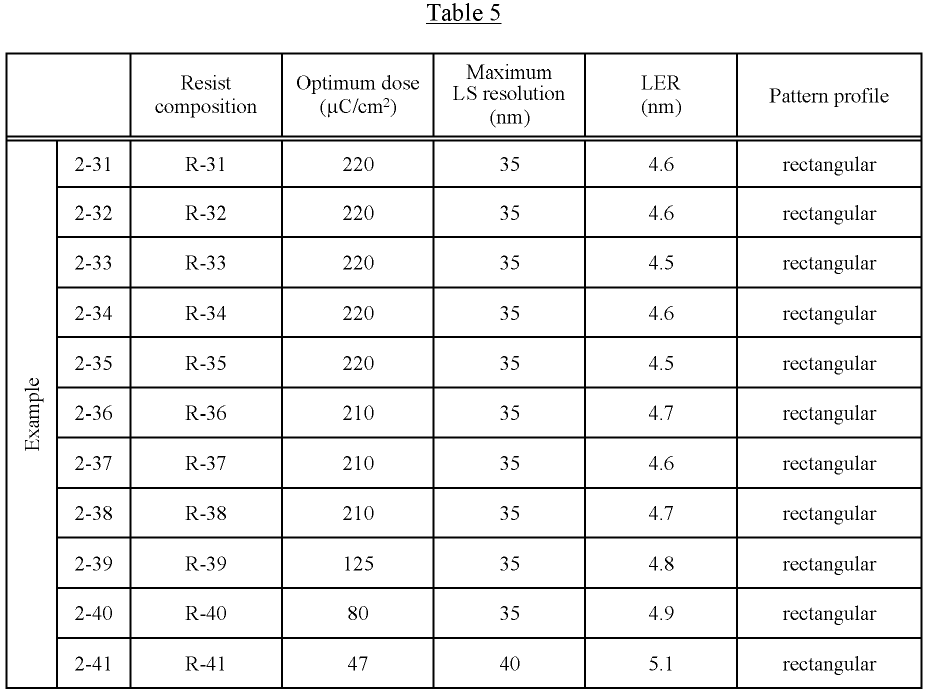

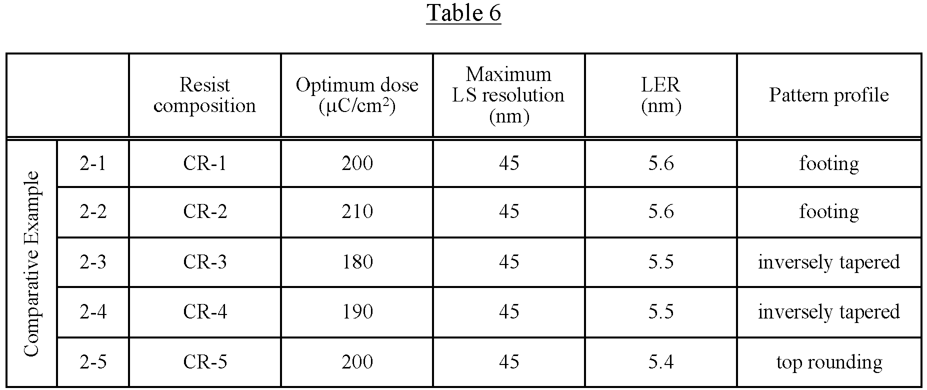

### [4] Evaluation of residue defects

### Examples 3-1 to 3-8 and Comparative Examples 3-1 and 3-2

Each of the resist compositions (R-8, R-15 to R-20, R-33, CR-3 and CR-4) was applied onto a reflection type mask blank for EUV lithography masks to form a resist film of 80 nm thick. Using an EB writer system EBM-5000Plus (NuFlare Technology Inc., accelerating voltage 50 kV), the resist film was exposed over its entire surface to EB in its optimum dose. The resist film was then baked (PEB) at 110°C for 600 seconds and developed in a 2.38 wt% TMAH aqueous solution. Using a mask defect inspection system M9650 (Laser Tech), development residues were evaluated. The total number of defects after development is shown in Table 7.

**Table 7**

| | | Resist composition | Total number of defects after development |
|---|---|---|---|
| Example | 3-1 | R-8 | 470 |
| | 3-2 | R-15 | 480 |
| | 3-3 | R-16 | 480 |
| | 3-4 | R-17 | 500 |
| | 3-5 | R-18 | 550 |
| | 3-6 | R-19 | 580 |
| | 3-7 | R-20 | 580 |
| | 3-8 | R-33 | 600 |
| Comparative Example | 3-1 | CR-3 | 1,680 |
| | 3-2 | CR-4 | 1,660 |

All the chemically amplified positive resist compositions (R-1 to R-41) within the scope of the invention show satisfactory LS resolution, LER and pattern rectangularity as well as reduced values of develop loading. In contrast, comparative resist compositions (CR-1 to CR-5) are unsatisfactory in LS resolution, LER and pattern rectangularity because of insufficient design of base polymers. Resist composition CR-5 in which the polymer had a high dissolution rate in unexposed region showed degraded resolution and formed a pattern of round-top profile. As to the evaluation of residue defects, CR-3 and CR-4 were unsatisfactory. Now that the invention is designed such that a resist composition is formulated using a base polymer having a specific acid labile group of acetal form and a limited number of halogen atoms, a pattern of satisfactory profile having a high resolution and reduced LER is formed even in high-dose regions while the influence of residue defects on alkaline developer is restrained.

It has been demonstrated that the chemically amplified positive resist composition and resist pattern forming process according to the invention are useful in the photolithography for the fabrication of semiconductor devices, especially the processing of photomask blanks of transmission and reflection types.

## Claims

1. A chemically amplified positive resist composition comprising (A) a base polymer, (B) a photoacid generator, and (C) a quencher, wherein
the base polymer (A) contains a polymer comprising phenolic hydroxy-containing units represented by the formula (A1), aromatic ring-containing units represented by any one of the formulae (A2) to (A4), and units containing a phenolic hydroxy group protected with an acid labile group, represented by the formula (A5),
all repeat units in the base polymer (A) are aromatic ring-containing repeat units,
the number of halogen atoms in the repeat units in the base polymer (A) is up to 3, 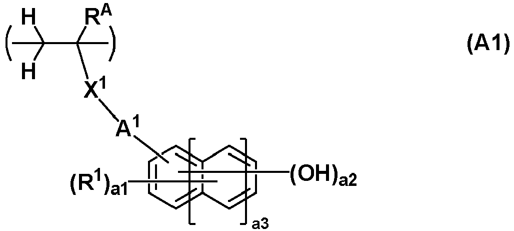
wherein a1 is an integer satisfying 0 ≤ a1 ≤ 5+2(a3)-a2, a2 is an integer of 1 to 3, a3 is an integer of 0 to 2,
R^{A} is hydrogen, fluorine, methyl or trifluoromethyl,
X¹ is a single bond, *-C(=O)-O- or *-C(=O)-NH-, * designates a point of attachment to the carbon atom in the backbone,
A¹ is a single bond or a C₁-C₁₀ saturated hydrocarbylene group in which some -CH₂-may be replaced by -O-,
R¹ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, 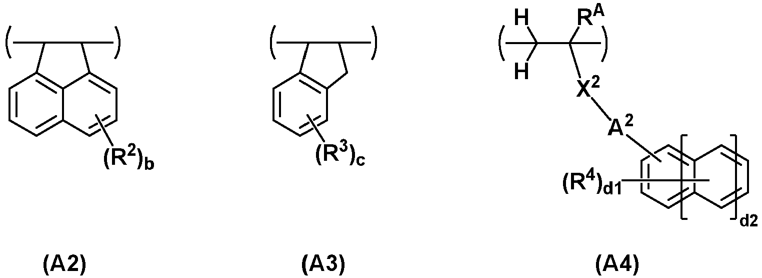
wherein b and c are each independently an integer of 0 to 4, d1 is an integer of 0 to 5, d2 is an integer of 0 to 2,
R^{A} is hydrogen, fluorine, methyl or trifluoromethyl,
X² is a single bond, *-C(=O)-O- or *-C(=O)-NH-, * designates a point of attachment to the carbon atom in the backbone,
A² is a single bond or a C₁-C₁₀ saturated hydrocarbylene group in which some -CH₂-may be replaced by -O-,
R² and R³ are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group,
R⁴ is an acetyl group, C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro group or cyano group, R⁴ may also be hydroxy when d2 is 1 or 2, 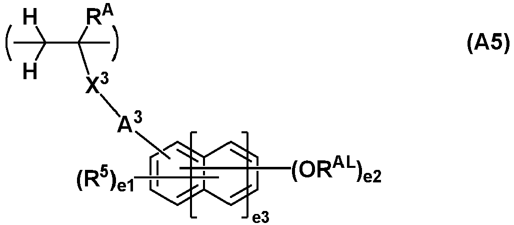
wherein e1 is an integer satisfying 0 ≤ e1 ≤ 5+2(e3)-e2, e2 is an integer of 1 to 3, e3 is an integer of 0 to 2,
R^{A} is hydrogen, fluorine, methyl or trifluoromethyl,
X³ is a single bond, *-C(=O)-O- or *-C(=O)-NH-, * designates a point of attachment to the carbon atom in the backbone,
A³ is a single bond or a C₁-C₁₀ saturated hydrocarbylene group in which some -CH₂- may be replaced by -O-,
R⁵ is halogen, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group,
R^{AL} is an acid labile group of acetal form having the formula (AL-1) when e2=1, R^{AL} is hydrogen or an acid labile group of acetal form having the formula (AL-1), at least one R^{AL} being an acid labile group of acetal form having the formula (AL-1), when e2=2 or 3, 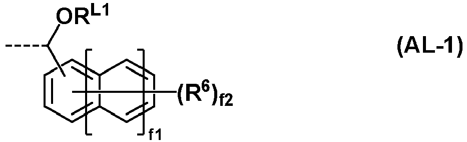
wherein f1 is an integer of 0 to 2, and f2 is an integer satisfying 0 ≤ f2 ≤ 5+2(f1),
R⁶ is acetyl, a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro or cyano group,
R^{L1} is a C₁-C₃₀ hydrocarbyl group, and
the broken line designates a point of attachment.

2. The resist composition of claim 1 wherein the phenolic hydroxy-containing units have the formula (A1-1): 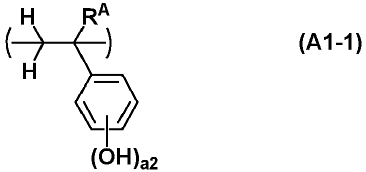 wherein R^{A} and a2 are as defined above.

3. The resist composition of claim 1 or 2 wherein the units containing a phenolic hydroxy group protected with an acid labile group have the formula (A5-1): 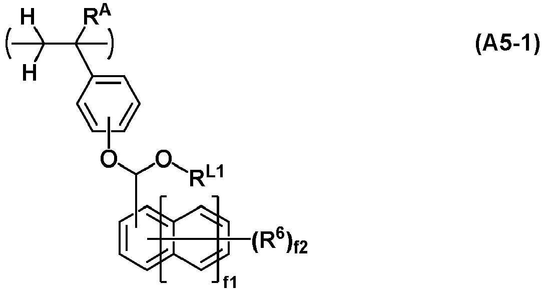 wherein R^{A}, R⁶, f1, f2 and R^{L1} are as defined above.

4. The resist composition of any one of claims 1 to 3 wherein the photoacid generator (B) generates an acid having an acid strength (pKa) of -3.0 or larger.

5. The resist composition of any one of claims 1 to 4 wherein the photoacid generator (B) and the quencher (C) are present in a weight ratio (B/C) of less than 3/1.

6. The resist composition of any one of claims 1 to 5 wherein the photoacid generator (B) is an onium salt compound containing an anion having the formula (B-1) or (B-2): 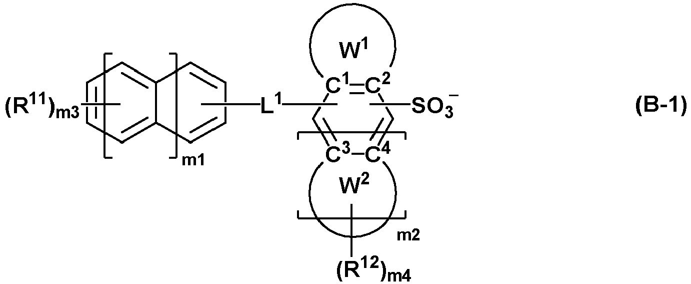
wherein m1 and m2 are each independently an integer of 0 to 2, m3 is an integer of 1 to 5 in case of m 1=0, an integer of 1 to 7 in case of m 1=1, and an integer of 1 to 9 in case of m1=2, m4 is an integer of 0 to 5 in case of m2=0, an integer of 0 to 7 in case of m2=1, and an integer of 0 to 9 in case of m2=2,
L¹ is a single bond, ether bond, ester bond, sulfonate ester bond, amide bond, carbonate bond or carbamate bond,
R¹¹ is each independently iodine or a C₃-C₂₀ branched or cyclic hydrocarbyl group which may contain a heteroatom, at least one R¹¹ is attached to a carbon atom adjoining the carbon atom to which L¹ is attached, a plurality of R¹¹ may bond together to form a ring with the carbon atoms to which they are attached when m3 is 2 or more,
R¹² is each independently a C₁-C₂₀ hydrocarbyl group which may contain a heteroatom, a plurality of R¹² may bond together to form a ring with the carbon atoms to which they are attached when m4 is 2 or more,
W¹ forms a C₃-C₁₅ ring with the carbon atoms C¹ and C² on the adjoining aromatic ring, some carbon on the ring may be replaced by a heteroatom-containing group,
W² forms a C₃-C₁₅ ring with the carbon atoms C³ and C⁴ on the adjoining aromatic ring, some carbon on the ring may be replaced by a heteroatom-containing group, 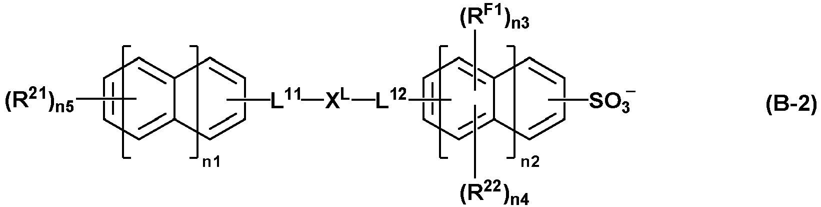
wherein n1 and n2 are each independently an integer of 0 to 2, n3 is an integer of 1 to 4 in case of n2=0, an integer of 1 to 6 in case of n2=1, and an integer of 1 to 8 in case of n2=2, n4 is an integer of 0 to 3 in case of n2=0, an integer of 0 to 5 in case of n2=1, and an integer of 0 to 7 in case of n2=2, n3+n4 is from 1 to 4 in case of n2=0, from 1 to 6 in case of n2=1, and from 1 to 8 in case of n2=2, n5 is an integer of 1 to 5 in case of n1=0, an integer of 1 to 7 in case of n1=1, and an integer of 1 to 9 in case of n1=2,
R²¹ is each independently iodine or a C₃-C₂₀ branched or cyclic hydrocarbyl group which may contain a heteroatom, at least one R²¹ is attached to a carbon atom adjoining the carbon atom to which L¹¹ is attached, a plurality of R²¹ may bond together to form a ring with the carbon atoms to which they are attached when n5 is 2 or more,
R²² is each independently a C₁-C₂₀ hydrocarbyl group which may contain a heteroatom, a plurality of R²² may bond together to form a ring with the carbon atoms to which they are attached when n4 is 2 or more,
R^{F1} is each independently fluorine, a C₁-C₆ fluorinated alkyl group, C₁-C₆ fluorinated alkoxy group, or C₁-C₆ fluorinated thioalkoxy group,
L¹¹ and L¹² are each independently a single bond, ether bond, ester bond, amide bond, sulfonate ester bond, carbonate bond or carbamate bond, and
X^{L} is a single bond or a C₁-C₄₀ hydrocarbylene group which may contain a heteroatom.

7. The resist composition of claim 6 wherein the photoacid generator (B) is an onium salt compound having a fluorine-free anion.

8. The resist composition of any one of claims 1 to 7, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 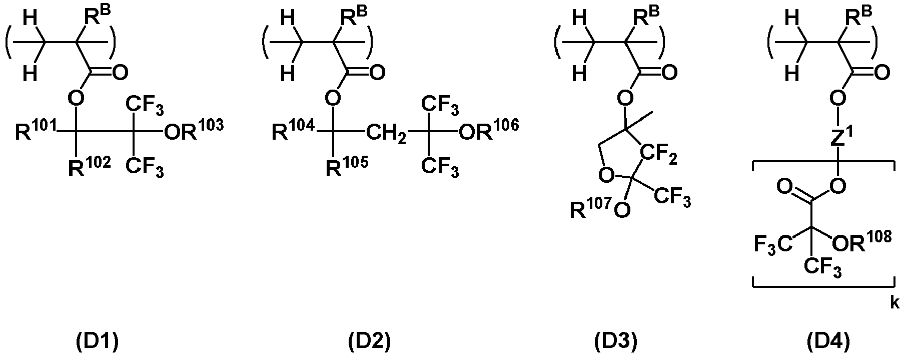 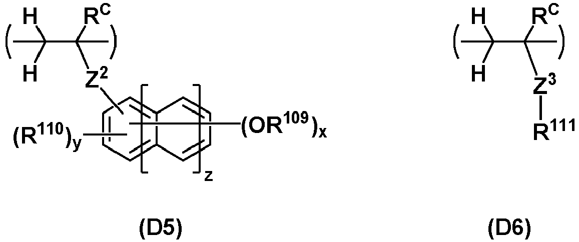 wherein x is 1, 2 or 3, y is an integer satisfying 0 ≤ y ≤ 5+2z-x, z is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group,
when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond,
R¹¹⁰ is a C₁-C₅ straight or branched hydrocarbyl group in which a heteroatom-containing moiety may intervene in a carbon-carbon bond,
R¹¹¹ is a C₁-C₂₀ saturated hydrocarbyl group in which at least one hydrogen is substituted by fluorine, and in which some -CH₂- may be replaced by an ester bond or ether bond,
Z¹ is a C₁-C₂₀ (k+1)-valent hydrocarbon group or C₁-C₂₀ (k+1)-valent fluorinated hydrocarbon group,
Z² is a single bond, *-C(=O)-O- or *-C(=O)-NH-,
Z³ is a single bond, -O-, *-C(=O)=O-Z³¹-Z³²- or *-C(=O)-NH-Z³¹-Z³²-, Z³¹ is a single bond or C₁-C₁₀ saturated hydrocarbylene group, Z³² is a single bond, ester bond, ether bond, or sulfonamide bond, and * designates a point of attachment to the carbon atom in the backbone.

9. The resist composition of any one of claims 1 to 8, further comprising (E) an organic solvent.

10. The resist composition of any one of claims 1 to 9 wherein the base polymer has a dissolution rate in alkaline developer of up to 5 nm/min.

11. The resist composition of any one of claims 1 to 10 which forms a resist film, the resist film in an unexposed region having a dissolution rate in alkaline developer of up to 10 nm/min.

12. The resist composition of any one of claims 1 to 11, adapted for the EB lithography.

13. A resist pattern forming process comprising the steps of:
applying the chemically amplified positive resist composition of any one of claims 1 to 12 onto a substrate to form a resist film thereon,
exposing the resist film to a pattern of EUV or EB, and
developing the exposed resist film in an alkaline developer.

14. The process of claim 13 wherein the substrate has the outermost surface of a material containing at least one element selected from chromium, silicon, tantalum, molybdenum, cobalt, nickel, tungsten, and tin.

15. A mask blank of transmission or reflection type which is coated with the chemically amplified positive resist composition of any one of claims 1 to 12.
